# EUROPEAN PATENT SPECIFICATION

(11) **EP 4 436 349 B1**
(45) Date of publication and mention of the grant of the patent: **01.04.2026**
(21) Application number: 24155597.8
(22) Date of filing: 02.02.2024
(51) Int. Cl.: H10K 85/30, C07F 15/00, H10K 50/11

(54) **LIGHT-EMITTING DEVICE INCLUDING ORGANOMETALLIC COMPOUND, ELECTRONIC APPARATUS INCLUDING THE LIGHT-EMITTING DEVICE, AND THE ORGANOMETALLIC COMPOUND**
LICHTEMITTIERENDE VORRICHTUNG MIT ORGANOMETALLISCHER VERBINDUNG, ELEKTRONISCHE VORRICHTUNG MIT DER LICHTEMITTIERENDEN VORRICHTUNG UND ORGANOMETALLISCHE VERBINDUNG
DISPOSITIF ÉLECTROLUMINESCENT COMPRENANT UN COMPOSÉ ORGANOMÉTALLIQUE, APPAREIL ÉLECTRONIQUE COMPRENANT LE DISPOSITIF ÉLECTROLUMINESCENT ET LE COMPOSÉ ORGANOMÉTALLIQUE

(30) Priority: 24.03.2023 KR 20230039229; 12.05.2023 KR 20230061734
(43) Date of publication of application: 25.09.2024
(73) Proprietor: Samsung Display Co., Ltd., Yongin-si, Gyeonggi-do 17113 (KR)
(72) Inventor: AHN, Seihwan, 17113 Yongin-si (KR); KO, Soobyung, 17113 Yongin-si (KR)
(74) Representative: Marks & Clerk LLP

(56) References cited:
- KR-A- 20230 022 358
- US-A1- 2019 103 566
- US-A1- 2022 069 239
- US-A1- 2023 117 263

## Description

### BACKGROUND

### 1. Field

One or more aspects of embodiments of the present disclosure relate to a light-emitting device including an organometallic compound, an electronic apparatus including the light-emitting device, and the organometallic compound.

### 2. Description of the Related Art

Self-emissive light-emitting devices are a class (category type) among light-emitting devices. The self-emissive devices have relatively wide viewing angles, high contrast ratios, short response times, and excellent or suitable characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons may transition (i.e., relax) from an excited state to a ground state to thereby generate light.

Light-emitting devices comprising organometallic complexes are known in the art, such as from KR 2023 0022358 A, US 2022/069239 A1, and US 2019/103566 A1.

### SUMMARY

One or more aspects of embodiments of the present disclosure are directed toward a light-emitting device including an organometallic compound, an electronic apparatus including the light-emitting device, and the organometallic compound.

Additional aspects will be set forth in part in the description which follows and, in part, will be apparent from the description, or may be learned by practice of the presented embodiments of the disclosure.

According to one or more embodiments, a light-emitting device includes
a first electrode,
a second electrode facing the first electrode,
an interlayer arranged between the first electrode and the second electrode and including an emission layer, and
an organometallic compound represented by Formula 1.

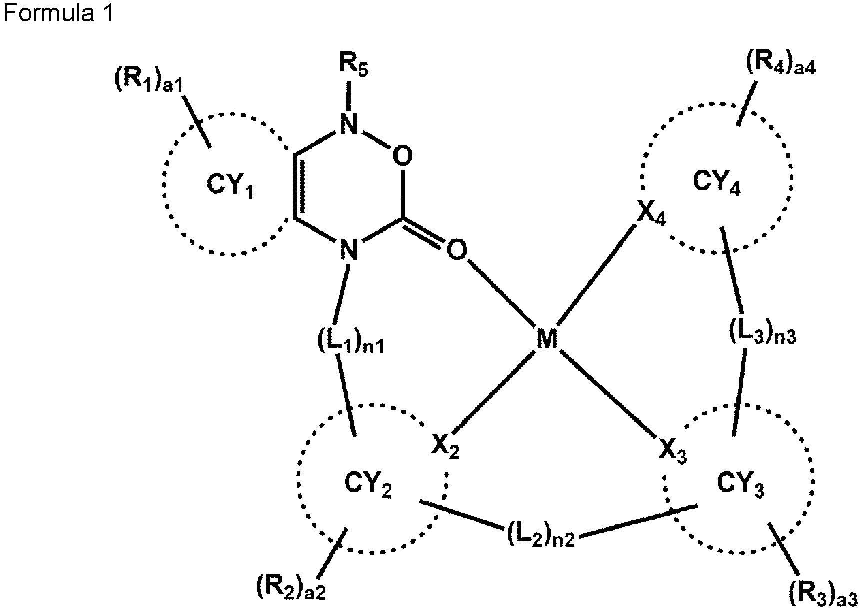

In Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₂ to X₄ are each independently C or N,
rings CY₁ to CY₄ are each independently a C₅-C₃₀ carbocyclic group or a C₁-C₃₀ heterocyclic group,
L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom,
n1 to n3 are each independently an integer from 1 to 5,
R₁ to R₅, R₁ₐ, and R_{1b} are each independently hydrogen, deuterium, -F, -CI, - Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₁-C₆₀ alkylthio group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 to a4 are each independently an integer from 1 to 20,
two or more neighboring groups of R₁ to R₅ are optionally bonded together to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₁₀ₐ is
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

According to one or more embodiments, an electronic apparatus includes the light-emitting device.

According to one or more embodiments, electronic equipment includes the light-emitting device.

According to one or more embodiments, there is provided the organometallic compound represented by Formula 1.

At least some of the above and other features of the invention are set out in the claims.

### BRIEF DESCRIPTION OF THE DRAWINGS

The accompanying drawings are included to provide a further understanding of the above and other aspects, features, and advantages of certain embodiments of the present disclosure are incorporated in and constitute a part of this specification. The drawings illustrate example embodiments and, together with the following description taken in conjunction with the accompanying drawings, serve to make the principles of the present disclosure more apparent. In the drawings:
FIG. 1 is a schematic view of a structure of a light-emitting device according to one or more embodiments of the present disclosure;
FIG. 2 is a schematic view of a structure of an electronic apparatus according to one or more embodiments of the present disclosure;
FIG. 3 is a schematic view of a structure of an electronic apparatus according to one or more embodiments of the present disclosure;
FIG. 4 is a schematic perspective view of electronic equipment including a light-emitting device according to one or more embodiments of the present disclosure;
FIG. 5 is a diagram illustrating the exterior of a vehicle as electronic equipment including a light-emitting device according to one or more embodiments of the present disclosure; and
FIGS. 6A, 6B, and 6C are each a schematic view of the interior of a vehicle that includes a structure of electronic equipment including a light-emitting device according to one or more embodiments of the present disclosure.

### DETAILED DESCRIPTION

Reference will now be made in more detail to embodiments of the present disclosure, examples of which are illustrated in the accompanying drawings, wherein like reference numerals refer to like elements throughout, and duplicative descriptions thereof may not be provided the specification. In this regard, the present embodiments may have different forms and should not be construed as being limited to the descriptions set forth herein. Accordingly, the embodiments are merely described, by referring to the drawings, to explain aspects of the present description.

As utilized herein, the term "and/or" includes any and all combinations of one or more of the associated listed items. Expressions such as "at least one of," "one of," and "selected from," when preceding a list of elements, modify the entire list of elements and do not modify the individual elements of the list. For example, throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

The terminology used herein is for the purpose of describing embodiments and is not intended to limit the embodiments described herein. Unless otherwise defined, all chemical names, technical and scientific terms, and terms defined in common dictionaries should be interpreted as having meanings consistent with the context of the related art, and should not be interpreted in an ideal or overly formal sense. It will be understood that, although the terms first, second, etc. may be used herein to describe various elements, these elements should not be limited by these terms. These terms are only used to distinguish one element from another element. Thus, a first element could be termed a second element without departing from the teachings of the present disclosure. Similarly, a second element could be termed a first element.

As used herein, singular forms such as "a," "an," and "the" are intended to include the plural forms as well, unless the context clearly indicates otherwise.

It will be further understood that the terms "comprise," "comprises," "comprising," "has," "have," "having," "include," "includes," and/or " including," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

As used herein, the term "and/or" includes any, and all, combination(s) of one or more of the associated listed items.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

It will be understood that when an element is referred to as being "on," "connected to," or "on" another element, it may be directly on, connected, or coupled to the other element or one or more intervening elements may also be present. When an element is referred to as being "directly on," "directly connected to," or "directly coupled to" another element, there are no intervening elements present.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Unless otherwise defined, all terms (including technical and scientific terms) used herein have the same meaning as commonly understood by those of ordinary skill in the art to which the present disclosure pertains. It is also to be understood that terms defined in commonly used dictionaries should be interpreted as having meanings consistent with meanings in the context of the related art, unless expressly defined herein, and should not be interpreted in an ideal or overly formal sense.

In this context, "consisting essentially of" means that any additional components will not materially affect the chemical, physical, optical or electrical properties of the semiconductor film.

Further, in this specification, the phrase "on a plane," or "plan view," means viewing a target portion from the top, and the phrase "on a cross-section" means viewing a cross-section formed by vertically cutting a target portion from the side.

According to one or more embodiments, a light-emitting device includes
a first electrode;
a second electrode facing the first electrode;
an interlayer arranged between the first electrode and the second electrode and including an emission layer; and
an organometallic compound represented by Formula 1: 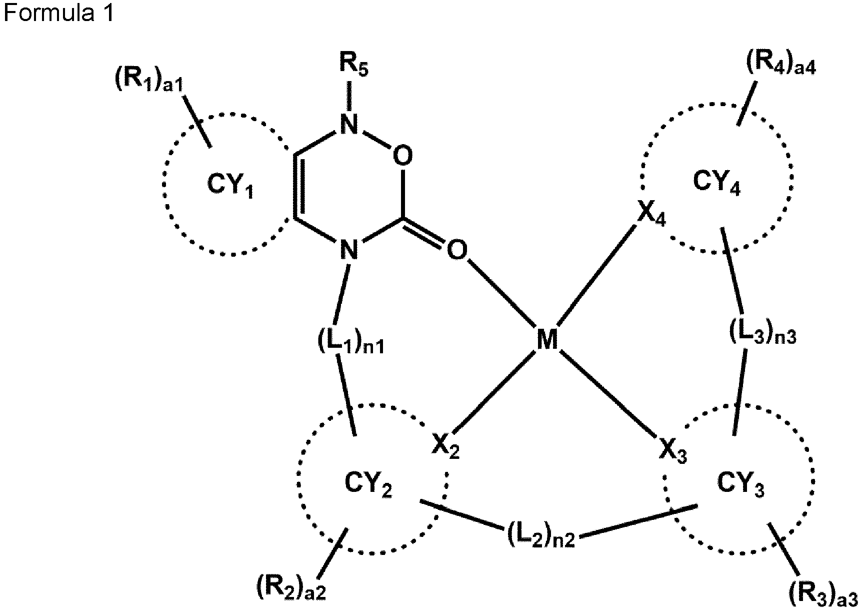
wherein Formula 1 is as described herein.

In one or more embodiments,
the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a hole blocking layer, an electron transport layer, an electron injection layer, or any combination thereof.

In one or more embodiments, the interlayer of the light-emitting device may include the organometallic compound represented by Formula 1.

In one or more embodiments, the emission layer of the light-emitting device may include the organometallic compound represented by Formula 1.

In one or more embodiments, the emission layer of the light-emitting device may include a dopant and a host, and the organometallic compound represented by Formula 1 may be included in the dopant. In other words, the organometallic compound may act as a dopant. In one or more embodiments, the emission layer may be to emit (e.g., configured to emit) blue light. The blue light may have a maximum emission wavelength of, for example, about 430 nm to about 470 nm.

In one or more embodiments, the electron transport region of the light-emitting device may include a hole blocking layer, and the hole blocking layer may include a phosphine oxide-containing compound, a silicon-containing compound, or any combination thereof. In one or more embodiments, the hole blocking layer may directly contact the emission layer.

In one or more embodiments, the light-emitting device may further include a second compound including at least one π electron-deficient nitrogen-containing C₁-C₆₀ (*e.g*. C₁-C₃₀) heterocyclic group, a third compound including a group represented by Formula 3, a fourth compound capable of emitting delayed fluorescence, or any combination thereof, and
the organometallic compound, the second compound, the third compound, and the fourth compound in the light-emitting device may be different from each other. 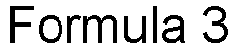 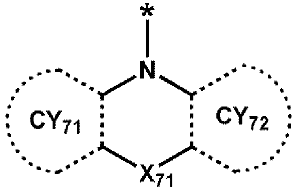 In Formula 3,
ring CY₇₁ and ring CY₇₂ are each independently a π electron-rich C₃-C₆₀ (*e.g.* C₃-C₃₀) cyclic group or a pyridine group,
X₇₁ is a single bond, or a linking group including O, S, N, B, C, Si, or any combination thereof, and
* indicates a binding site to any atom included in the remaining part other than Formula 3 in the third compound.

In one or more embodiments, the organometallic compound may include at least one deuterium.

In one or more embodiments, the second compound to the fourth compound may each include at least one deuterium.

In one or more embodiments, the second compound may include at least one silicon.

In one or more embodiments, the third compound may include at least one silicon.

In one or more embodiments, the light-emitting device may further include, in addition to the organometallic compound represented by Formula 1, the second compound and the third compound, and at least one of the second compound or the third compound may include at least one deuterium, at least one silicon, or a combination thereof.

In one or more embodiments, the light-emitting device (for example, the emission layer in the light-emitting device) may further include the second compound, in addition to the organometallic compound. At least one of the organometallic compound or the second compound may include at least one deuterium. In one or more embodiments, the composition and the light-emitting device (for example, the emission layer in the light-emitting device) may each further include the third compound, the fourth compound, or any combination thereof, in addition to the organometallic compound and the second compound.

In one or more embodiments, the light-emitting device (for example, the emission layer in the light-emitting device) may further include the third compound, in addition to the organometallic compound. At least one of the organometallic compound or the third compound may include at least one deuterium. In one or more embodiments, the composition and the light-emitting device (for example, the emission layer in the light-emitting device) may each further include the second compound, the fourth compound, or any combination thereof, in addition to the organometallic compound and the third compound.

In one or more embodiments, the light-emitting device (for example, the emission layer in the light-emitting device) may further include the fourth compound, in addition to the organometallic compound. At least one of the organometallic compound or the fourth compound may include at least one deuterium. The fourth compound may serve to improve color purity, luminescence efficiency, and lifespan characteristics of the light-emitting device. In one or more embodiments, the composition and the light-emitting device (for example, the emission layer in the light-emitting device) may each further include the second compound, the third compound, or any combination thereof, in addition to the organometallic compound and the fourth compound.

In one or more embodiments, the light-emitting device (for example, the emission layer in the light-emitting device) may further include the second compound and the third compound, in addition to the organometallic compound. The second compound and the third compound may form an exciplex. At least one of the organometallic compound, the second compound, or the third compound may include at least one deuterium.

In one or more embodiments, the emission layer of the light-emitting device may include: i) the organometallic compound; and ii) the second compound, the third compound, the fourth compound, or any combination thereof, and the emission layer may be to emit (e.g., configured to emit) blue light.

In one or more embodiments, the maximum emission wavelength of the blue light may be about 430 nanometers (nm) to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, the second compound may include a pyridine group, a pyrimidine group, a pyrazine group, a pyridazine group, a triazine group, or any combination thereof.

In one or more embodiments, the following compounds may be excluded from the third compound.

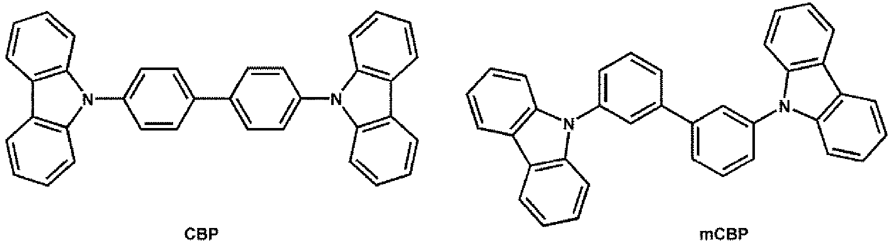

In one or more embodiments, the third compound may not include (e.g., may exclude) a (e.g., any) compound represented by Formula 3-1 described herein.

In one or more embodiments, a difference between a triplet energy level (electron volt (eV)) of the fourth compound and a singlet energy level (eV) of the fourth compound may be at least about 0 eV and not more than about 0.5 eV (or, at least about 0 eV and not more than about 0.3 eV).

In one or more embodiments, the fourth compound may include at least one cyclic group including boron (B) and nitrogen (N) as ring-forming atoms.

In one or more embodiments, the fourth compound may be a C₈-C₆₀ (*e.g.* C₈-C₃₀) polycyclic group-containing compound including at least two cyclic groups that are condensed with each other while sharing boron (B).

In one or more embodiments, the fourth compound may include a condensed ring in which at least one third ring may be condensed with at least one fourth ring, wherein
the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and
the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the second compound may include a compound represented by Formula 2: 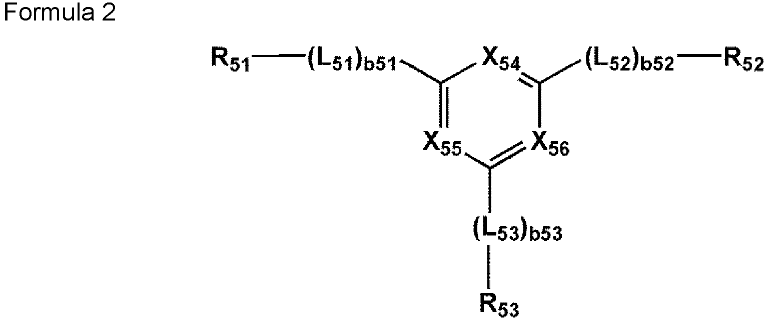 wherein, in Formula 2,
L₅₁ to L₅₃ are each independently a single bond, a C₃-C₆₀ (*e.g.* C₃-C₃₀) carbocyclic group that is unsubstituted or substituted with at least one R₁₀ₐ, or a C₁-C₆₀ (*e.g.* C₁-C₂₀) heterocyclic group that is unsubstituted or substituted with at least one R₁₀ₐ,
b51 to b53 are each independently an integer from 1 to 5,
X₅₄ is N or C(R₅₄), X₅₅ is N or C(R₅₅), X₅₆ is N or C(R₅₆), and at least one of X₅₄ to X₅₆ is N, and
R₅₁ to R₅₆ and R₁₀ₐ are each as described herein.

In one or more embodiments, the third compound may include a compound represented by Formula 3-1, a compound represented by Formula 3-2, a compound represented by Formula 3-3, a compound represented by Formula 3-4, a compound represented by Formula 3-5, or any combination thereof: 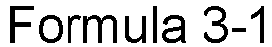 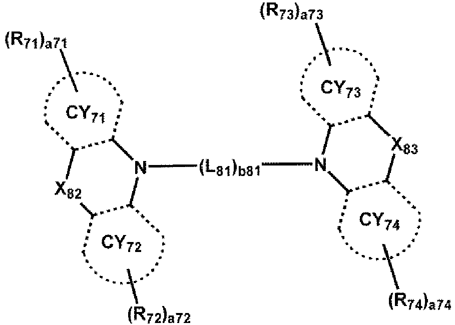 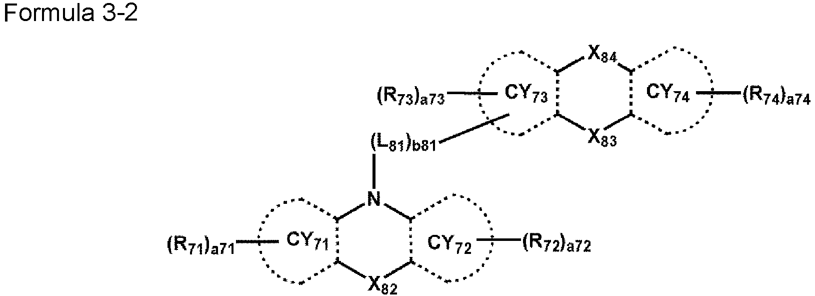 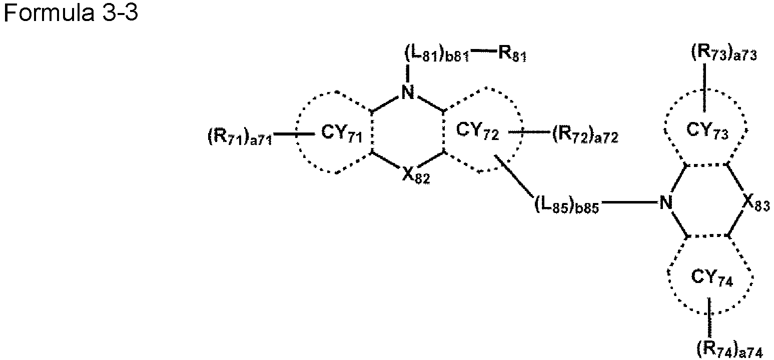 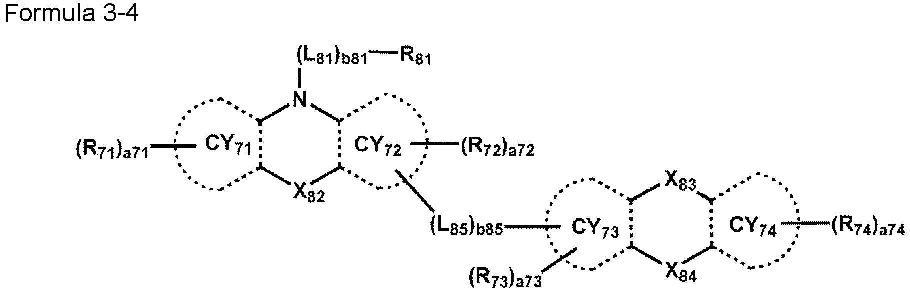 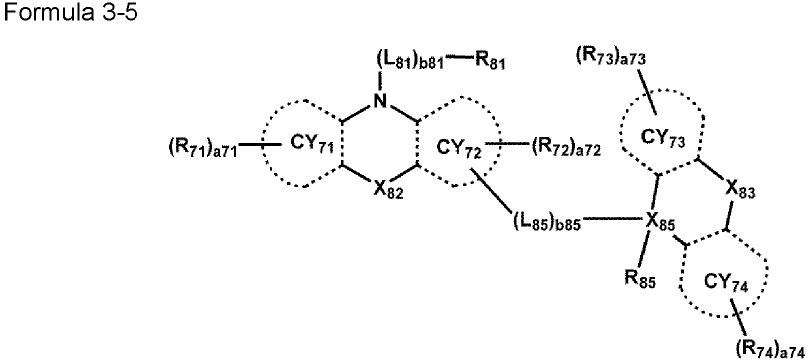 wherein, in Formulae 3-1 to 3-5,
rings CY₇₁ to ring CY₇₄ are each independently a π electron-rich C₃-C₆₀ (e.g. C₃-C₃₀) cyclic group or a pyridine group,
X₈₂ is a single bond, O, S, N-[(L₈₂)_{b82}-R₈₂], C(R₈₂ₐ)(R_{82b}), or Si(R₈₂ₐ)(R_{82b}),
X₈₃ is a single bond, O, S, N-[(L₈₃)_{b83}-R₈₃], C(R₈₃ₐ)(R_{83b}), or Si(R₈₃ₐ)(R_{83b}),
X₈₄ is O, S, N-[(L₈₄)_{b84}-R₈₄], C(R₈₄ₐ)(R_{84b}), or Si(R₈₄ₐ)(R_{84b}),
X₈₅ is C or Si,
L₈₁ to L₈₅ are each independently a single bond, *-C(Q₄)(Q₅)-*', *-Si(Q₄)(Q₅)-*', a π electron-rich C₃-C₆₀ (e.g. C₃-C₃₀) cyclic group that is unsubstituted or substituted with at least one R₁₀ₐ, or a pyridine group that is unsubstituted or substituted with at least one R₁₀ₐ, and Q₄ and Q₅ are each as described in connection with Q₁ herein,
b81 to b85 are each independently an integer from 1 to 5,
R₇₁ to R₇₄, R₈₁ to R₈₅, R₈₂ₐ, R_{82b}, R₈₃ₐ, R_{83b}, R₈₄ₐ, and R_{84b} are each the same as described herein,
a71 to a74 are each independently an integer from 0 to 20, and
R₁₀ₐ is as described herein.

In one or more embodiments, the fourth compound may be a compound represented by Formula 502, a compound represented by Formula 503, or any combination thereof: 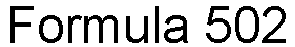 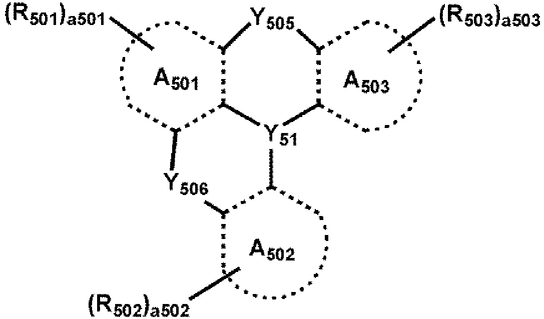 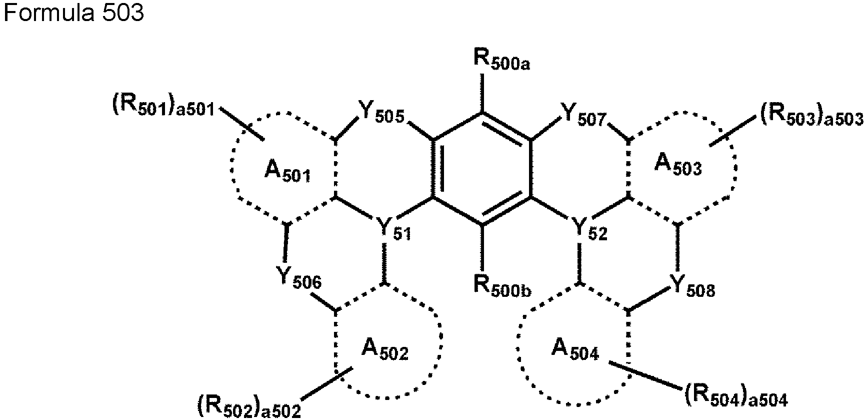 wherein, in Formulae 502 and 503,
ring A₅₀₁ to ring A₅₀₄ are each independently a C₃-C₆₀ (e.g. C₃-C₃₀) carbocyclic group or a C₁-C₆₀ (*e.g.* C₁-C₂₀) heterocyclic group,
Y₅₀₅ is O, S, N(R₅₀₅), B(R₅₀₅), C(R₅₀₅ₐ)(R_{505b}), or Si(R₅₀₅ₐ)(R_{505b}),
Y₅₀₆ is O, S, N(R₅₀₆), B(R₅₀₆), C(R₅₀₆ₐ)(R_{506b}), or Si(R₅₀₆ₐ)(R_{506b}),
Y₅₀₇ is O, S, N(R₅₀₇), B(R₅₀₇), C(R₅₀₇ₐ)(R_{507b}), or Si(R₅₀₇ₐ)(R_{507b}),
Y₅₀₈ is O, S, N(R₅₀₈), B(R₅₀₈), C(R₅₀₈ₐ)(R_{508b}), or Si(R₅₀₈ₐ)(R_{508b}),
Y₅₁ and Y₅₂ are each independently B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} are each as described herein, and
a501 to a504 are each independently an integer from 0 to 20.

In one or more embodiments, the light-emitting device may satisfy at least one of Conditions 1 to 4:

### Condition 1

LUMO energy level (eV) of third compound > LUMO energy level (eV) of organometallic compound

### Condition 2

LUMO energy level (eV) of organometallic compound > LUMO energy level (eV) of second compound

### Condition 3

HOMO energy level (eV) of organometallic compound > HOMO energy level (eV) of third compound

### Condition 4

HOMO energy level (eV) of the third compound > HOMO energy level (eV) of the second compound
wherein the highest occupied molecular orbital (HOMO) energy level and the lowest unoccupied molecular orbital (LUMO) energy level of each of the organometallic compound, the second compound, and the third compound may each be a negative value and may be measured according to a suitable method in the art.

In one or more embodiments, an absolute value of a difference between the LUMO energy level of the organometallic compound and the LUMO energy level of the second compound may be at least about 0.1 eV and not more than about 1.0 eV, an absolute value of a difference between the LUMO energy level of the organometallic compound and the LUMO energy level of the third compound may be at least about 0.1 eV and not more than about 1.0 eV, an absolute value of a difference between the HOMO energy level of the organometallic compound and the HOMO energy level of the second compound may be not more than about 1.25 eV (for example, at least about 0.2 eV and not more than about 1.25 eV), and an absolute value of a difference between the HOMO energy level of the organometallic compound and the HOMO energy level of the third compound may be not more than about 1.25 eV (for example, at least about 0.2 eV and not more than about 1.25 eV).

When the relationships between LUMO energy level and HOMO energy level satisfy the conditions as described, the balance between holes and electrons injected into the emission layer may be made.

The light-emitting device may have a structure of a first embodiment or a second embodiment.

### First embodiment

According to the first embodiment, the organometallic compound may be included in the emission layer in the interlayer of the light-emitting device, wherein the emission layer may further include a host, the organometallic compound may be different from the host, and the emission layer may be to emit phosphorescence or fluorescence emitted from the organometallic compound. In other words, according to the first embodiment, the organometallic compound may be a dopant or an emitter. In one or more embodiments, the organometallic compound may be a phosphorescent dopant or a phosphorescent emitter.

Phosphorescence or fluorescence emitted from the organometallic compound may be blue light.

The emission layer may further include an auxiliary dopant. The auxiliary dopant may effectively transfer energy to the organometallic compound which is a dopant or an emitter to increase luminescence efficiency.

The auxiliary dopant may be different from the organometallic compound and the host.

In one or more embodiments, the auxiliary dopant may be a delayed fluorescence-emitting compound.

In one or more embodiments, the auxiliary dopant may include at least one cyclic group including boron (B) and nitrogen (N) as ring-forming atoms.

### Second embodiment

According to the second embodiment, the organometallic compound may be included in the emission layer in the interlayer of the light-emitting device, wherein the emission layer may further include a host and a dopant, the organometallic compound, the host, and the dopant may be different from one another, and the emission layer may be to emit (e.g., configured to emit) phosphorescence or fluorescence (for example, delayed fluorescence) from the dopant.

In one or more embodiments, the organometallic compound in the second embodiment may serve as an auxiliary dopant that transfers energy to a dopant (or emitter), not as a dopant.

In one or more embodiments, the organometallic compound in the second embodiment may serve as an emitter and as an auxiliary dopant that transfers energy to a dopant (or emitter).

In one or more embodiments, phosphorescence or fluorescence emitted from the dopant (or emitter) in the second embodiment may be blue phosphorescence or blue fluorescence (for example, blue delayed fluorescence).

The dopant (or emitter) in the second embodiment may be a phosphorescent dopant material (for example, the organometallic compound represented by Formula 1, an organometallic compound represented by Formula 401, or any combination thereof) or any fluorescent dopant material (for example, a compound represented by Formula 501, a compound represented by Formula 502, a compound represented by Formula 503, or any combination thereof).

In the first embodiment and the second embodiment, the blue light may have a maximum emission wavelength of about 390 nm to about 500 nm, about 410 nm to about 490 nm, about 430 nm to about 480 nm, about 440 nm to about 475 nm, or about 455 nm to about 470 nm.

The auxiliary dopant in the first embodiment may include, for example, the fourth compound represented by Formula 502 or Formula 503.

The host in the first embodiment and the second embodiment may be any host material (for example, a compound represented by Formula 301, a compound represented by 301-1, a compound represented by Formula 301-2, or any combination thereof).

In one or more embodiments, the host in the first embodiment and the second embodiment may be the second compound, the third compound, or any combination thereof.

In one or more embodiments, the light-emitting device may further include a capping layer arranged outside the first electrode and/or outside the second electrode.

In one or more embodiments, the light-emitting device may further include at least one of a first capping layer located outside the first electrode and a second capping layer located outside the second electrode, and at least one of the first capping layer and the second capping layer may include the organometallic compound represented by Formula 1. The first capping layer and/or the second capping layer may each be as described herein.

In one or more embodiments, the light-emitting device may further include:
a first capping layer arranged outside the first electrode and including the organometallic compound represented by Formula 1;
a second capping layer arranged outside the second electrode and including the organometallic compound represented by Formula 1; or
the first capping layer and the second capping layer.

The expression that "(interlayer and/or a capping layer) includes an organometallic compound represented by Formula 1" as utilized herein may be to refer to that the (interlayer and/or the capping layer) may include one kind of organometallic compound represented by Formula 1 or two or more different kinds of organometallic compounds, each represented by Formula 1.

In one or more embodiments, the interlayer and/or the capping layer may include only Compound BD1 as the organometallic compound. In this regard, Compound BD1 may be present in the emission layer of the light-emitting device. In one or more embodiments, the interlayer may include Compound BD1 and Compound BD2 as the organometallic compound. In this regard, Compound BD1 and Compound BD2 may exist in substantially the same layer (for example, both (e.g., simultaneously) Compound BD1 and Compound BD2 may exist in the emission layer), or different layers (for example, Compound BD1 may exist in the emission layer and Compound BD2 may exist in the electron transport region).

The term "interlayer" as utilized herein refers to a single layer and/or all of a plurality of layers arranged between the first electrode and the second electrode of the light-emitting device.

According to one or more embodiments, an electronic apparatus includes the light-emitting device. The electronic apparatus may further include a thin-film transistor. In one or more embodiments, the electronic apparatus may further include a thin-film transistor including a source electrode and a drain electrode, wherein the first electrode of the light-emitting device may be electrically connected to the source electrode or the drain electrode. In one or more embodiments, the electronic apparatus may further include a color filter, a color conversion layer, a touch screen layer, a polarizing layer, or any combination thereof. A detailed description of the electronic apparatus is provided herein.

According to one or more embodiments, electronic equipment includes the light-emitting device.

In one or more embodiments, the electronic equipment may be at least one selected from among of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, a signboard, and combinations thereof.

According to one or more embodiments, provided is the organometallic compound represented by Formula 1. Formula 1 is as described herein.

Methods of synthesizing the organometallic compound may be easily understood by those of ordinary skill in the art by referring to Synthesis Examples and/or Examples described herein.

### Description of Formula 1

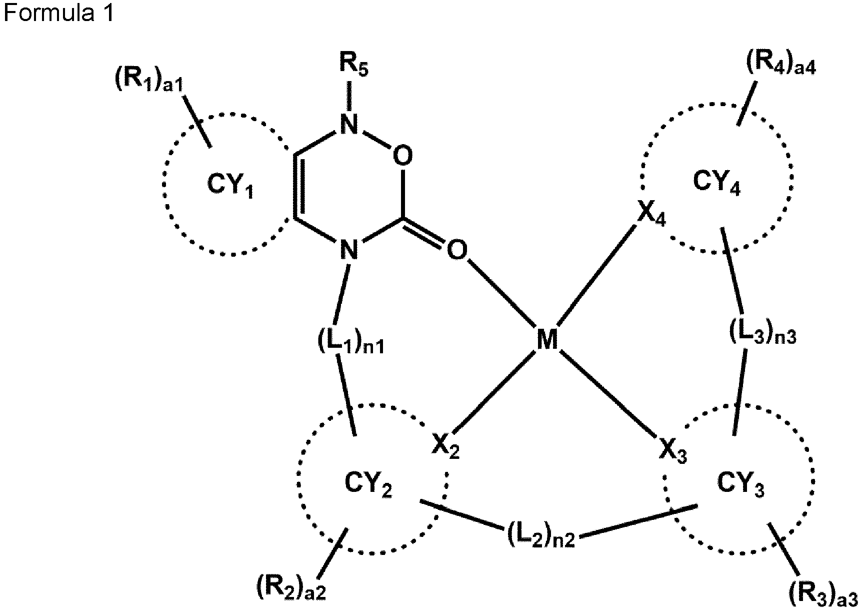

In Formula 1, M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In one or more embodiments, M may be platinum (Pt) or palladium (Pd). In one or more embodiments, M may be platinum (Pt).

In Formula 1, X₂ to X₄ are each independently C or **N.**

In one or more embodiments, X₂ and X₃ may each be C, and X₄ may be **N.**

In one or more embodiments, one of a bond between X₂ and M, a bond between X₃ and M, and a bond between X₄ and M may be a coordinate bond, and the other two bonds may each be a covalent bond.

In one or more embodiments, a bond between X₂ and M and a bond between X₃ and M may each be a covalent bond, and a bond between X₄ and M may be a coordinate bond.

In one or more embodiments, M may be platinum (Pt), X₂ and X₃ may each be C, X₄ may be N, a bond between X₂ and M and a bond between X₃ and M may each be a covalent bond, and a bond between X₄ and M may be a coordinate bond.

In Formula 1, rings CY₁ to CY₄ are each independently a C₅-C₃₀ (*e.g.* C₅-C₂₀) carbocyclic group or a C₁-C₃₀ (*e.g.* C₁-C₂₀) heterocyclic group.

In one or more embodiments, rings CY₁ to CY₄ may each independently be
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodihydrodisiline group, a dibenzodihydrosiline group, a dibenzodioxine group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group.

In one or more embodiments, ring CY₁ may be
a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenbenzosilole group, an azadinaphthofuran group, an azadinaphthothiophene group, an azadibenzocarbazole group, an azadibenzofluorene group, or an azadinaphthosilole group.

In one or more embodiments, ring CY₁ may be
a benzene group, a pyridine group, a pyrimidine group, a naphthalene group, a dibenzofuran group, a dibenzothiophene group, a carbazole group, a fluorene group, or a dibenzosilole group. In one or more embodiments, ring CY₁ may be a benzene group.

In one or more embodiments, ring CY₂ may be
a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenbenzosilole group, an azadinaphthofuran group, an azadinaphthothiophene group, an azadibenzocarbazole group, an azadibenzofluorene group, or an azadinaphthosilole group.

In one or more embodiments, ring CY₂ may be a benzene group, a pyridine group, a pyrimidine group, a naphthalene group, a dibenzofuran group, a dibenzothiophene group, a carbazole group, a fluorene group, or a dibenzosilole group.

In one or more embodiments, ring CY₃ may be
a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenbenzosilole group, an azadinaphthofuran group, an azadinaphthothiophene group, an azadibenzocarbazole group, an azadibenzofluorene group, or an azadinaphthosilole group.

In one or more embodiments, ring CY₃ may be
a pyridine group, a pyrimidine group, a dibenzofuran group, a dibenzothiophene group, a carbazole group, a fluorene group, or a dibenzosilole group.

In one or more embodiments, ring CY₄ may be
a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a benzopyrazole group, a benzimidazole group, or a benzothiazole group.

In Formula 1, L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom. In one or more embodiments, L₁ may be a single bond. In one or more embodiments, L₂ may be O. In one or more embodiments, L₃ may be a single bond. In one or more embodiments, L₁ may be a single bond, L₂ may be O, and L₃ may be a single bond.

In Formula 1, n1 to n3 respectively indicate the number of L₁ to the number of L₃, and are each independently an integer from 1 to 5. When n1 is 2 or more, two or more of L₁ may be identical to or different from each other, when n2 is 2 or more, two or more of L₂ may be identical to or different from each other, and when n3 is 2 or more, two or more of L₃ may be identical to or different from each other.

In one or more embodiments, R₁ₐ and R_{1b} may each independently be hydrogen, deuterium, -F, -Cl, -Br, -I, a hydroxyl group, a cyano group, a nitro group, a C₁-C₆₀ (e.g. C₁-C₂₀) alkyl group that is unsubstituted or substituted with at least one R₁₀ₐ, a C₂-C₆₀ (*e.g*. C₂-C₂₀) alkenyl group that is unsubstituted or substituted with at least one R₁₀ₐ, a C₂-C₆₀ (*e.g.* C₂-C₂₀) alkynyl group that is unsubstituted or substituted with at least one R₁₀ₐ, a C₁-C₆₀ (*e.g.* C₁-C₂₀) alkoxy group that is unsubstituted or substituted with at least one R₁₀ₐ, a C₁-C₆₀ (*e.g.* C₁-C₂₀) alkylthio group that is unsubstituted or substituted with at least one R₁₀ₐ, a C₃-C₆₀ (*e.g.* C₃-C₃₀) carbocyclic group that is unsubstituted or substituted with at least one R₁₀ₐ, a C₁-C₆₀ (*e.g.* C₁-C₂₀) heterocyclic group that is unsubstituted or substituted with at least one R₁₀ₐ, a C₆-C₆₀ (*e.g.* C₆-C₃₀) aryloxy group that is unsubstituted or substituted with at least one R₁₀ₐ, a C₆-C₆₀ (*e.g.* C₆-C₃₀) arylthio group that is unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ are each as described herein.

In one or more embodiments, R₁ₐ and R_{1b} may each independently be:

hydrogen, deuterium, -F, -Cl, -Br, -I, a hydroxyl group, a cyano group, a nitro group, a C₁-C₂₀ (*e.g.* C₁-C₁₀) alkyl group, or a C₁-C₂₀ (*e.g.* C₁-C₁₀) alkoxy group;
a C₁-C₂₀ (*e.g.* C₁-C₁₀) alkyl group or a C₁-C₂₀ (*e.g.* C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂).
Q₁ to Q₃ and Q₃₁ to Q₃₃ are each as described herein.

In one or more embodiments, L₁ and L₃ may each be a single bond, L₂ may be *-O-*' or *-S-*', and n2 may be 1.

In Formula 1, R₁ to R₅ are each independently hydrogen, deuterium, -F, -Cl, -Br, -I, a hydroxyl group, a cyano group, a nitro group, a C₁-C₆₀ (*e.g.* C₁-C₂₀) alkyl group that is unsubstituted or substituted with at least one R₁₀ₐ, a C₂-C₆₀ (*e.g.* C₂-C₂₀) alkenyl group that is unsubstituted or substituted with at least one R₁₀ₐ, a C₂-C₆₀ (*e.g.* C₂-C₂₀) alkynyl group that is unsubstituted or substituted with at least one R₁₀ₐ, a C₁-C₆₀ (*e.g*. C₁-C₂₀) alkoxy group that is unsubstituted or substituted with at least one R₁₀ₐ, a C₁-C₆₀ (*e.g.* C₁-C₂₀) alkylthio group that is unsubstituted or substituted with at least one R₁₀ₐ, a C₃-C₆₀ (*e.g.* C₃-C₃₀) carbocyclic group that is unsubstituted or substituted with at least one R₁₀ₐ, a C₁-C₆₀ (*e.g.* C₁-C₂₀) heterocyclic group that is unsubstituted or substituted with at least one R₁₀ₐ, a C₆-C₆₀ (*e.g.* C₆-C₃₀) aryloxy group that is unsubstituted or substituted with at least one R₁₀ₐ, a C₆-C₆₀ (*e.g.* C₆-C₃₀) arylthio group that is unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ are each as described herein.

In Formula 1, a1 to a4 respectively indicate the number of R₁ to the number of R₄, and are each independently an integer from 1 to 20. When a1 is 2 or more, two or more of R₁ may be identical to or different from each other, when a2 is 2 or more, two or more of R₂ may be identical to or different from each other, when a3 is 2 or more, two or more of R₃ may be identical to or different from each other, and when a4 is 2 or more, two or more of R₄ may be identical to or different from each other.

In one or more embodiments, two or more neighboring groups of R₁ to R₅ may be optionally bonded together to form a C₃-C₆₀ (*e.g.* C₃-C₃₀) carbocyclic group that is unsubstituted or substituted with at least one R₁₀ₐ or a C₁-C₆₀ (*e.g.* C₁-C₂₀) heterocyclic group that is unsubstituted or substituted with at least one R₁₀ₐ.

R₁₀ₐ is as described herein.

In one or more embodiments, R₁ to R₅ may each independently be:
hydrogen, deuterium, -F, -Cl, -Br, -I, a hydroxyl group, a cyano group, a nitro group, a C₁-C₂₀ (*e.g.* C₁-C₁₀) alkyl group, or a C₁-C₂₀ (*e.g.* C₁-C₁₀) alkoxy group;
a C₁-C₂₀ (*e.g.* C₁-C₁₀) alkyl group or a C₁-C₂₀ (*e.g.* C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂).
Q₁ to Q₃ and Q₃₁ to Q₃₃ are each as described herein.

In one or more embodiments, R₁ to R₅ may each independently be:
hydrogen, deuterium, a cyano group, or a C₁-C₂₀ (*e.g.* C₁-C₁₀) alkyl group;
a C₁-C₂₀ (*e.g.* C₁-C₁₀) alkyl group that is substituted with deuterium, -CD₃, - CD₂H, -CDH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -CD₃, -CD₂H, -CDH₂, a cyano group, a C₁-C₂₀ (*e.g.* C₁-C₁₀) alkyl group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, -Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; a cyano group; a C₁-C₆₀ (*e.g.* C₁-C₂₀) alkyl group; a C₂-C₆₀ (*e.g.* C₂-C₂₀) alkenyl group; a C₂-C₆₀ (*e.g.* C₂-C₂₀) alkynyl group; or a C₃-C₆₀ (*e.g.* C₃-C₃₀) carbocyclic group that is unsubstituted or substituted with deuterium, a cyano group, a C₁-C₆₀ (*e.g.* C₁-C₂₀) alkyl group, a phenyl group, a biphenyl group, or any combination thereof.

In one or more embodiments, R₅ may be a group represented by Formula 1-1: 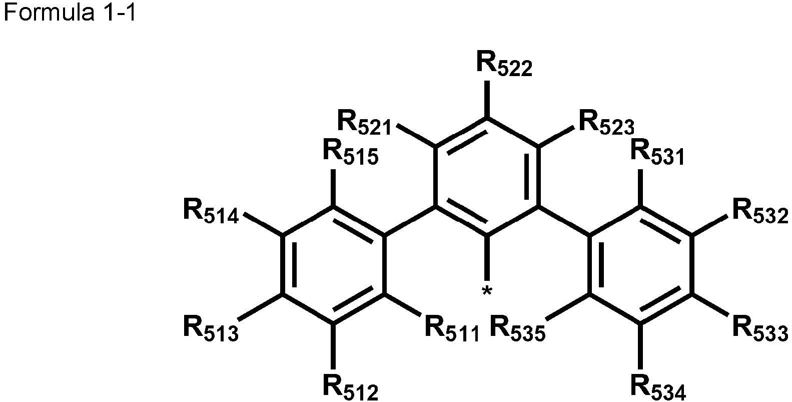 wherein, in Formula 1-1,
R₅₁₁ to R₅₁₅, R₅₂₁ to R₅₂₃, and R₅₃₁ to R₅₃₅ are each as described in connection with R₅ herein, and
* indicates a binding site to N in Formula 1.

In one or more embodiments, in Formula 1, a group represented by 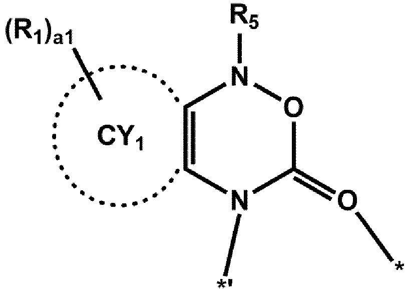 may be selected from groups represented by Formulae CY1-1 to CY1-14: 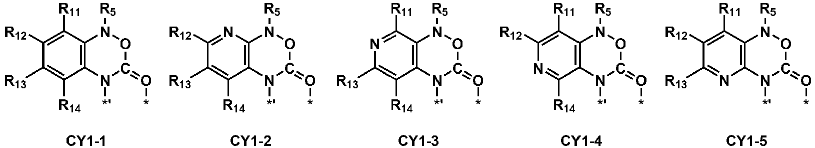 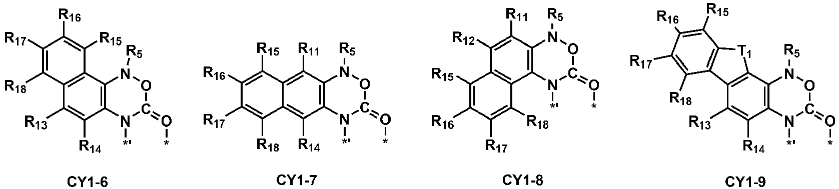 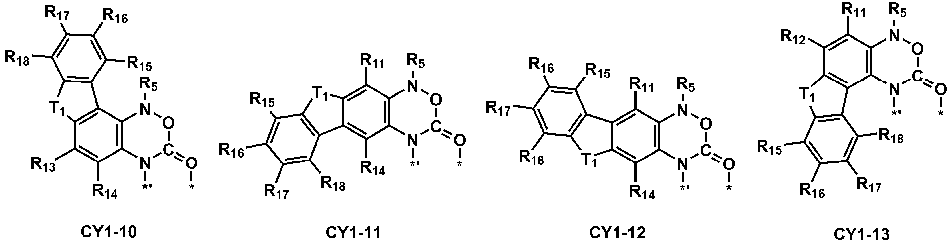 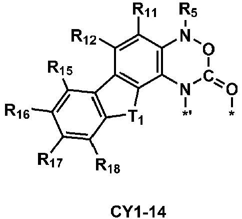 wherein, in Formulae CY1-1 to CY1-14,
T₁ is C(Y₁₁)(Y₁₂), N(Y₁₁), O, S, or Si(Y₁₁)(Y₁₂),
Y₁₁ and Y₁₂ are each independently hydrogen, deuterium, -F, -Cl, -Br, -I, a hydroxyl group, a cyano group, a nitro group, a C₁-C₆₀ (*e.g.* C₁-C₂₀) alkyl group that is unsubstituted or substituted with at least one R₁₀ₐ, a C₂-C₆₀ (*e.g.* C₂-C₂₀) alkenyl group that is unsubstituted or substituted with at least one R₁₀ₐ, a C₂-C₆₀ (*e.g.* C₂-C₂₀) alkynyl group that is unsubstituted or substituted with at least one R₁₀ₐ, a C₁-C₆₀ (*e.g.* C₁-C₂₀) alkoxy group that is unsubstituted or substituted with at least one R₁₀ₐ, a C₁-C₆₀ (*e.g.* C₁-C₂₀) alkylthio group that is unsubstituted or substituted with at least one R₁₀ₐ, a C₃-C₆₀ (*e.g.* C₃-C₃₀) carbocyclic group that is unsubstituted or substituted with at least one R₁₀ₐ, a C₁-C₆₀ (*e.g.* C₁-C₂₀) heterocyclic group that is unsubstituted or substituted with at least one R₁₀ₐ, a C₆-C₆₀ (*e.g.* C₆-C₃₀) aryloxy group that is unsubstituted or substituted with at least one R₁₀ₐ, a C₆-C₆₀ (*e.g.* C₆-C₃₀) arylthio group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
R₁₀ₐ and Q₁ to Q₃ are each as described herein,
R₁₁ to R₁₈ are each as described in connection with R₁ herein,
R₅ is as described herein,
* indicates a binding site to M in Formula 1, and
*' indicates a binding site to L₁ in Formula 1.

In one or more embodiments, in Formula 1, a group represented by 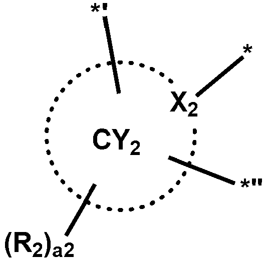 may be selected from groups represented by Formulae CY2-1 to CY2-16: 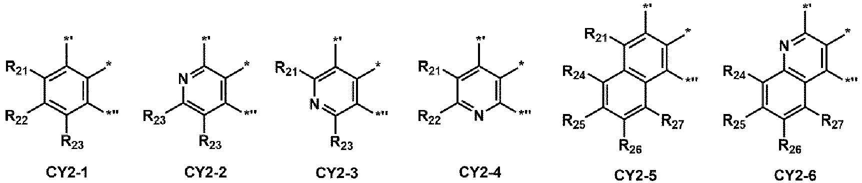 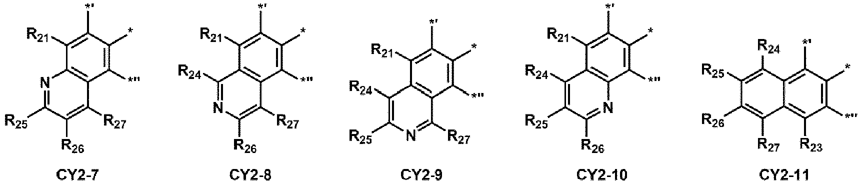 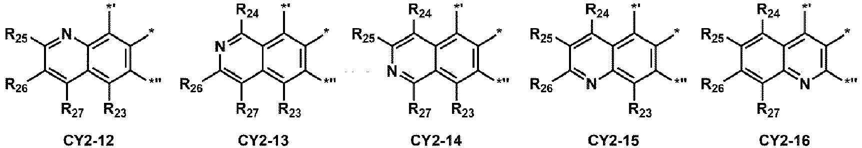 wherein, in Formulae CY2-1 to CY2-16,
R₂₁ to R₂₇ are each as described in connection with R₂ herein,
* indicates a binding site to M in Formula 1,
*' indicates a binding site to L₁ in Formula 1, and
*" indicates a binding site to L₂ in Formula 1.

In one or more embodiments, in Formula 1, a group represented by 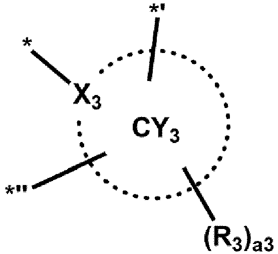 may be selected from groups represented by Formulae CY3-1 to CY3-16: 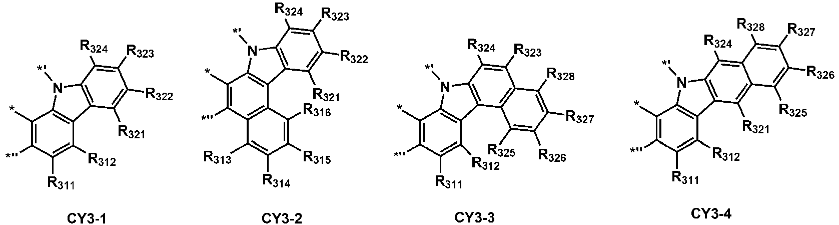 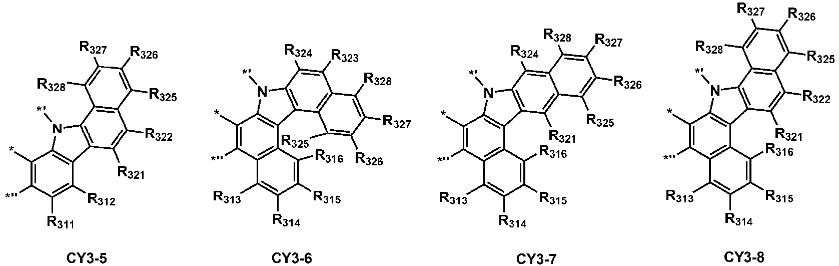 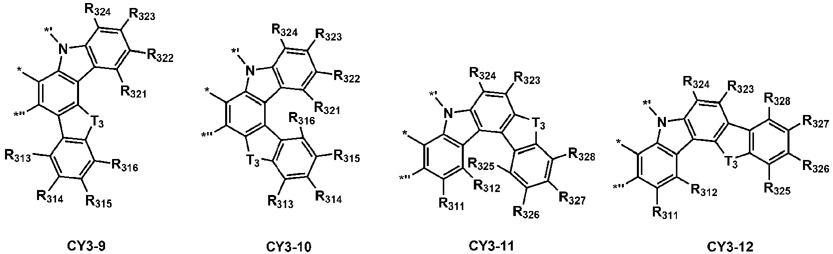 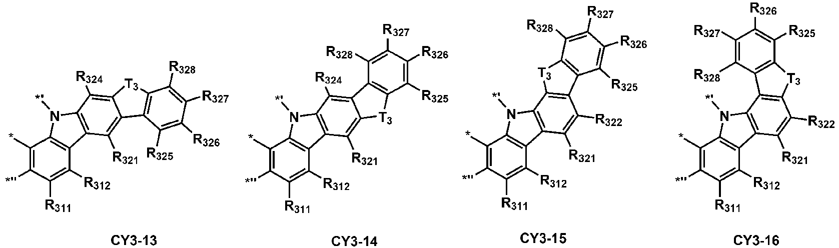 wherein, in Formulae CY3-1 to CY3-16,
T₃ is C(Y₃₁)(Y₃₂), N(Y₃₁), O, S, or Si(Y₃₁)(Y₃₂),
Y₃₁ and Y₃₂ are each independently hydrogen, deuterium, -F, -Cl, -Br, -I, a hydroxyl group, a cyano group, a nitro group, a C₁-C₆₀ (*e.g.* C₁-C₂₀) alkyl group that is unsubstituted or substituted with at least one R₁₀ₐ, a C₂-C₆₀ (*e.g.* C₂-C₂₀) alkenyl group that is unsubstituted or substituted with at least one R₁₀ₐ, a C₂-C₆₀ (*e.g.* C₂-C₂₀) alkynyl group that is unsubstituted or substituted with at least one R₁₀ₐ, a C₁-C₆₀ (*e.g.* C₁-C₂₀) alkoxy group that is unsubstituted or substituted with at least one R₁₀ₐ, a C₁-C₆₀ (*e.g.* C₁-C₂₀) alkylthio group that is unsubstituted or substituted with at least one R₁₀ₐ, a C₃-C₆₀ (*e.g.* C₃-C₃₀) carbocyclic group that is unsubstituted or substituted with at least one R₁₀ₐ, a C₁-C₆₀ (*e.g.* C₁-C₂₀) heterocyclic group that is unsubstituted or substituted with at least one R₁₀ₐ, a C₆-C₆₀ (*e.g.* C₆-C₃₀) aryloxy group that is unsubstituted or substituted with at least one R₁₀ₐ, a C₆-C₆₀ (*e.g.* C₆-C₃₀) arylthio group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
R₁₀ₐ and Q₁ to Q₃ are each as described herein,
R₃₁₁ to R₃₁₆ and R₃₂₁ to R₃₂₈ are each as described in connection with R₃ herein,
* indicates a binding site to M in Formula 1,
*' indicates a binding site to L₃ in Formula 1, and
*" indicates a binding site to L₂ in Formula 1.

In one or more embodiments, in Formula 1, a group represented by 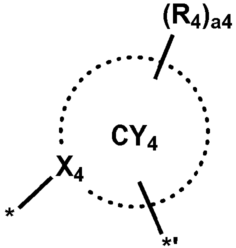 may be selected from groups represented by Formulae CY4-1 to CY4-19: 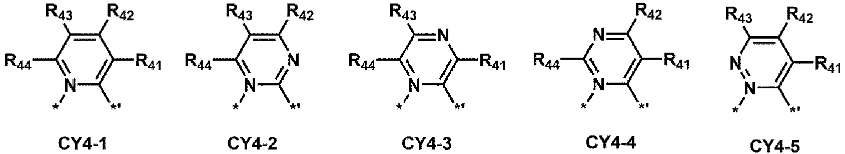 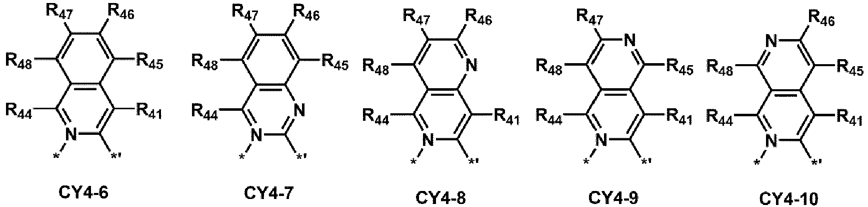 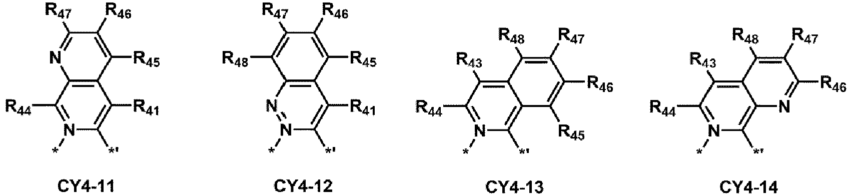 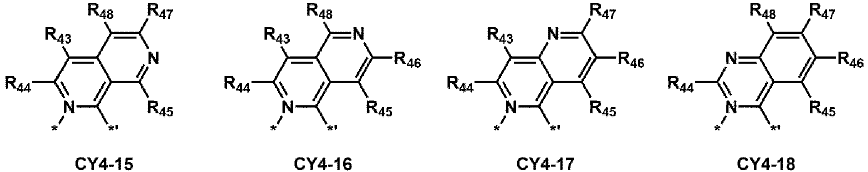 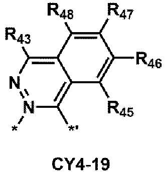 wherein, in Formulae CY4-1 to CY4-19,
R₄₁ to R₄₈ are each as described in connection with R₄ herein,
* indicates a binding site to M in Formula 1, and
*' indicates a binding site to L₃ in Formula 1.

In one or more embodiments, the organometallic compound represented by Formula 1 may be represented by Formula 1-2: 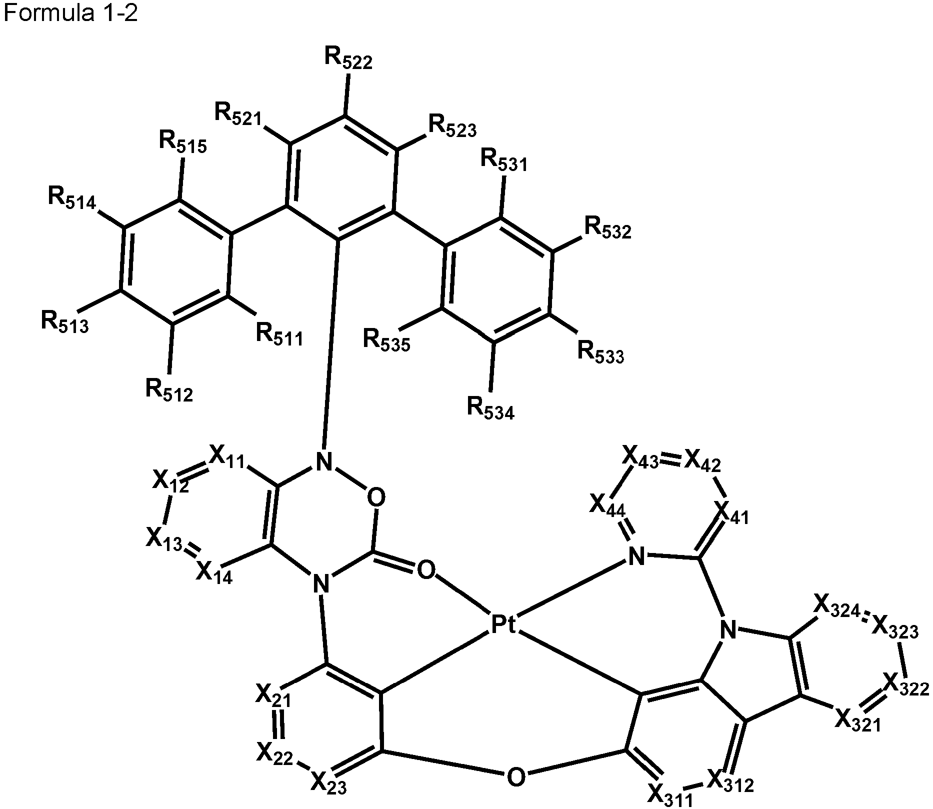 wherein, in Formula 1-2,
X₁₁ is C(R₁₁) or N, X₁₂ is C(R₁₂) or N, X₁₃ is C(R₁₃) or N, and X₁₄ is C(R₁₄) or N,
X₂₁ is C(R₂₁) or N, X₂₂ ise C(R₂₂) or N, and X₂₃ is C(R₂₃) or N,
X311 is C(R₃₁₁) or N, X₃₁₂ is C(R₃₁₂) or N, X₃₂₁ is C(R₃₂₁) or N, X₃₂₂ is C(R₃₂₂) or N, X₃₂₃ is C(R₃₂₃) or N, and X₃₂₄ is C(R₃₂₄) or N,
X₄₁ ise C(R₄₁) or N, X₄₂ is C(R₄₂) or N, X₄₃ is C(R₄₃) or N, and X₄₄ is C(R₄₄) or N,
R₁₁ to R₁₄ are each as described in connection with R₁ herein,
R₂₁ to R₂₃ are each as described in connection with R₂ herein,
R₃₁₁, R₃₁₂, and R₃₂₁ to R₃₂₄ are each as described in connection with R₃ herein,
R₄₁ to R₄₄ are each as described in connection with R₄ herein, and
R₅₁₁ to R₅₁₅, R₅₂₁ to R₅₂₃, and R₅₃₁ to R₅₃₅ are each as described in connection with R₅ herein.

In one or more embodiments, two or more neighboring groups of R₁₁ to R₁₄, R₂₁ to R₂₃, R₃₁₁, R₃₁₂, R₃₂₁ to R₃₂₄, R₄₁ to R₄₄, R₅₁₁ to R₅₁₅, R₅₂₁ to R₅₂₃, and R₅₃₁ to R₅₃₅ may be optionally bonded together to form a C₃-C₆₀ (*e.g.* C₃-C₃₀) carbocyclic group that is unsubstituted or substituted with at least one R₁₀ₐ or a C₁-C₆₀ (*e.g.* C₁-C₂₀) heterocyclic group that is unsubstituted or substituted with at least one R₁₀ₐ.

R₁₀ₐ is as described herein.

Unless defined otherwise, for example, in the description of Formula 1, R₁₀ₐ is:
deuterium, -F, -Cl, -Br, -I, a hydroxyl group, a cyano group, or a nitro group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group, each unsubstituted or substituted with deuterium, -F, -Cl, -Br, -I, a hydroxyl group, a cyano group, a nitro group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, or a C₆-C₆₀ (*e.g.* C₆-C₃₀) arylthio group, each unsubstituted or substituted with deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Unless defined otherwise, for example, in the description of Formula 1, Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ (*e.g.* C₁-C₂₀) alkyl group; a C₂-C₆₀ (*e.g.* C₂-C₂₀) alkenyl group; a C₂-C₆₀ (*e.g.* C₂-C₂₀) alkynyl group; a C₁-C₆₀ (*e.g.* C₁-C₂₀) alkoxy group; or a C₃-C₆₀ (*e.g.* C₃-C₃₀) carbocyclic group or a C₁-C₆₀ (*e.g.* C₁-C₂₀) heterocyclic group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a phenyl group, a biphenyl group, or any combination thereof.

In the organometallic compound represented by Formula 1, because the interaction between R₅ which is a substituent and ring CY₄ is enhanced due to the hydrogen bonding effect by the oxygen (O) atom of 1,2,5-oxadiazin-6-one ring, the overall rigidity of the molecule is increased such that the color purity and luminescence efficiency may be increased, and the formation of a ³MC state may be inhibited such that overall structural stability may be increased, and exciplex formation with a host may be inhibited. Accordingly, an electronic device (for example, an organic light-emitting device) having low driving voltage, high efficiency, and long lifespan characteristics may be implemented by utilizing the organometallic compound.

### Description of other formulae

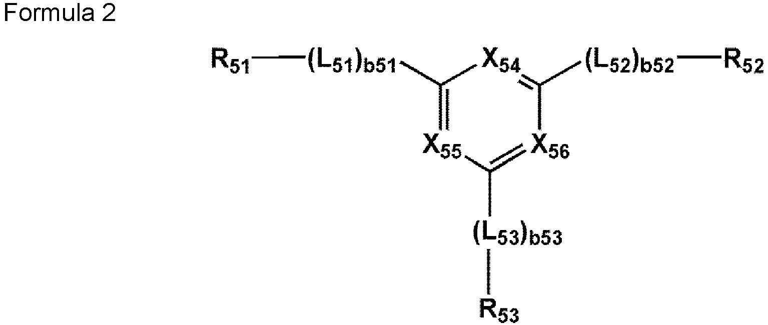

In Formula 2, L₅₁ to L₅₃ are each independently a single bond, a C₃-C₆₀ (*e.g.* C₃-C₃₀) carbocyclic group that is unsubstituted or substituted with at least one R₁₀ₐ, or a C₁-C₆₀ (*e.g.* C₁-C₂₀) heterocyclic group that is unsubstituted or substituted with at least one R₁₀ₐ.

b51 to b53 in Formula 2 respectively indicate the number of L₅₁ to the number of L₅₃, and are each an integer from 1 to 5. When b51 is 2 or more, two or more of L₅₁ may be identical to or different from each other, when b52 is 2 or more, two or more of L₅₂ may be identical to or different from each other, and when b53 is 2 or more, two or more of L₅₃ may be identical to or different from each other. In one or more embodiments, b51 to b53 may each independently be 1 or 2.

L₅₁ to L₅₃ in Formula 2 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxane group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof, and
Q₃₁ to Q₃₃ may each independently be hydrogen, deuterium, a C₁-C₂₀ (*e.g.* C₁-C₁₀) alkyl group, a C₁-C₂₀ (*e.g.* C₁-C₁₀) alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formula 2, a bond between L₅₁ and R₅₁, a bond between L₅₂ and R₅₂, a bond between L₅₃ and R₅₃, a bond between two or more L₅₁, a bond between two or more L₅₂, a bond between two or more L₅₃, a bond between L₅₁ and carbon between X₅₄ and X₅₅ in Formula 2, a bond between L₅₂ and carbon between X₅₄ and X₅₆ in Formula 2, and a bond between L₅₃ and carbon between X₅₅ and X₅₆ in Formula 2 may each be a "carbon-carbon single bond".

In Formula 2, X₅₄ is N or C(R₅₄), X₅₅ is N or C(R₅₅), X₅₆ is N or C(R₅₆), and at least one of X₅₄ to X₅₆ is N. R₅₄ to R₅₆ are each as described herein. In one or more embodiments, two or three of X₅₄ to X₅₆ may be N.

In Formula 2, R₅₁ to R₅₆ are each independently hydrogen, deuterium, -F, - Cl, -Br, -I, a hydroxyl group, a cyano group, a nitro group, a C₁-C₆₀ (*e.g.* C₁-C₂₀) alkyl group that is unsubstituted or substituted with at least one R₁₀ₐ, a C₂-C₆₀ (*e.g.* C₂-C₂₀) alkenyl group that is unsubstituted or substituted with at least one R₁₀ₐ, a C₂-C₆₀ (*e.g.* C₂-C₂₀) alkynyl group that is unsubstituted or substituted with at least one R₁₀ₐ, a C₁-C₆₀ (*e.g.* C₁-C₂₀) alkoxy group that is unsubstituted or substituted with at least one R₁₀ₐ, a C₃-C₆₀ (*e.g.* C₆-C₃₀) carbocyclic group that is unsubstituted or substituted with at least one R₁₀ₐ, a C₁-C₆₀ (*e.g.* C₁-C₂₀) heterocyclic group that is unsubstituted or substituted with at least one R₁₀ₐ, a C₆-C₆₀ (*e.g.* C₆-C₃₀) aryloxy group that is unsubstituted or substituted with at least one R₁₀ₐ, a C₆-C₆₀ (*e.g.* C₆-C₃₀) arylthio group that is unsubstituted or substituted with at least one R₁₀ₐ, a C₇-C₆₀ (*e.g.* C₇-C₃₀) arylalkyl group that is unsubstituted or substituted with at least one R₁₀ₐ, a C₂-C₆₀ (*e.g.* C₂-C₂₀) heteroarylalkyl group that is unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂). Q₁ to Q₃ are each as described herein.

In Formula 2, R₅₁ to R₅₆ may each independently be:
hydrogen, deuterium, -F, -Cl, -Br, -I, a hydroxyl group, a cyano group, a nitro group, a C₁-C₂₀ (*e.g.* C₁-C₁₀) alkyl group, or a C₁-C₂₀ (*e.g.* C₁-C₁₀) alkoxy group;
a C₁-C₂₀ (*e.g.* C₁-C₁₀) alkyl group or a C₁-C₂₀ (*e.g.* C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 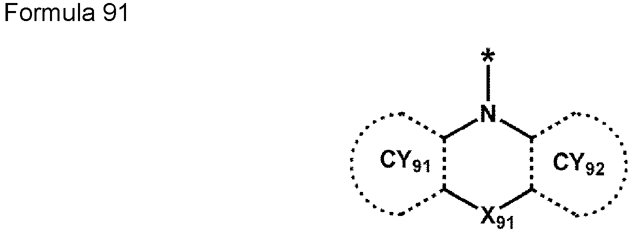 wherein, in Formula 91,
      ring CY₉₁ and ring CY₉₂ are each independently a C₅-C₃₀ (e.g. C₅-C₂₀) carbocyclic group that is unsubstituted or substituted with at least one R₁₀ₐ or a C₁-C₃₀ (e.g. C₁-C₂₀) heterocyclic group that is unsubstituted or substituted with at least one R₁₀ₐ,
      X₉₁ is a single bond, O, S, N(R₉₁), B(R₉₁), C(R₉₁ₐ)(R_{91b}), or Si(R₉₁ₐ)(R_{91b}),
      R₉₁, R₉₁ₐ, and R_{91b} are each independently as described in connection with R₈₂, R₈₂ₐ, and R_{82b}, respectively,
      R₁₀ₐ is as described herein, and
      * indicates a binding site to a neighboring atom.

In one or more embodiments, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In Formula 2, a group represented by *-(L₅₁)_{b51}-R₅₁ and a group represented by *-(L₅₂)_{b52}-R₅₂ may each not be a phenyl group.

In one or more embodiments, in Formula 2, a group represented by *-(L₅₁)_{b51}-R₅₁ and a group represented by *-(L₅₂)_{b52}-R₅₂ may be identical to each other.

In one or more embodiments, in Formula 2, a group represented by *-(L₅₁)_{b51}-R₅₁ and a group represented by *-(L₅₂)_{b52}-R₅₂ may be different from each other.

In one or more embodiments, in Formula 2, b51 and b52 may each be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

In one or more embodiments, R₅₁ and R₅₂ in Formula 2 may each independently be a C₃-C₆₀ (*e.g*. C₃-C₃₀) carbocyclic group that is unsubstituted or substituted with at least one R₁₀ₐ, a C₁-C₆₀ (*e.g*. C₁-C₂₀) heterocyclic group that is unsubstituted or substituted with at least one R₁₀ₐ, a C₆-C₆₀ (*e.g*. C₆-C₃₀) aryloxy group that is unsubstituted or substituted with at least one R₁₀ₐ, a C₆-C₆₀ (*e.g*. C₆-C₃₀) arylthio group that is unsubstituted or substituted with at least one R₁₀ₐ, -C(Q₁)(Q₂)(Q₃), or - Si(Q₁)(Q₂)(Q₃), and
Q₁ to Q₃ may each independently be a C₃-C₆₀ (*e.g*. C₃-C₃₀) carbocyclic group or a C₁-C₆₀ (*e.g*. C₁-C₂₀) heterocyclic group, each unsubstituted or substituted with deuterium, -F, a cyano group, a C₁-C₆₀ (*e.g*. C₁-C₂₀) alkyl group, a C₁-C₆₀ (*e.g*. C₁-C₂₀) alkoxy group, a phenyl group, a biphenyl group, or any combination thereof.

In one or more embodiments,
a group represented by *-(L₅₁)_{b51}-R₅₁ in Formula 2 may be a group represented by one of Formulae CY51-1 to CY51-26, and/or
a group represented by *-(L₅₂)_{b52}-R₅₂ in Formula 2 may be a group represented by one of Formulae CY52-1 to CY52-26, and/or
a group represented by *-(L₅₃)_{b53}-R₅₃ in Formula 2 may be a group represented by one of Formulae CY53-1 to CY53-27, -C(Q₁)(Q₂)(Q₃), or - Si(Q₁)(Q₂)(Q₃): 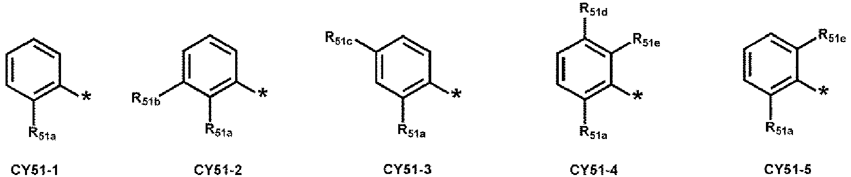 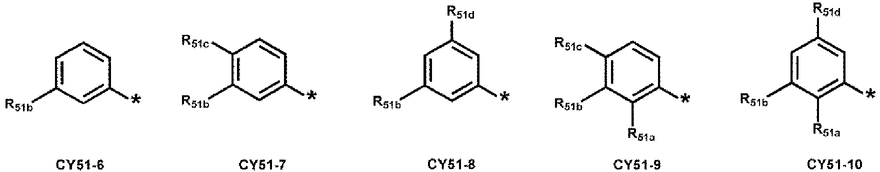 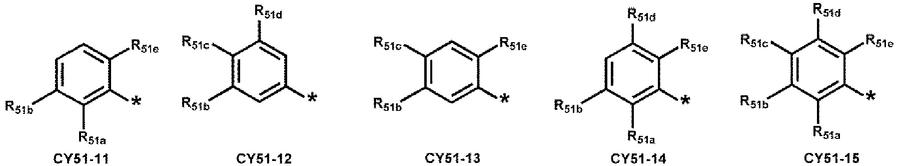 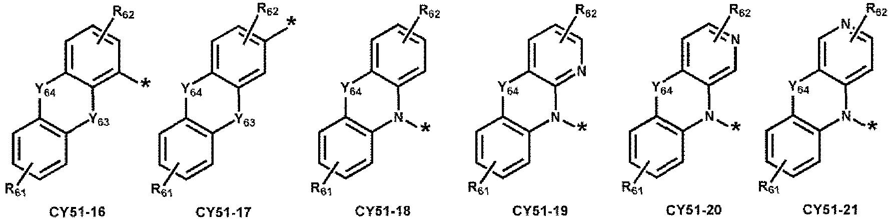 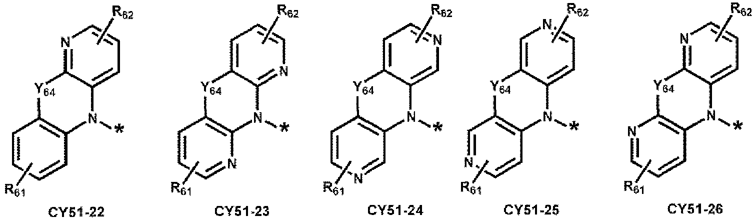 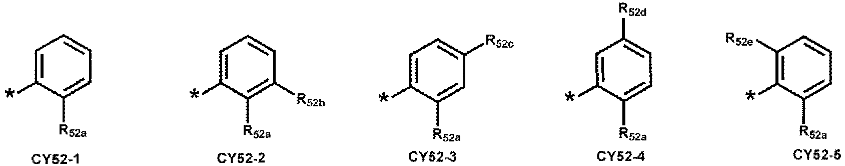 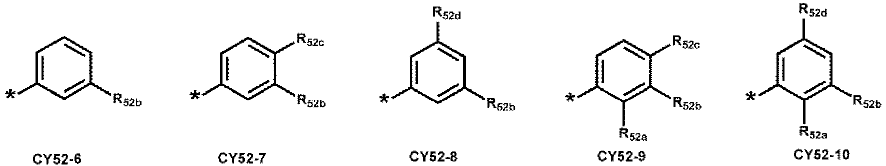 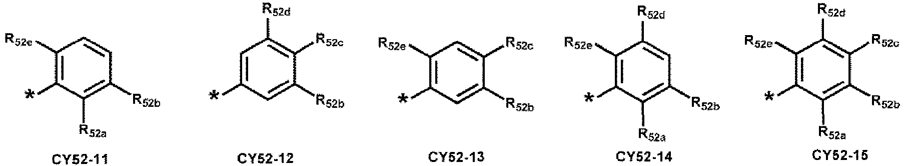 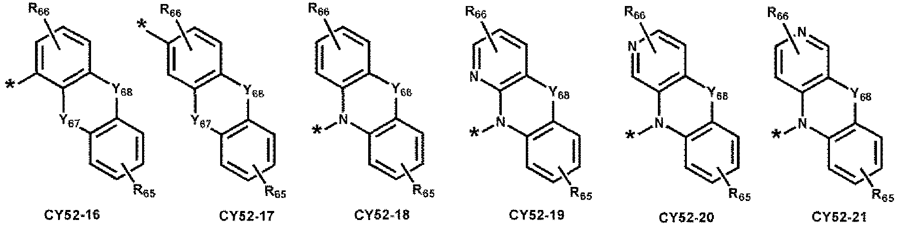 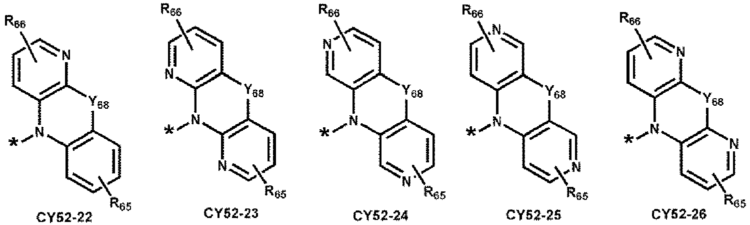 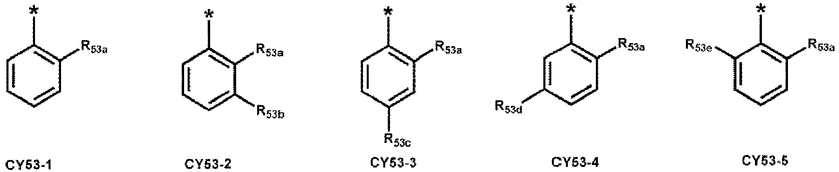 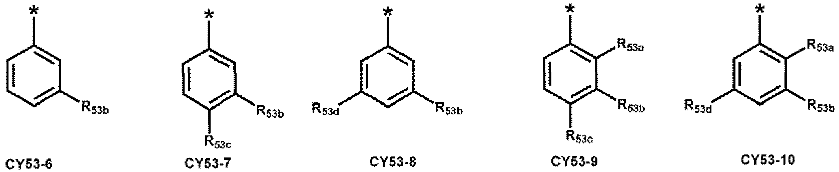 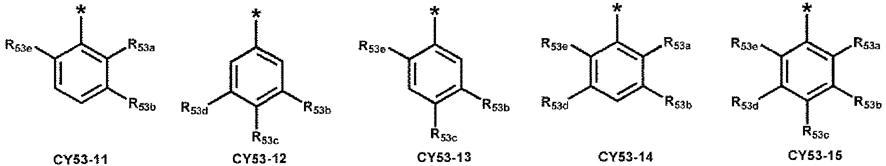 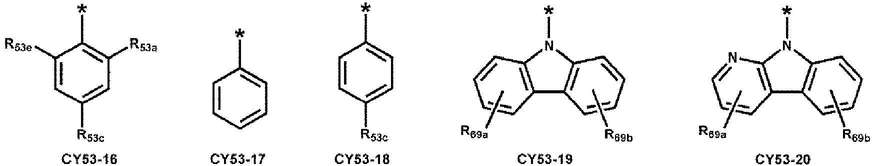 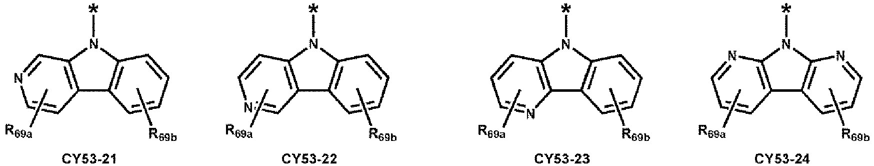 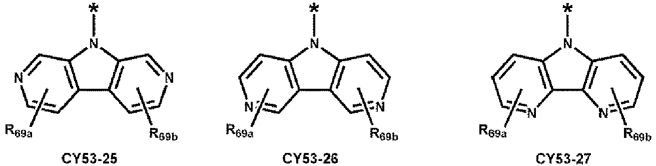
wherein, in Formulae CY51-1 to CY51-26, CY52-1 to CY52-26, and CY53-1 to CY53-27,
Y₆₃ is a single bond, O, S, N(R₆₃), B(R₆₃), C(R₆₃ₐ)(R_{63b}), or Si(R₆₃ₐ)(R_{63b}),
Y₆₄ is a single bond, O, S, N(R₆₄), B(R₆₄), C(R₆₄ₐ)(R_{64b}), or Si(R₆₄ₐ)(R_{64b}),
Y₆₇ is a single bond, O, S, N(R₆₇), B(R₆₇), C(R₆₇ₐ)(R_{67b}), or Si(R₆₇ₐ)(R_{67b}),
Y₆₈ is a single bond, O, S, N(R₆₈), B(R₆₈), C(R₆₈ₐ)(R_{68b}), or Si(R₆₈ₐ)(R_{68b}),
each of Y₆₃ and Y₆₄ in Formulae CY51-16 and CY51-17 may not be a single bond at the same time,
each of Y₆₇ and Y₆₈ in Formulae CY52-16 and CY52-17 may not be a single bond at the same time,
R₅₁ₐ to R₅₁ₑ, R₆₁ to R₆₄, R₆₃ₐ, R_{63b}, R₆₄ₐ, and R_{64b} are each as described in connection with R₅₁ herein, and R₅₁ₐ to R₅₁ₑ may each not be hydrogen,
R₅₂ₐ to R₅₂ₑ, R₆₅ to R₆₈, R₆₇ₐ, R_{67b}, R₆₈ₐ, and R_{68b} are each as described in connection with R₅₂ herein, and R₅₂ₐ to R₅₂ₑ may each not be hydrogen,
R₅₃ₐ to R₅₃ₑ, R₆₉ₐ, and R_{69b} are each as described in connection with R₅₃ herein, and R₅₃ₐ to R₅₃ₑ may each not be hydrogen, and
* indicates a binding site to a neighboring atom.

In one or more embodiments,
in Formulae CY51-1 to CY51-26 and Formulae CY52-1 to CY52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ (*e.g*. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or

   -C(Q₁)(Q₂)(Q₃) or -Si(Q₁)(Q₂)(Q₃),
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof,
in Formulae CY51-16 and CY51-17, i) Y₆₃ may be O or S, and Y₆₄ may be Si(R₆₄ₐ)(R_{64b}), or ii) Y₆₃ may be Si(R₆₃ₐ)(R_{63b}) and Y₆₄ may be O or S, and
in Formulae CY52-16 and CY52-17, i) Y₆₇ may be O or S, and Y₆₈ may be Si(R₆₈ₐ)(R_{68b}), or ii) Y₆₇ may be Si(R₆₇ₐ)(R_{67b}), and Y₆₈ may be O or S.

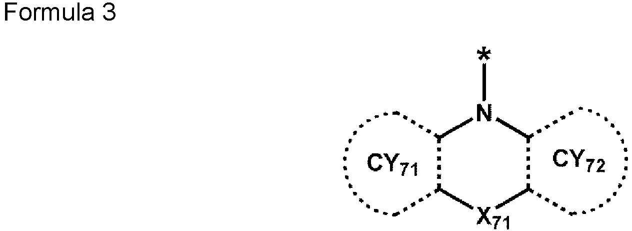

In Formula 3, ring CY₇₁ and ring CY₇₂ are each independently a π electron-rich C₃-C₆₀ (e.g. C₃-C₃₀) cyclic group or a pyridine group.

In Formula 3, X₇₁ is a single bond, or a linking group including O, S, N, B, C, Si, or any combination thereof.

In Formula 3, * indicates a binding site to any atom included in the remaining part other than Formula 3 in the third compound.

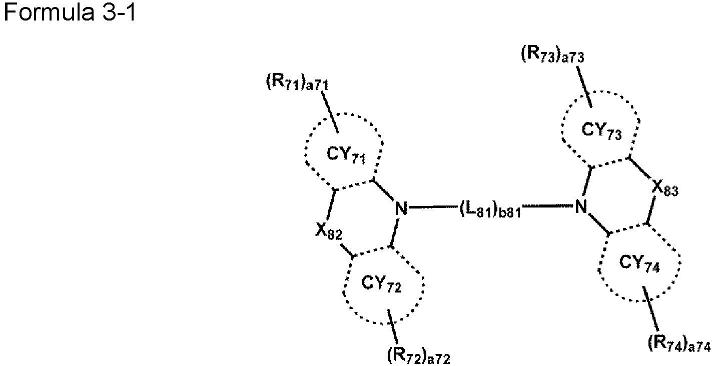

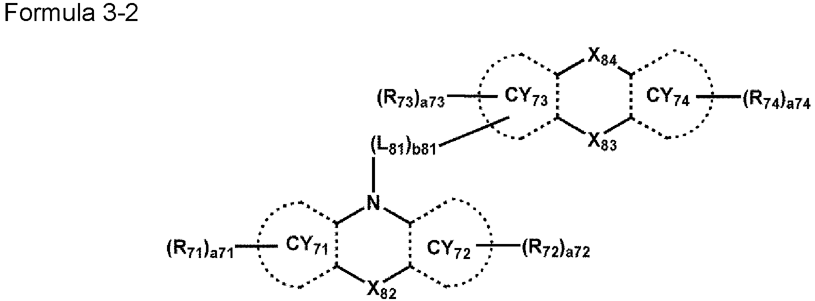

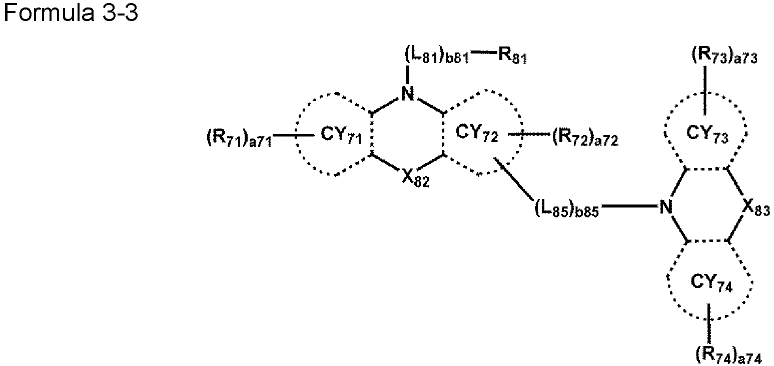

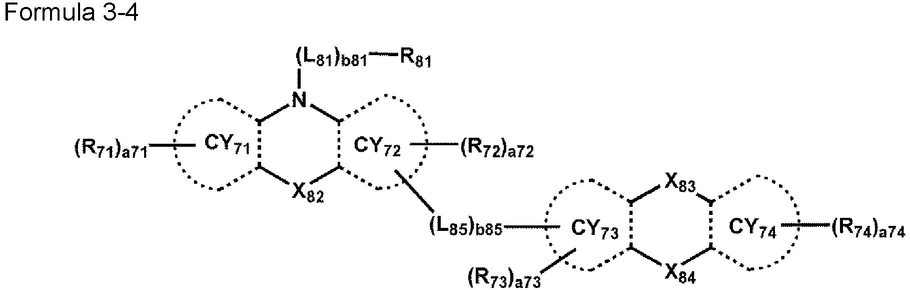

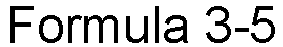

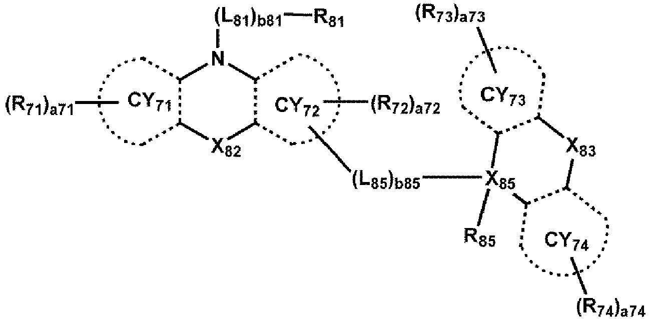

In Formulae 3-1 to 3-5, ring CY₇₁ to ring CY₇₄ are each independently a π electron-rich C₃-C₆₀ (*e.g*. C₃-C₃₀) cyclic group or a pyridine group.

In Formulae 3-1 to 3-5, X₈₂ is a single bond, O, S, N-[(L₈₂)_{b82}-R₈₂], C(R₈₂ₐ)(R_{82b}), or Si(R₈₂ₐ)(R_{82b}).

In Formulae 3-1 to 3-5, X₈₃ is a single bond, O, S, N-[(L₈₃)_{b83}-R₈₃], C(R₈₃ₐ)(R_{83b}), or Si(R₈₃ₐ)(R_{83b}).

In Formulae 3-1 to 3-5, X₈₄ is O, S, N-[(L₈₄)_{b84}-R₈₄], C(R₈₄ₐ)(R_{84b}), or Si(R₈₄ₐ)(R_{84b}).

In Formulae 3-1 to 3-5, X₈₅ is C or Si.

In Formulae 3-1 to 3-5, L₈₁ to L₈₅ are each independently a single bond, *-C(Q₄)(Q₅)-*', *-Si(Q₄)(Q₅)-*', a π electron-rich C₃-C₆₀ (*e.g*. C₃-C₃₀) cyclic group that is unsubstituted or substituted with at least one R₁₀ₐ or a pyridine group that is unsubstituted or substituted with at least one R₁₀ₐ.

Q₄ and Q₅ are each as described in connection with Q₁ herein.

In Formulae 3-1 to 3-5, b81 to b85 are each independently an integer from 1 to 5.

In Formulae 3-1 to 3-5, R₇₁ to R₇₄, R₈₁ to R₈₅, R₈₂ₐ, R_{82b}, R₈₃ₐ, R_{83b}, R₈₄ₐ, and R_{84b} are each independently as described herein.

In Formulae 3-1 to 3-5, a71 to a74 respectively indicate the number of R₇₁ to the number of R₇₄, and are each independently an integer from 0 to 20. When a71 is 2 or more, two or more of R₇₁ may be identical to or different from each other, when a72 is 2 or more, two or more of R₇₂ may be identical to or different from each other, when a73 is 2 or more, two or more of R₇₃ may be identical to or different from each other, and when a74 is 2 or more, two or more of R₇₄ may be identical to or different from each other. a71 to a74 may each independently be an integer from 0 to 8.

R₁₀ₐ is as described herein.

In Formulae 3-1 to 3-5, L₈₁ to L₈₅ may each independently be:
a single bond;

   *-C(Q₄)(Q₅)-*' or *-Si(Q₄)(Q₅)-*';

   or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ (*e.g*. C₁-C₁₀) alkyl group, a C₁-C₂₀ (*e.g*. C₁-C₁₀) alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof, and
Q₄, Q₅, and Q₃₁ to Q₃₃ may each independently be hydrogen, deuterium, a C₁-C₂₀ (*e.g*. C₁-C₁₀) alkyl group, a C₁-C₂₀ (*e.g*. C₁-C₁₀) alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 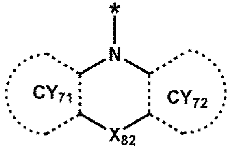 in Formulae 3-1 and 3-2 may be a group represented by one of Formulae CY71-1(1) to CY71-1(8), and/or
a group represented by 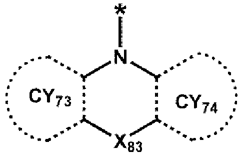 in Formulae 3-1 and 3-3 may be a group represented by one of Formulae CY71-2(1) to CY71-2(8), and/or
a group represented by 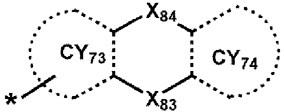 in Formulae 3-2 and 3-4 may be a group represented by one of Formulae CY71-3(1) to CY71-3(32),
a group represented by 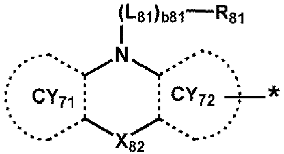 in Formulae 3-3 to 3-5 may be a group represented by one of Formulae CY71-4(1) to CY71-4(32), and/or
a group represented by 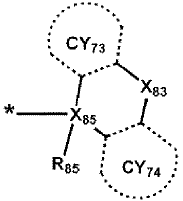 in Formula 3-5 may be a group represented by one of Formulae CY71-5(1) to CY71-5(8): 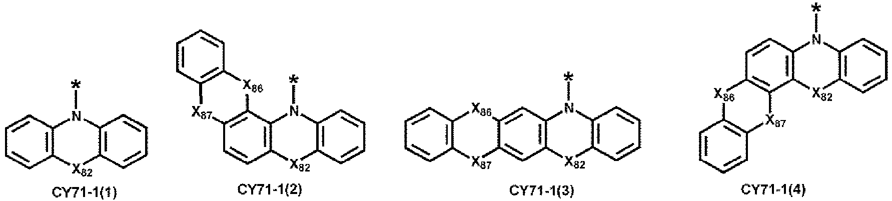 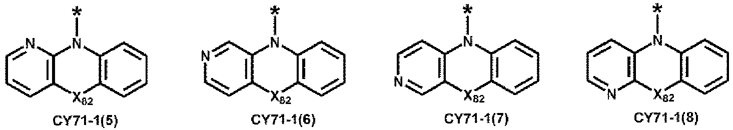 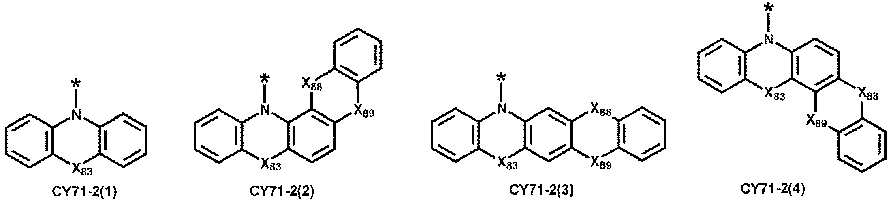 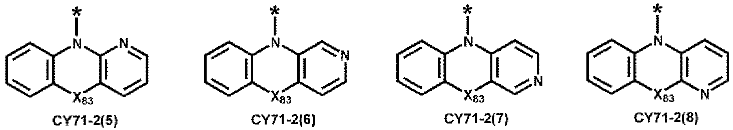 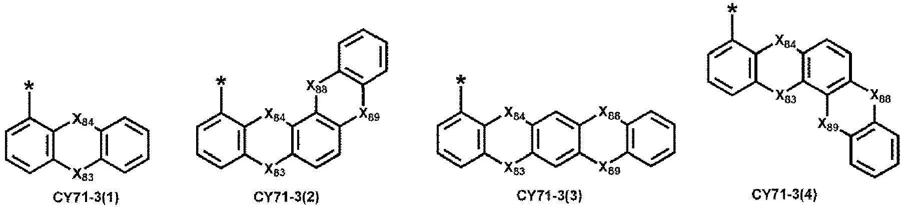 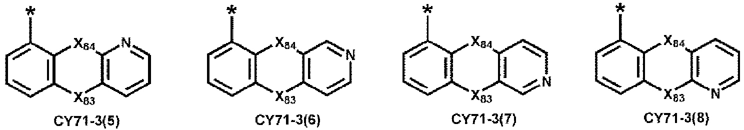 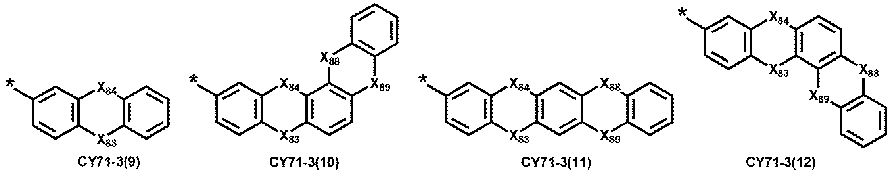 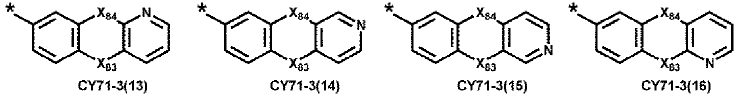 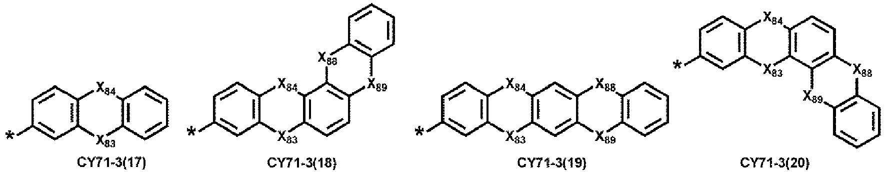 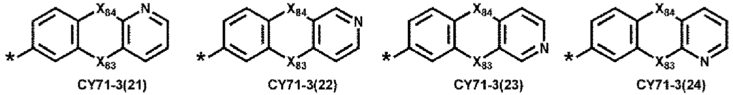 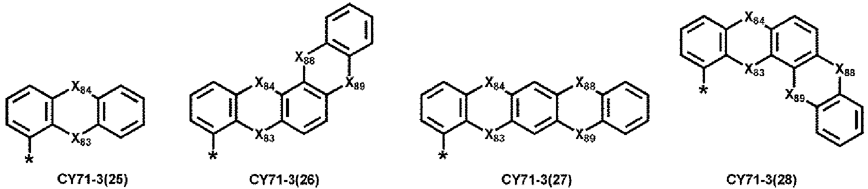 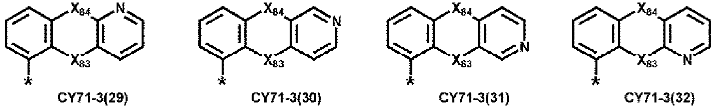 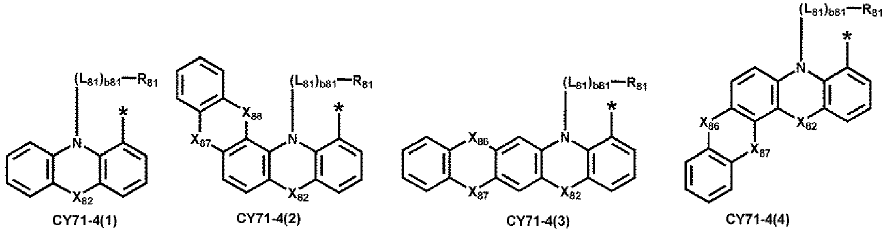 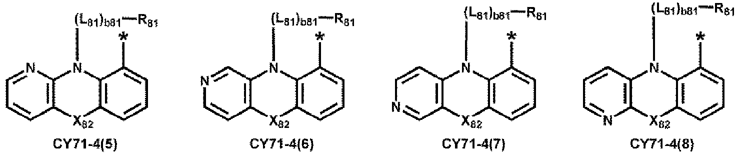 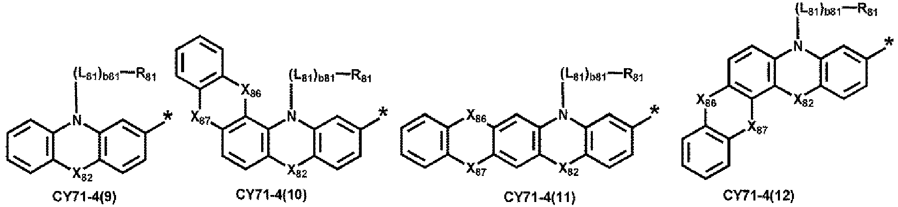 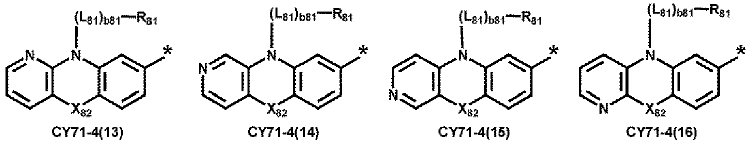 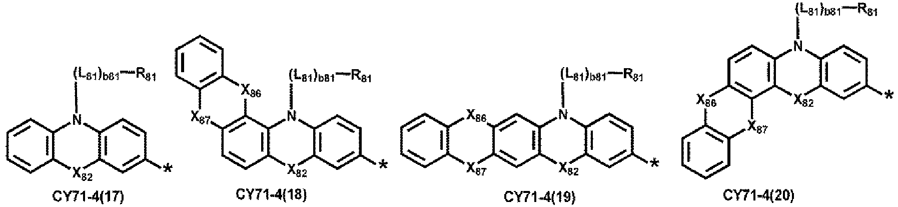 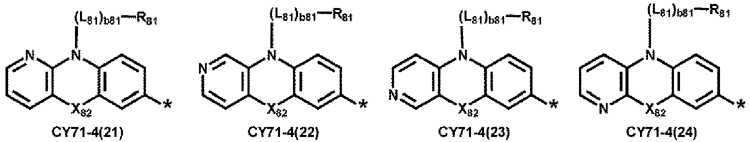 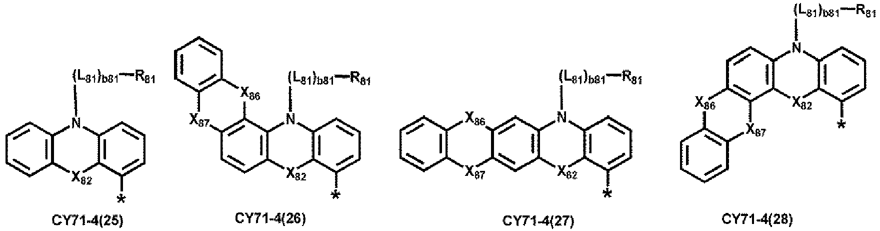 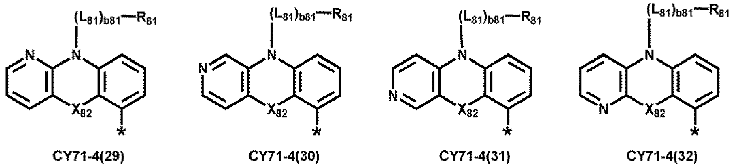 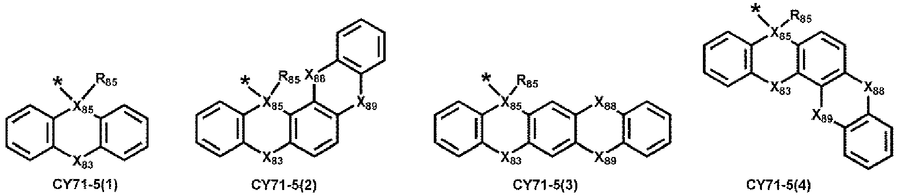 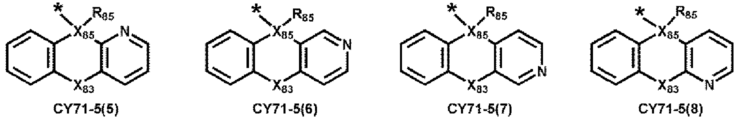
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ are each as described herein,
X₈₆ is a single bond, O, S, N(R₈₆), B(R₈₆), C(R₈₆ₐ)(R_{86b}), or Si(R₈₆ₐ)(R_{86b}),
X₈₇ is a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), each of X₈₆ and X₈₇ may not be a single bond at the same time,
X₈₈ is a single bond, O, S, N(R₈₈), B(R₈₈), C(R₈₈ₐ)(R_{88b}), or Si(R₈₈ₐ)(R_{88b}),
X₈₉ is a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), each of X₈₈ and X₈₉ may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} are each as described in connection with R₈₁ herein.

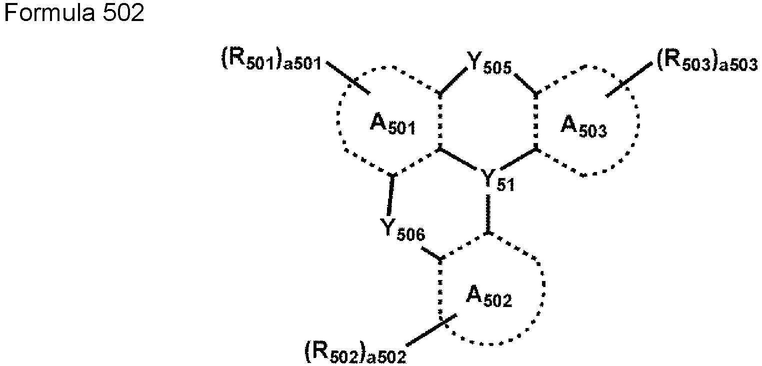

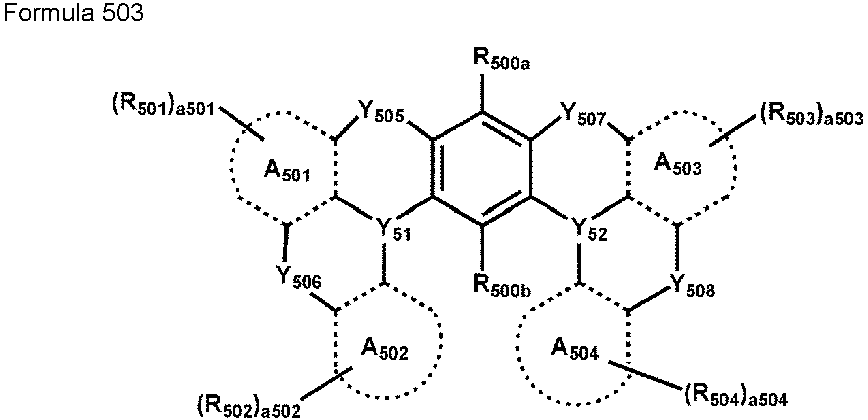

In Formulae 502 and 503, ring A₅₀₁ to ring A₅₀₄ are each independently a C₃-C₆₀ (e.g. C₃-C₃₀) carbocyclic group or a C₁-C₆₀ (e.g. C₁-C₂₀) heterocyclic group.

In Formulae 502 and 503, Y₅₀₅ is O, S, N(R₅₀₅), B(R₅₀₅), C(R₅₀₅ₐ)(R_{505b}), or Si(R₅₀₅ₐ)(R_{505b}).

In Formulae 502 and 503, Y₅₀₆ is O, S, N(R₅₀₆), B(R₅₀₆), C(R₅₀₆ₐ)(R_{506b}), or Si(R₅₀₆ₐ)(R_{506b}).

In Formulae 502 and 503, Y₅₀₇ is O, S, N(R₅₀₇), B(R₅₀₇), C(R₅₀₇ₐ)(R_{507b}), or Si(R507a)(R507b).

In Formulae 502 and 503, Y₅₀₈ is O, S, N(R₅₀₈), B(R₅₀₈), C(R₅₀₈ₐ)(R_{508b}), or Si(R508a)(R508b).

In Formulae 502 and 503, Y₅₁ and Y₅₂ are each independently B, P(=O), or S(=O).

In Formulae 502 and 503, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} are each as described herein.

In Formulae 502 and 503, a501 to a504 respectively indicate the number of R₅₀₁ to the number of R₅₀₄, and are each independently an integer from 0 to 20. When a501 is 2 or more, two or more of R₅₀₁ may be identical to or different from each other, when a502 is 2 or more, two or more of R₅₀₂ may be identical to or different from each other, when a503 is 2 or more, two or more of R₅₀₃ may be identical to or different from each other, and when a504 is 2 or more, two or more of R₅₀₄ may be identical to or different from each other. a501 to a504 may each independently an integer from 0 to 8.

Herein, R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} are each independently hydrogen, deuterium, -F, -Cl, -Br, -I, a hydroxyl group, a cyano group, a nitro group, a C₁-C₆₀ (*e.g*. C₁-C₂₀) alkyl group that is unsubstituted or substituted with at least one R₁₀ₐ, a C₂-C₆₀ (*e.g*. C₂-C₂₀) alkenyl group that is unsubstituted or substituted with at least one R₁₀ₐ, a C₂-C₆₀ (*e.g*. C₂-C₂₀) alkynyl group that is unsubstituted or substituted with at least one R₁₀ₐ, a C₁-C₆₀ (*e.g*. C₁-C₂₀) alkoxy group that is unsubstituted or substituted with at least one R₁₀ₐ, a C₃-C₆₀ (*e.g*. C₃-C₃₀) carbocyclic group that is unsubstituted or substituted with at least one R₁₀ₐ, a C₁-C₆₀ (*e.g*. C₁-C₂₀) heterocyclic group that is unsubstituted or substituted with at least one R₁₀ₐ, a C₆-C₆₀ (*e.g*. C₆-C₃₀) aryloxy group that is unsubstituted or substituted with at least one R₁₀ₐ, a C₆-C₆₀ (*e.g*. C₆-C₃₀) arylthio group that is unsubstituted or substituted with at least one R₁₀ₐ, a C₇-C₆₀ (*e.g*. C₇-C₃₀) arylalkyl group that is unsubstituted or substituted with at least one R₁₀ₐ, a C₂-C₆₀ (*e.g*. C₂-C₂₀) heteroarylalkyl group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ are each as described herein.

In one or more embodiments, i) in Formulae 2, 3-1 to 3-5, 502, and 503, R₅₁ to R₅₆, R₇₁ to R₇₄, R₈₁ to R₈₅, R₈₂ₐ, R_{82b}, R₈₃ₐ, R_{83b}, R₈₄ₐ and R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b}, and ii) R₁₀ₐ may each independently be:
hydrogen, deuterium, -F, -Cl, -Br, -I, a hydroxyl group, a cyano group, a nitro group, a C₁-C₂₀ (*e.g*. C₁-C₁₀) alkyl group, or a C₁-C₂₀ (*e.g*. C₁-C₁₀) alkoxy group;
a C₁-C₂₀ (*e.g*. C₁-C₁₀) alkyl group or a C₁-C₂₀ (*e.g*. C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ (*e.g*. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) in Formula 1, R₁ to R₅, ii) in Formulae 2, 3-1 to 3-5, 502, and 503, R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b}, and iii) R₁₀ₐ may each independently be
hydrogen, deuterium, -F, a cyano group, a nitro group, -CH₃, -CD₃, -CD₂H, - CDH₂, -CF₃, -CF₂H, -CFH₂,
a group represented by one of (e.g., one selected from among) Formulae 9-1 to 9-19,
a group represented by one of (e.g., one selected from among) Formulae 10-1 to 10-246, -C(Q₁)(Q₂)(Q₃), -Si(Q₁)(Q₂)(Q₃), and/or -P(=O)(Q₁)(Q₂) (Q₁ to Q₃ are each as described herein): 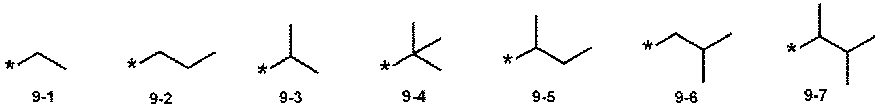 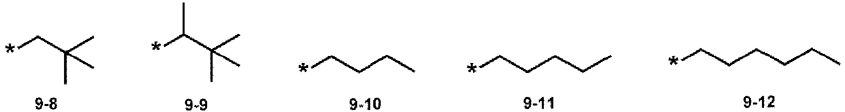 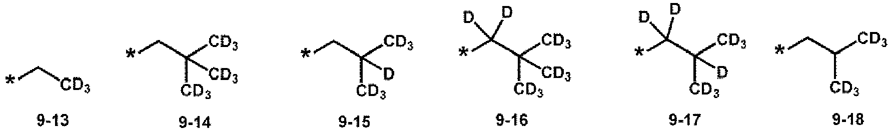 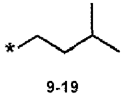 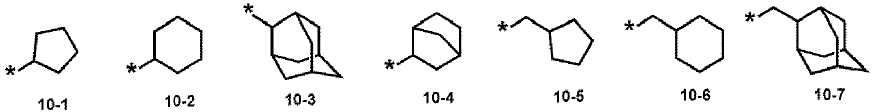 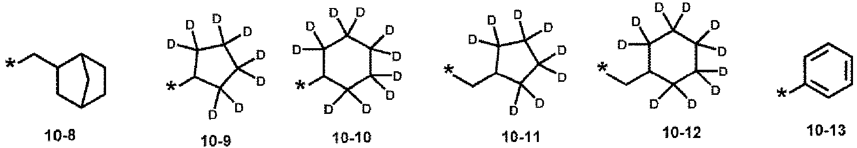 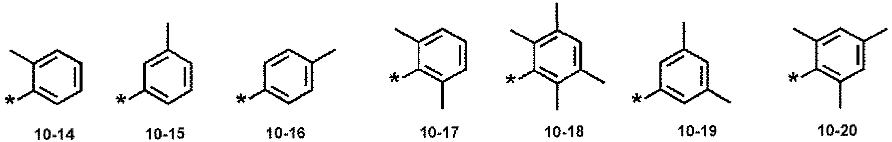 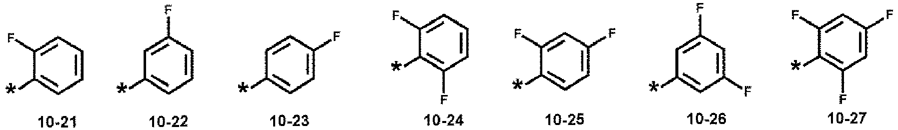 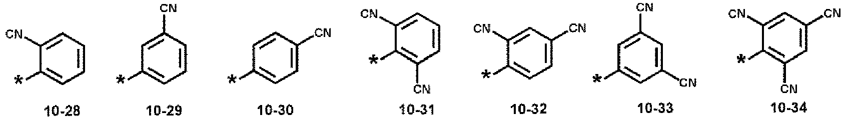 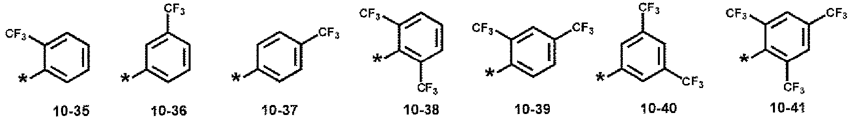 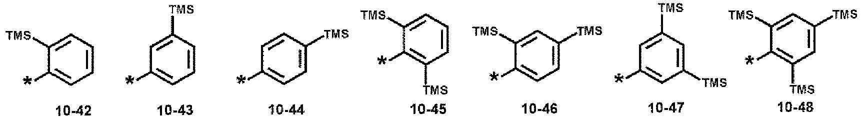 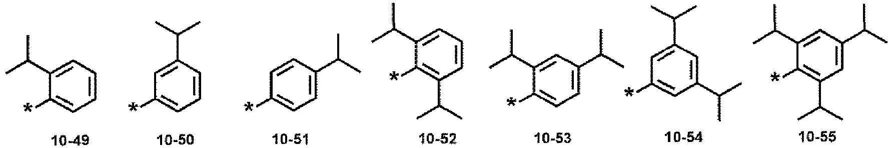 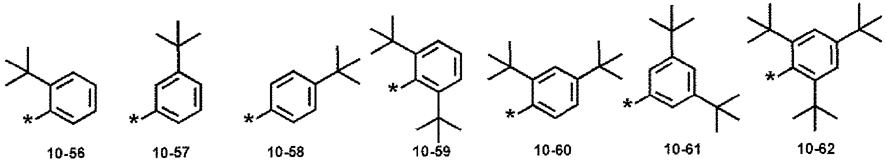 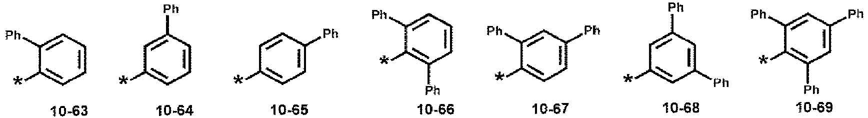 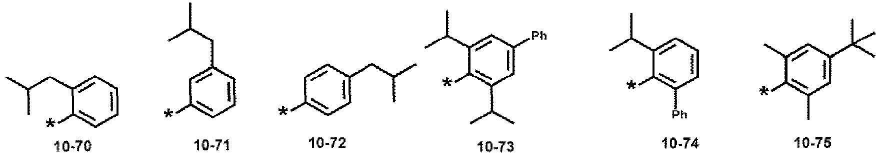 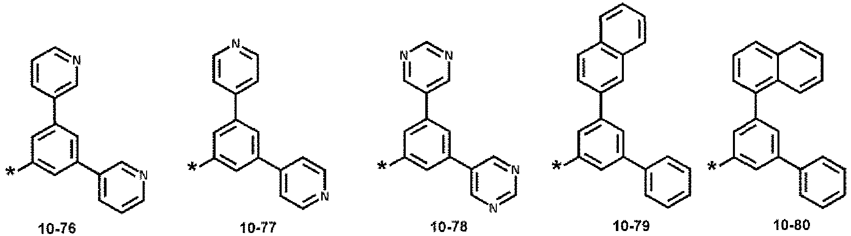 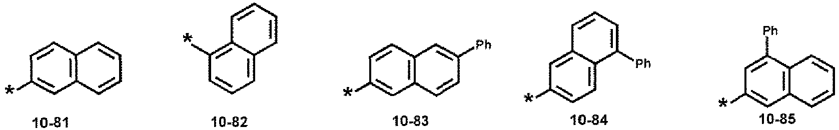 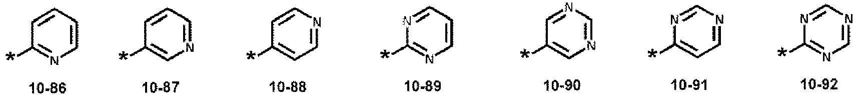 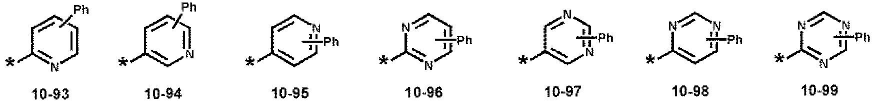 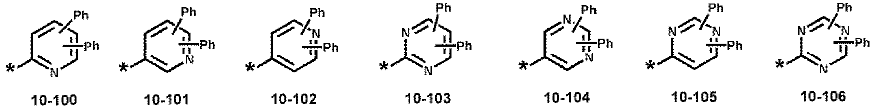 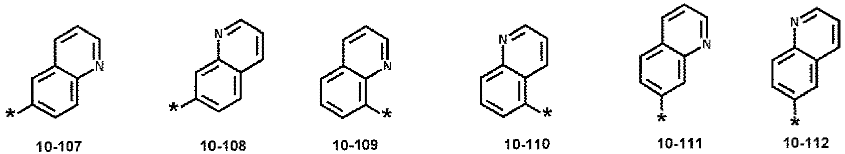 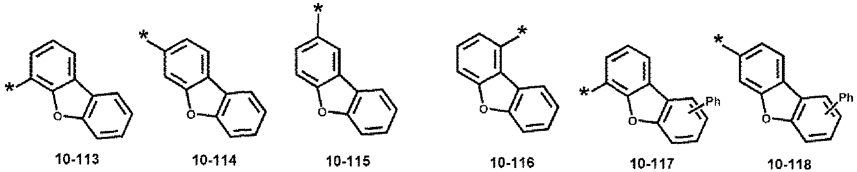 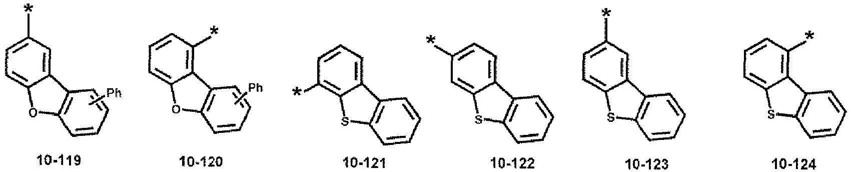 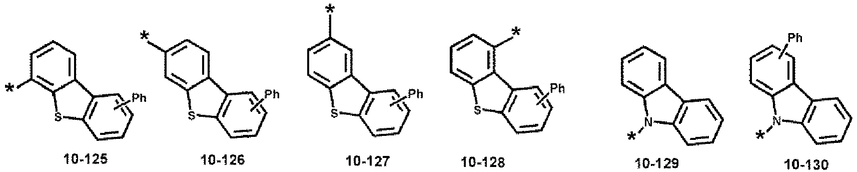 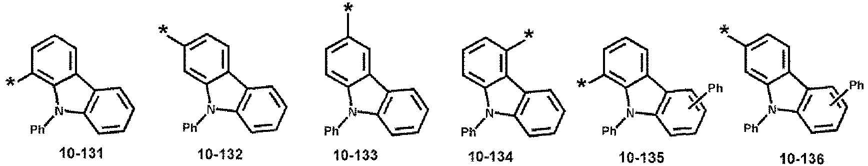 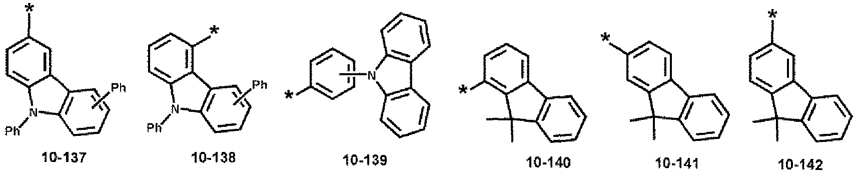 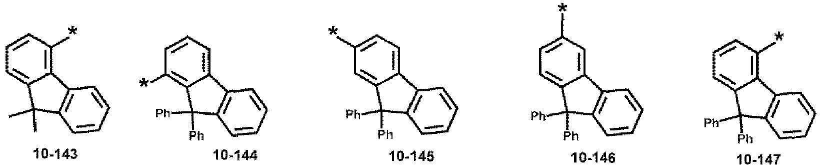 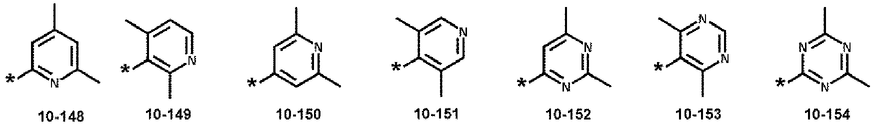 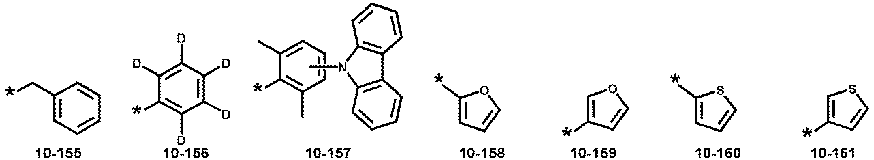 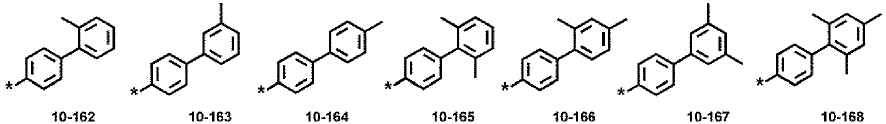 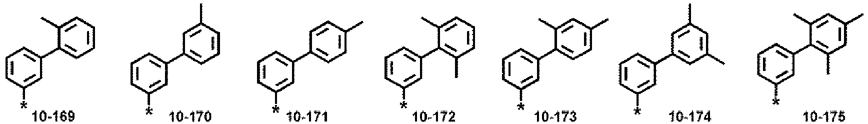 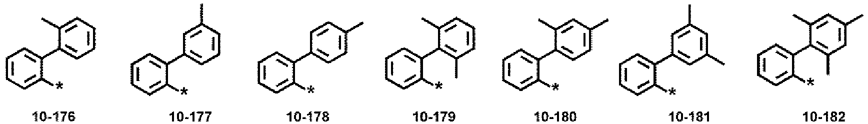 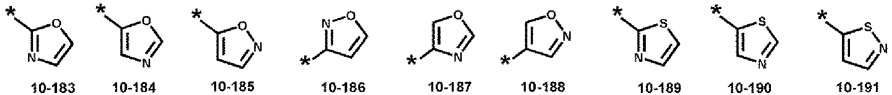 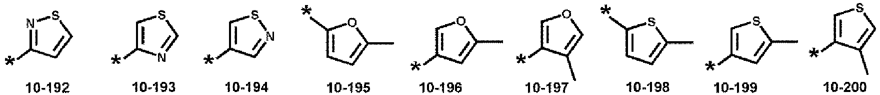 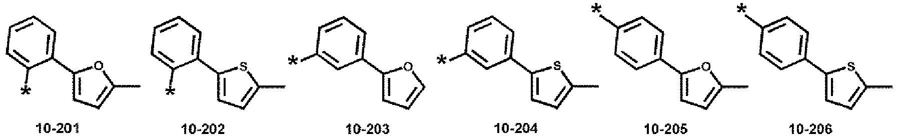 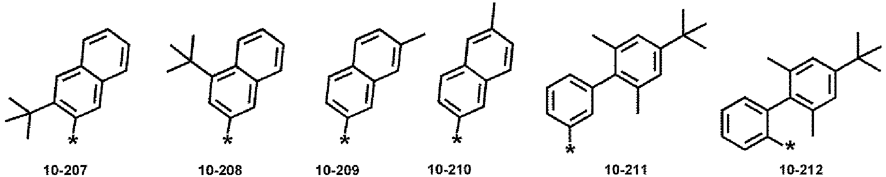 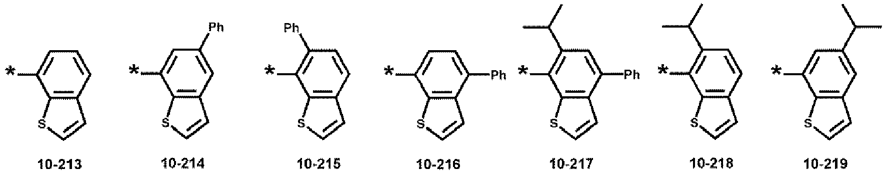 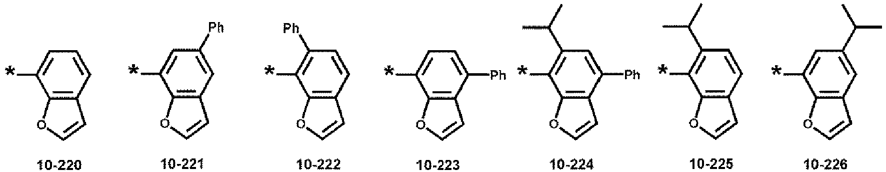 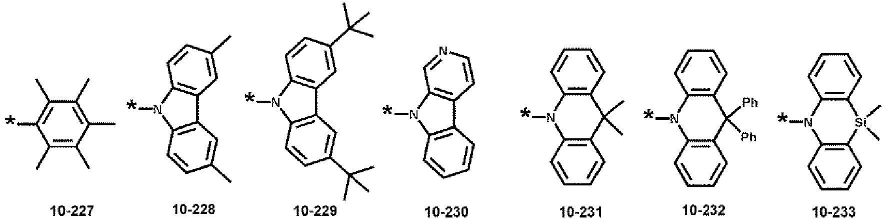 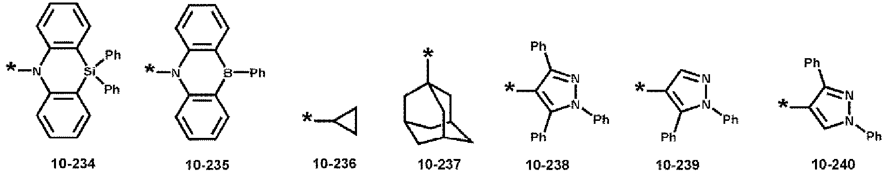 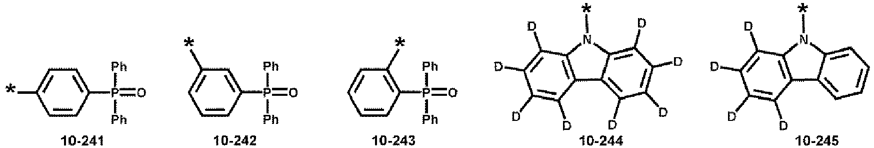 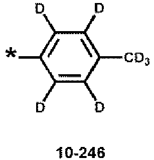
wherein, in Formulae 9-1 to 9-19 and 10-1 to 10-246, * indicates a binding site to a neighboring atom, "Ph" represents a phenyl group, and "TMS" represents a trimethylsilyl group.

### Examples of compounds

In one or more embodiments, the organometallic compound represented by Formula 1 may be one selected from among Compounds BD1 to BD64:

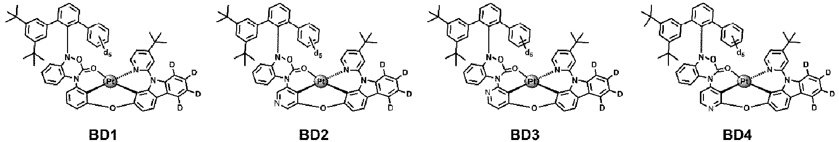

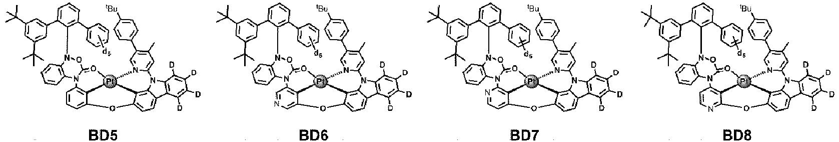

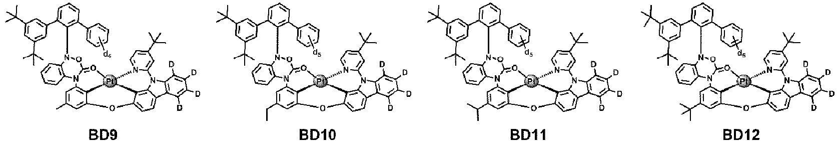

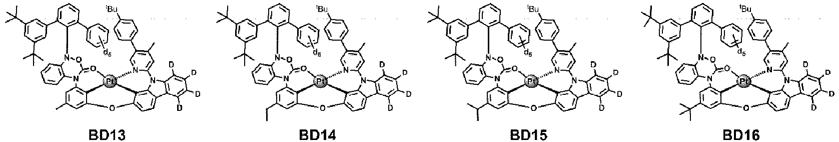

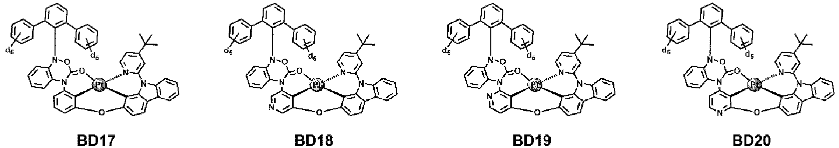

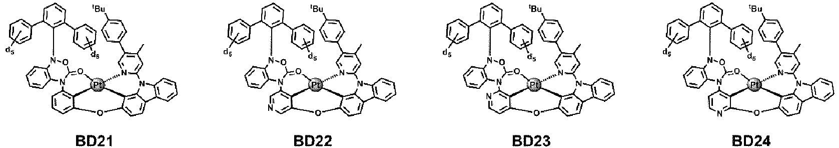

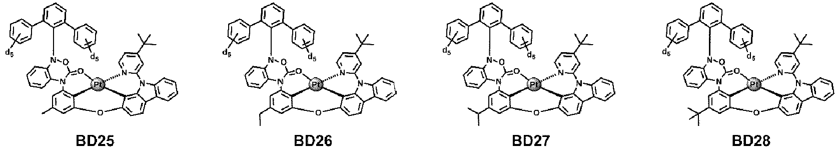

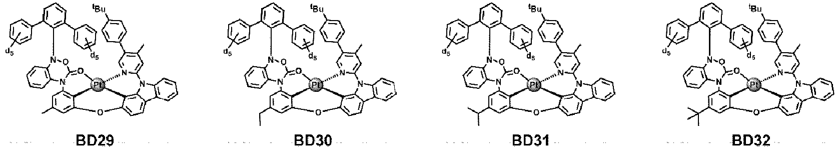

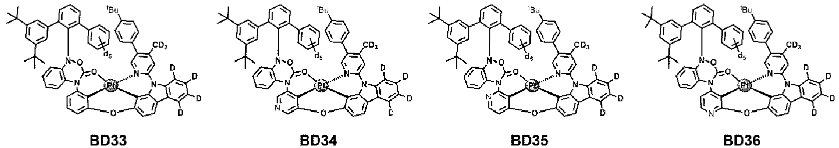

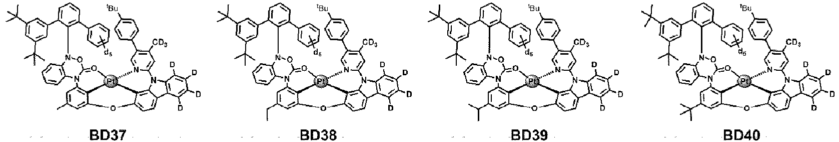

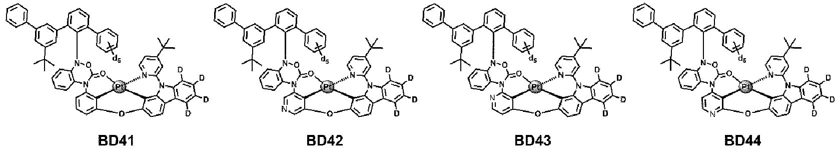

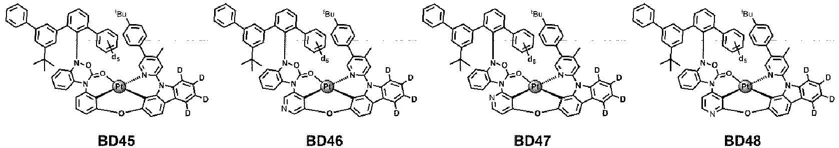

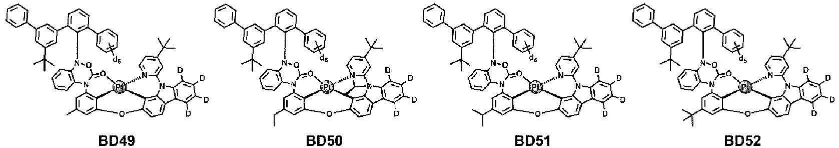

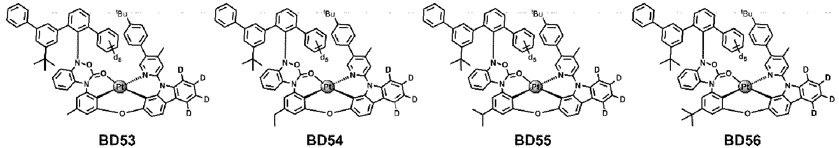

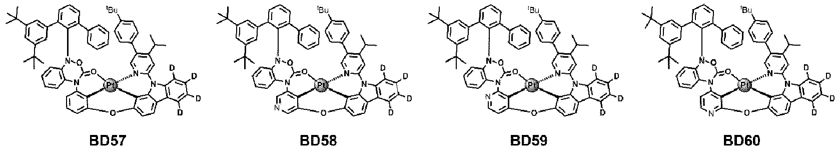

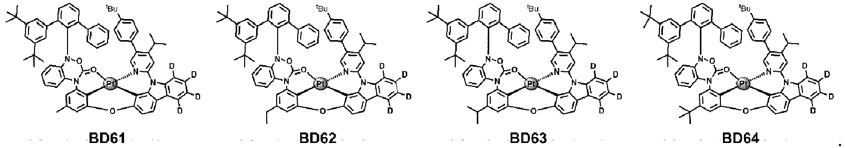

In one or more embodiments, the second compound may be one selected from among Compounds ETH1 to ETH84:

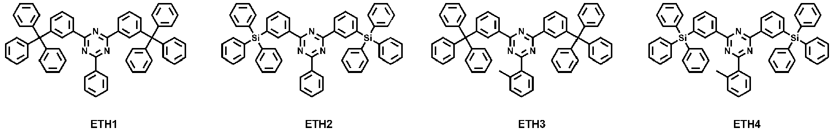

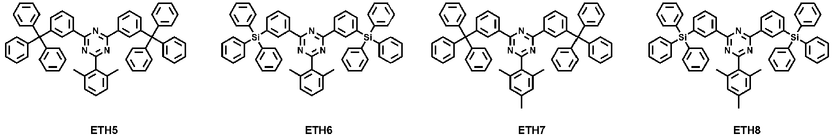

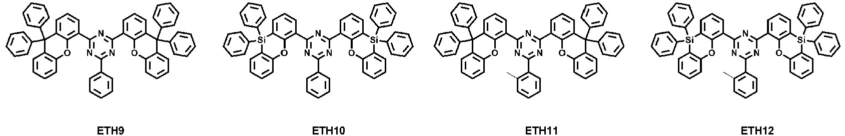

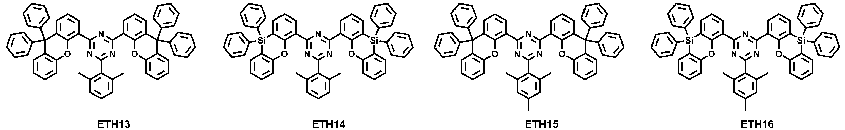

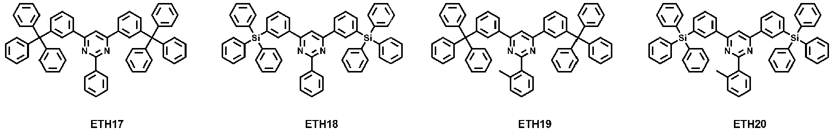

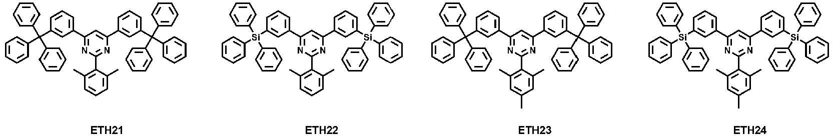

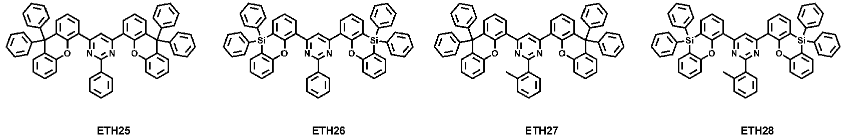

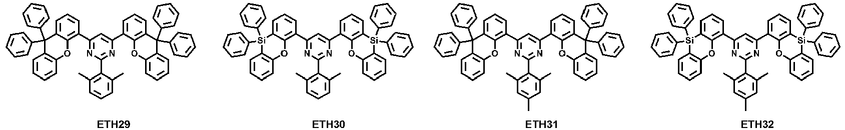

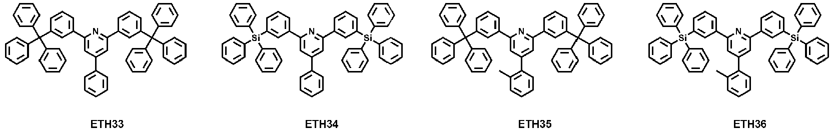

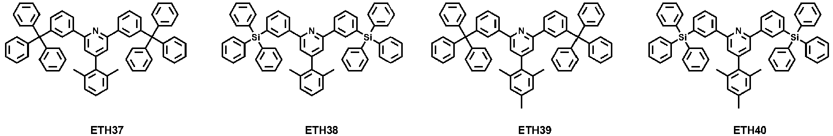

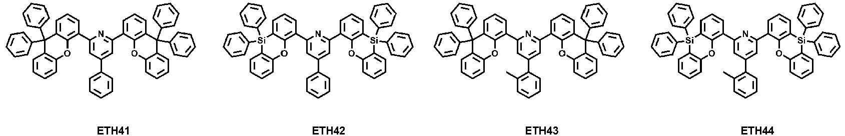

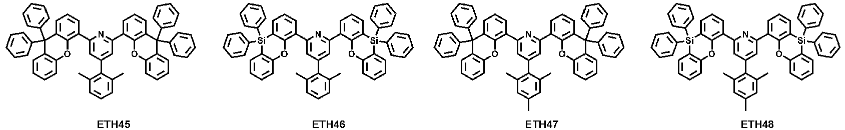

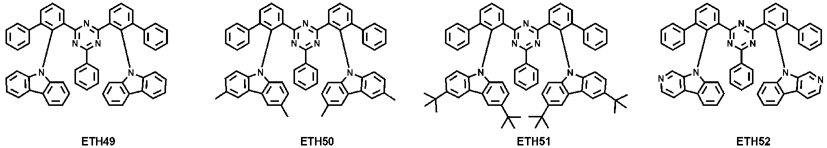

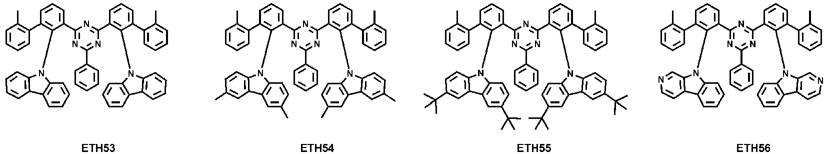

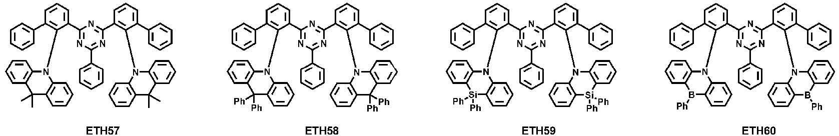

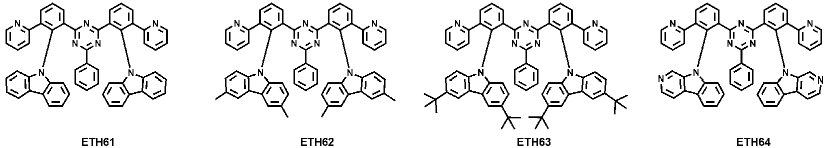

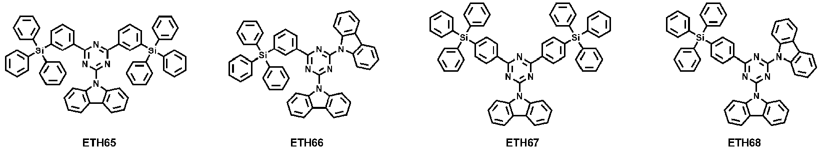

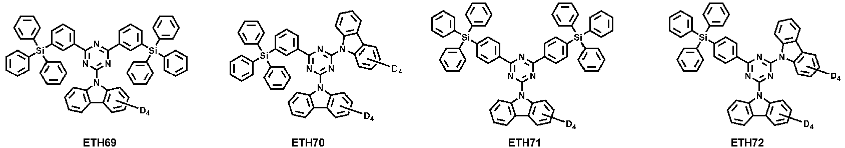

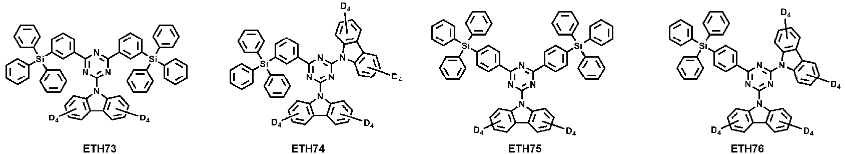

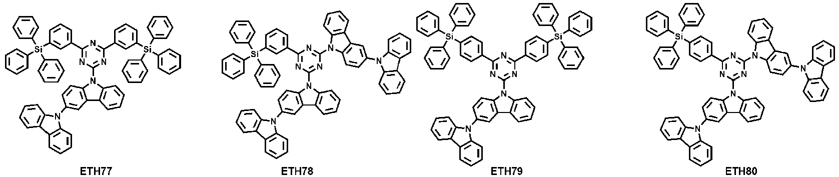

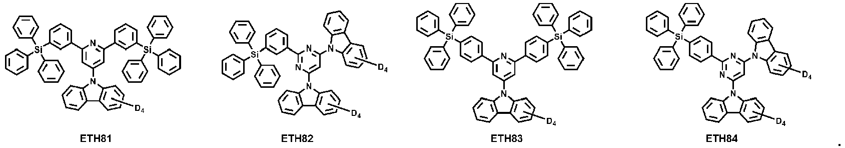

In one or more embodiments, the third compound may be one selected from among Compounds HTH1 to HTH52:

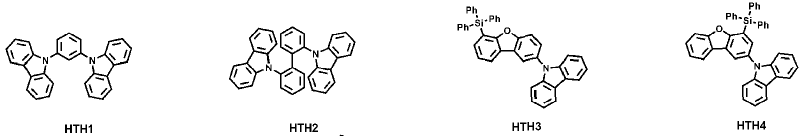

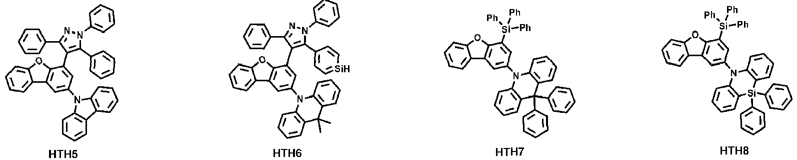

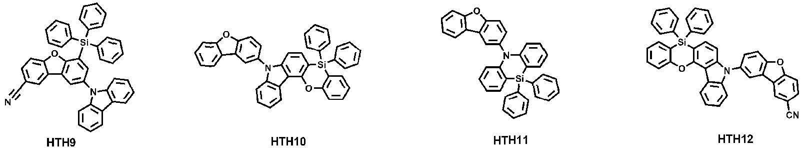

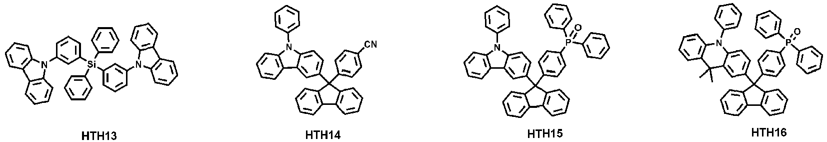

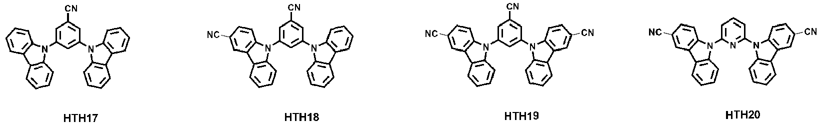

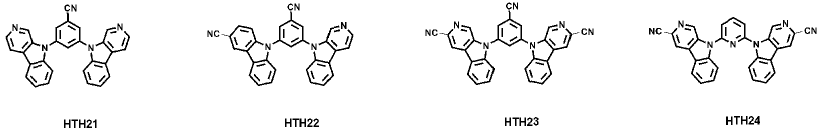

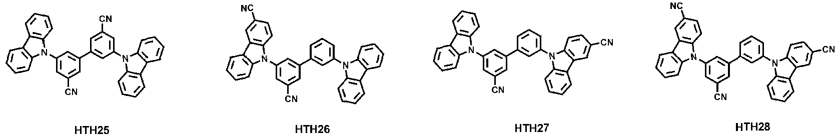

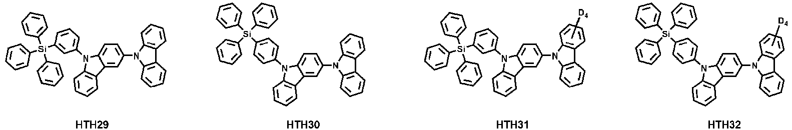

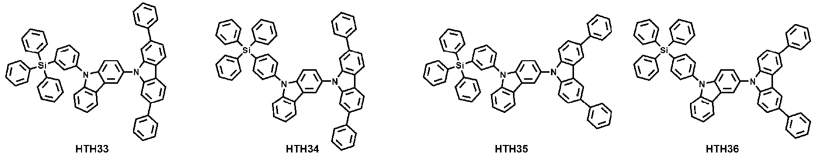

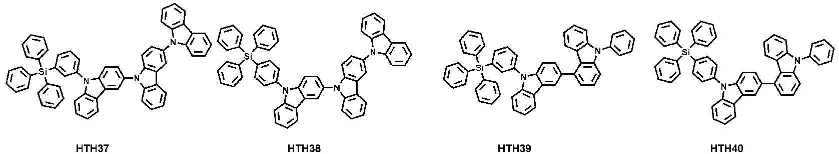

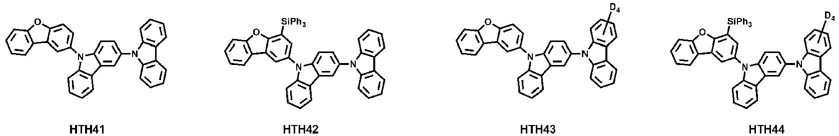

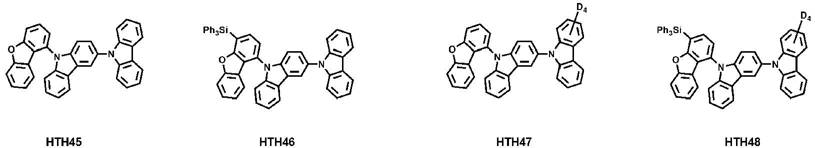

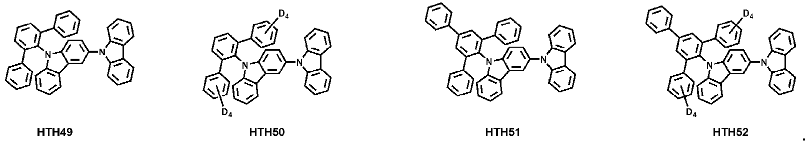

In one or more embodiments, the fourth compound may be one selected from among DFD1 to DFD29:

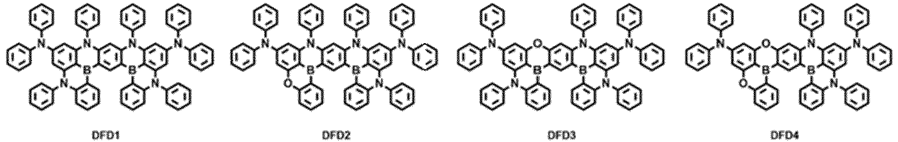

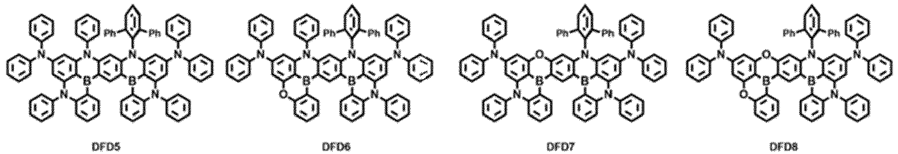

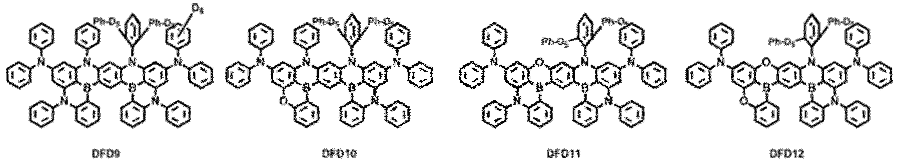

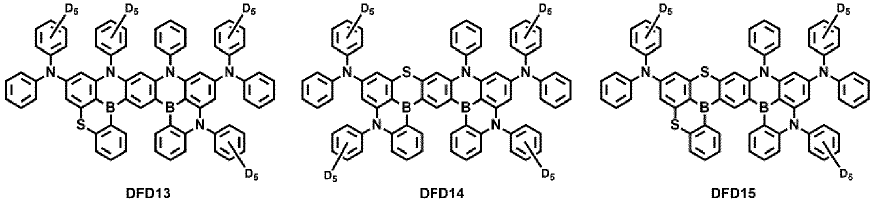

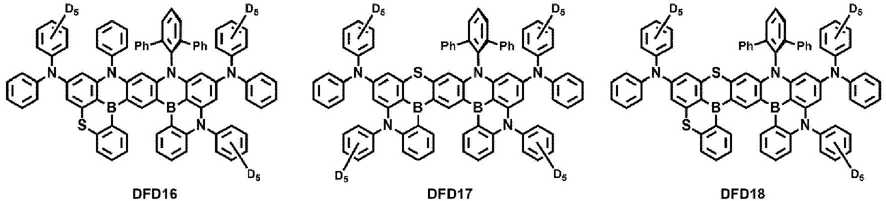

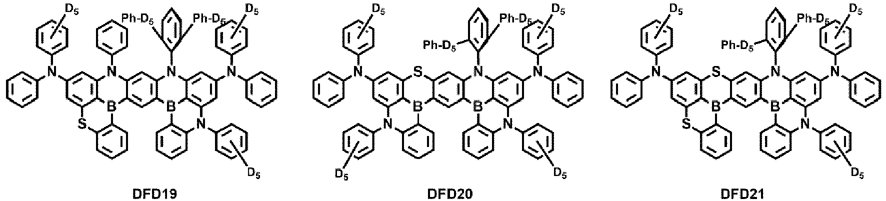

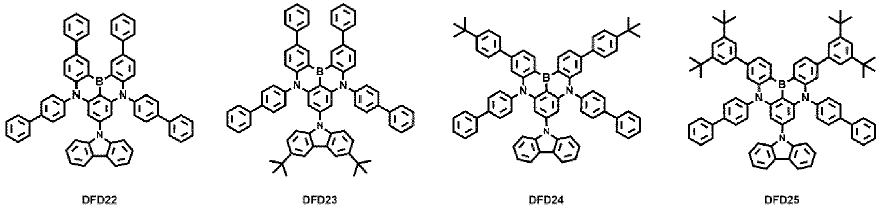

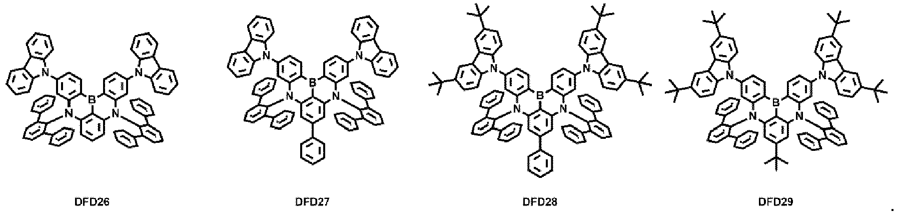

In the compounds described, Ph represents a phenyl group, D₅ represents substitution with five deuterium, and D₄ represents substitution with four deuterium. In one or more embodiments, a group represented by 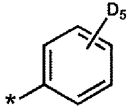 may be identical to a group represented by

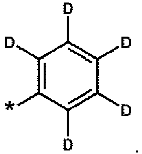

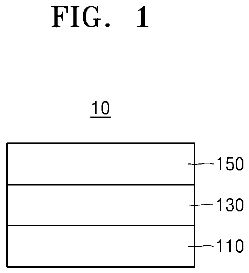

### Description of FIG. 1

FIG. 1 is a schematic cross-sectional view of a light-emitting device 10 according to one or more embodiments. The light-emitting device 10 includes a first electrode 110, an interlayer 130, and a second electrode 150.

Hereinafter, a structure of the light-emitting device 10 according to one or more embodiments and a method of manufacturing the light-emitting device 10 are described with reference to FIG. 1.

### First electrode 110

In FIG. 1, a substrate may be additionally arranged under the first electrode 110 or the second electrode 150. As the substrate, a glass substrate or a plastic substrate may be utilized. In one or more embodiments, the substrate may be a flexible substrate and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high work-function material that facilitates injection of holes. The "term "high work-function material" as utilized herein refers to a substance (e.g., a metal or metal alloy) that requires a relatively high amount of energy to emit electrons from its surface.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combination thereof.

The first electrode 110 may have a single-layer structure consisting of a single layer or a multilayer structure including a plurality of layers. In one or more embodiments, the first electrode 110 may have a three-layer structure of ITO/Ag/ITO. Interlayer 130

The interlayer 130 is arranged on the first electrode 110. The interlayer 130 includes the emission layer.

The interlayer 130 may further include a hole transport region arranged between the first electrode 110 and the emission layer, and an electron transport region arranged between the emission layer and the second electrode 150.

The interlayer 130 may further include, in addition to one or more suitable organic materials, a metal-containing compound such as an organometallic compound, an inorganic material such as quantum dots, and/or the like.

In one or more embodiments, the interlayer 130 may include i) two or more emitting units sequentially stacked between the first electrode 110 and the second electrode 150, and ii) a charge generation layer located between two neighboring emitting units. When the interlayer 130 includes the two or more emitting units and the charge generation layer, the light-emitting device 10 may be a tandem light-emitting device.

### Hole transport region in interlayer 130

The hole transport region may have: i) a single-layer structure including (e.g., consisting of) a single layer including (e.g., consisting of) a single material, ii) a single-layer structure including (e.g., consisting of) a single layer including (e.g., consisting of) a plurality of materials that are different from each other, or iii) a multilayer structure including a plurality of layers including a plurality of materials that are different from each other.

The hole transport region may include a hole injection layer, a hole transport layer, an emission auxiliary layer, an electron blocking layer, or any combination thereof.

In one or more embodiments, the hole transport region may have a multilayer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110.

The hole transport region may include a compound represented by Formula 201, a compound represented by Formula 202, or any combination thereof: 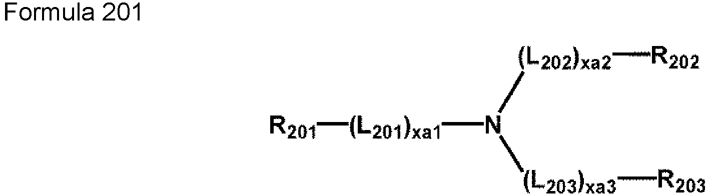 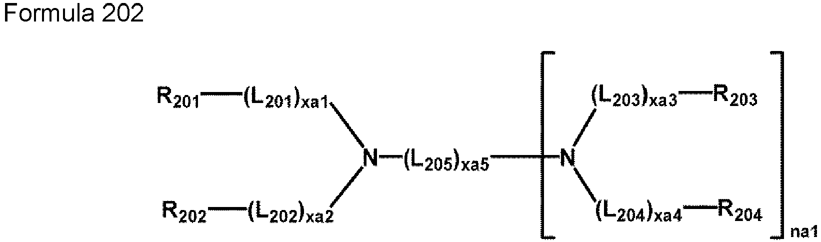 wherein, in Formulae 201 and 202,
L₂₀₁ to L₂₀₄ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R₁₀ₐ,
L₂₀₅ may be *-O-*', *-S-*', *-N(Q₂₀₁)-*', a C₁-C₂₀ (*e.g*. C₁-C₁₀) alkylene group that is unsubstituted or substituted with at least one R₁₀ₐ, a C₂-C₂₀ (*e.g*. C₂-C₁₀) alkenylene group that is unsubstituted or substituted with at least one R₁₀ₐ, a C₃-C₆₀ (*e.g*. C₃-C₃₀) carbocyclic group that is unsubstituted or substituted with at least one R₁₀ₐ, or a C₁-C₆₀ (*e.g*. C₁-C₂₀) heterocyclic group that is unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R₁₀ₐ,
R₂₀₁ and R₂₀₂ may be optionally linked together via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ (*e.g*. C₈-C₃₀) polycyclic group (for example, a carbazole group and/or the like) that is unsubstituted or substituted with at least one R₁₀ₐ (for example, see Compound HT16),
R₂₀₃ and R₂₀₄ may be optionally linked together via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ (*e.g*. C₈-C₃₀) polycyclic group that is unsubstituted or substituted with at least one R₁₀ₐ, and
na1 may be an integer from 1 to 4.

In one or more embodiments, each of Formulae 201 and 202 may include at least one selected from among groups represented by Formulae CY201 to CY217: 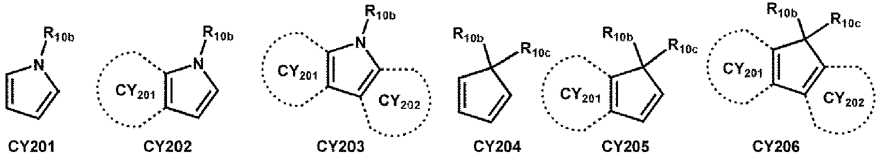 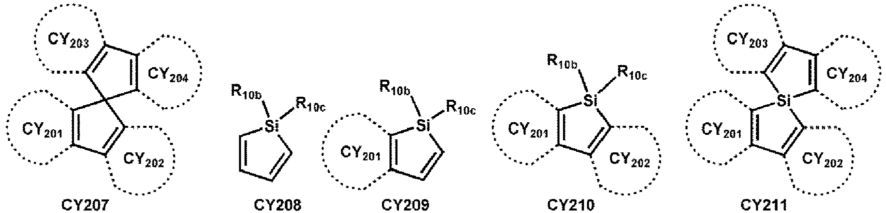 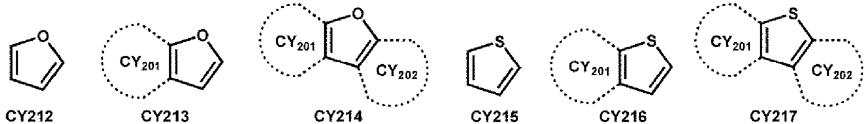 wherein, in Formulae CY201 to CY217, R_{10b} and R_{10c} are each as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) the groups represented by Formulae CY201 to CY203.

In one or more embodiments, each of Formulae 201 and 202 may not include (e.g., may exclude) the groups represented by Formulae CY201 to CY203 and may include at least one of the groups represented by Formulae CY204 to CY217.

In one or more embodiments, each of Formulae 201 and 202 may not include (e.g., may exclude) the groups represented by Formulae CY201 to CY217.

In one or more embodiments, the hole transport region may include: at least one selected from among Compounds HT1 to HT46; m-MTDATA; TDATA; 2-TNATA; NPB(NPD); β-NPB; TPD; spiro-TPD; spiro-NPB; methylated NPB; TAPC; HMTPD; 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); and/or any combination thereof:

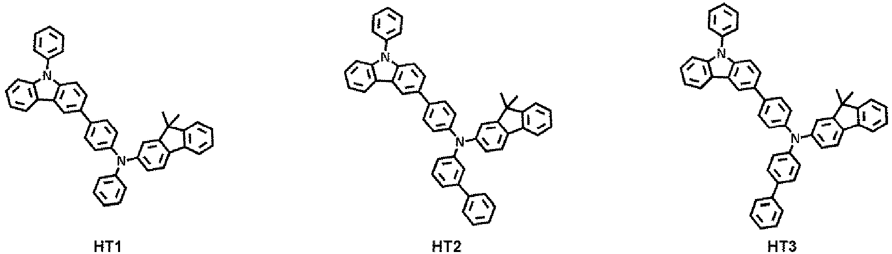

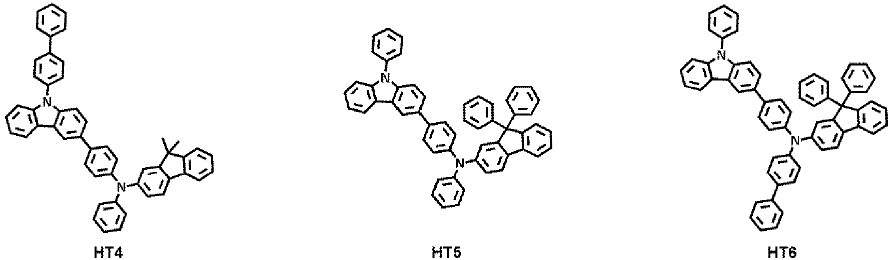

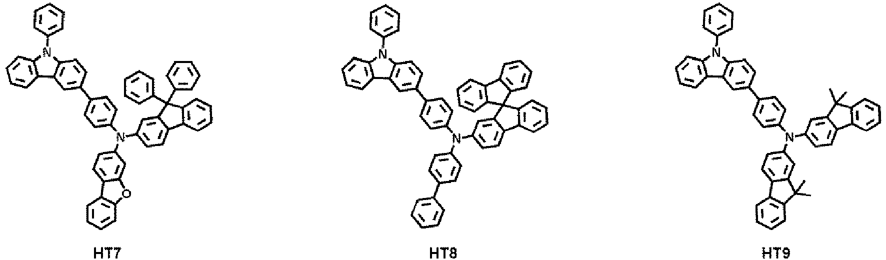

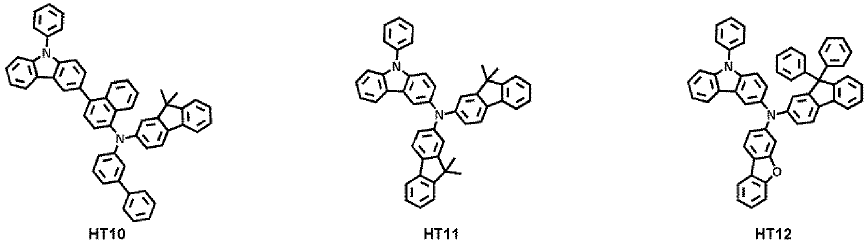

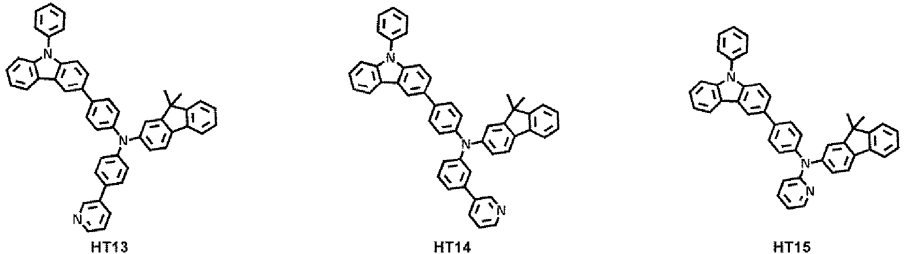

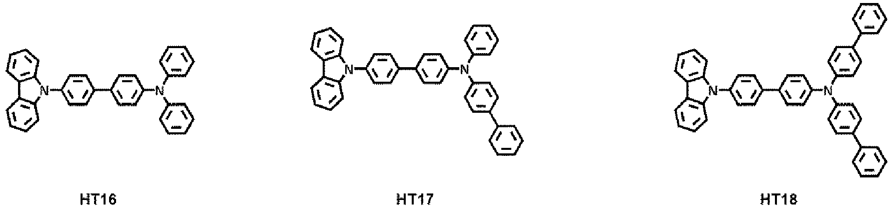

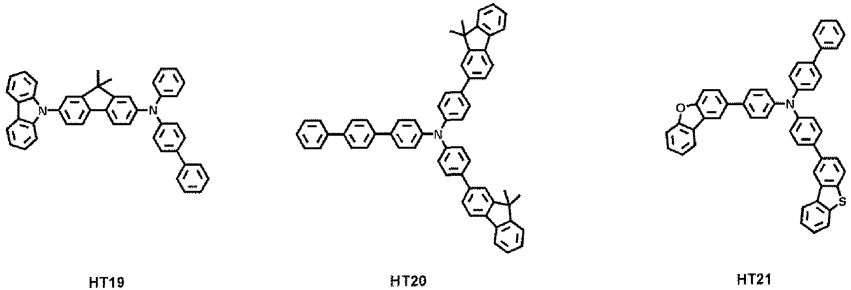

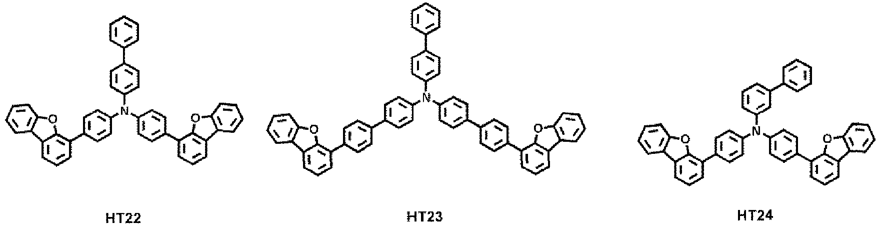

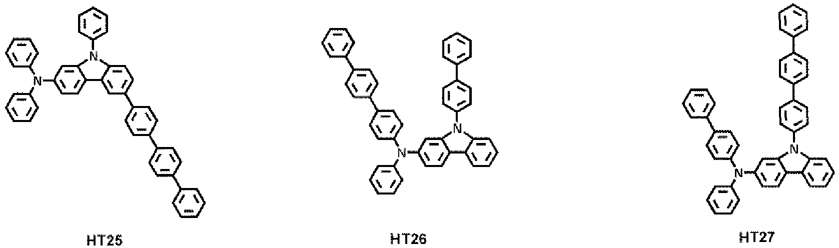

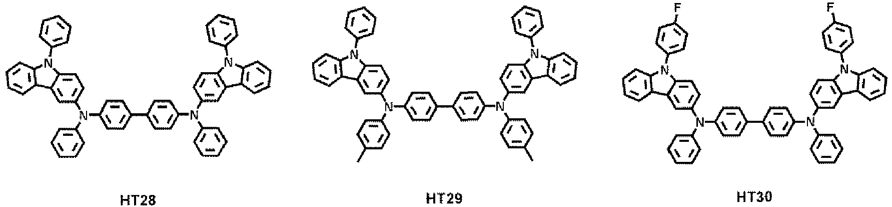

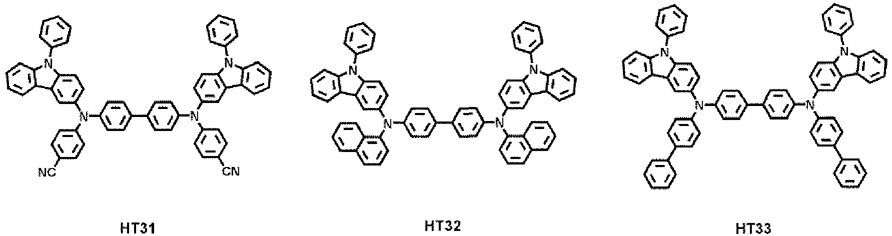

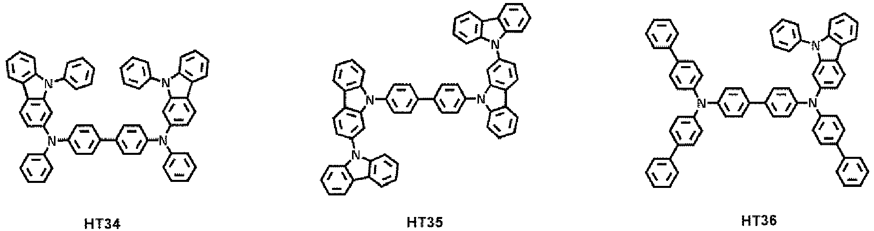

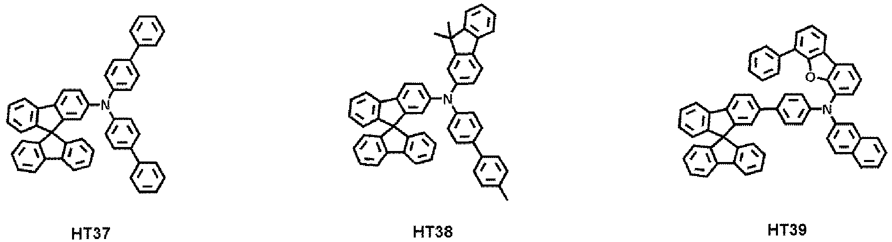

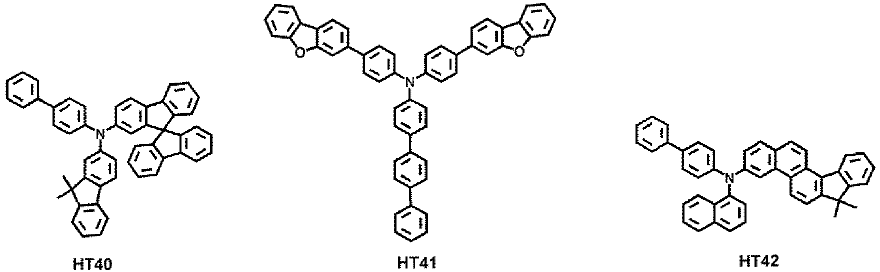

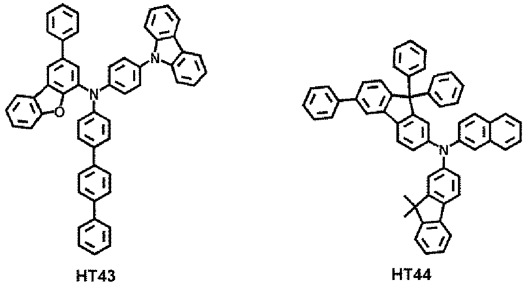

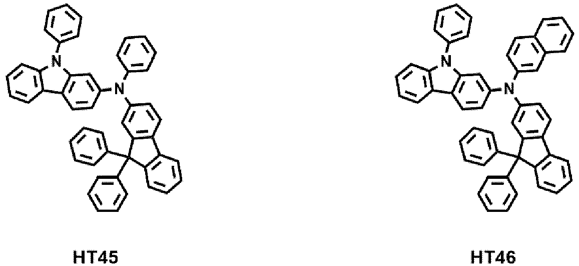

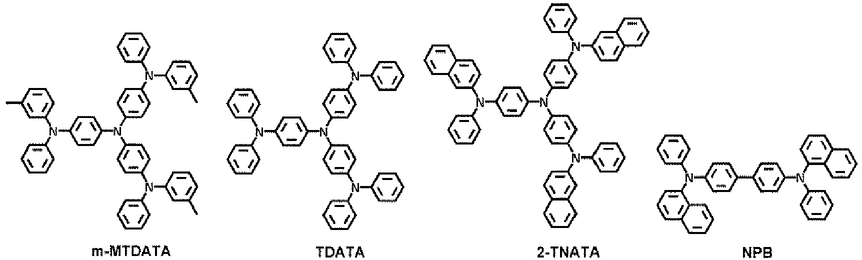

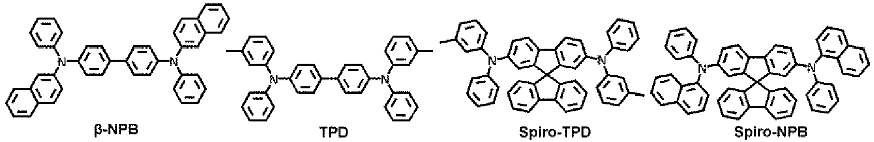

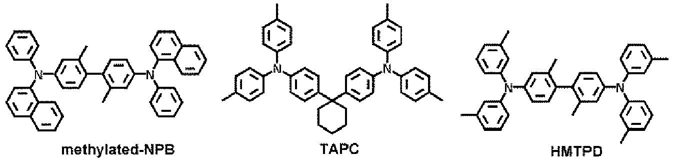

The thickness of the hole transport region may be about 50 angstrom (Å) to about 10,000 Å, for example, about 100 Å to about 4,000 Å. When the hole transport region includes a hole injection layer, a hole transport layer, or any combination thereof, the thickness of the hole injection layer may be about 100 Å to about 9,000 Å, for example, about 100 Å to about 1,000 Å, and the thickness of the hole transport layer may be about 50 Å to about 2,000 Å, for example, about 100 Å to about 1,500 Å. When the thicknesses of the hole transport region, the hole injection layer, and the hole transport layer are within the ranges described, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be included in the hole transport region may be included in the emission auxiliary layer and the electron blocking layer.

### p-dopant

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

In one or more embodiments, the LUMO energy of the p-dopant may be less than or equal to -3.5 eV.

In one or more embodiments, the p-dopant may include a quinone derivative, a cyano group-containing compound, a compound including an element EL1 and an element EL2, or any combination thereof.

Examples of the quinone derivative may include TCNQ and F4-TCNQ.

Examples of the cyano group-containing compound may include HAT-CN and a compound represented by Formula 221.

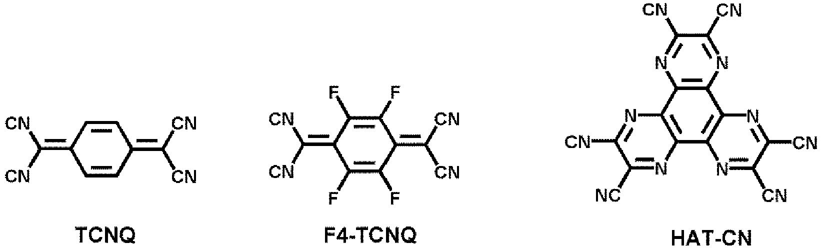

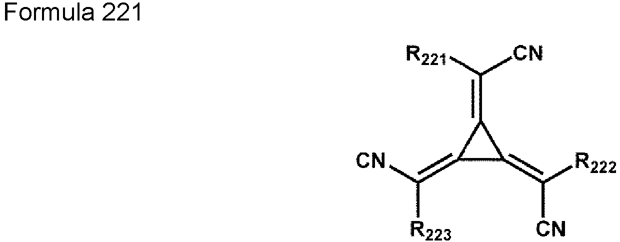

In Formula 221,
R₂₂₁ to R₂₂₃ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R₁₀ₐ, and
at least one selected from among R₂₂₁ to R₂₂₃ may each independently be a C₃-C₆₀ (*e.g*. C₃-C₃₀) carbocyclic group or a C₁-C₆₀ (*e.g*. C₁-C₂₀) heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound including the element EL1 and the element EL2, the element EL1 may be a metal, a metalloid, or a combination thereof, and the element EL2 may be a non-metal, a metalloid, or a combination thereof.

Examples of the metal may include an alkali metal (for example, lithium (Li), sodium (Na), potassium (K), rubidium (Rb), cesium (Cs), and/or the like); an alkaline earth metal (for example, beryllium (Be), magnesium (Mg), calcium (Ca), strontium (Sr), barium (Ba), and/or the like); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (for example, zinc (Zn), indium (In), tin (Sn), and/or the like); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid may include silicon (Si), antimony (Sb), and tellurium (Te).

Examples of the non-metal may include oxygen (O) and halogen (for example, F, Cl, Br, I, and/or the like).

Examples of the compound including the element EL1 and the element EL2 may include a metal oxide, a metal halide (for example, a metal fluoride, a metal chloride, a metal bromide, a metal iodide, and/or the like), a metalloid halide (for example, a metalloid fluoride, a metalloid chloride, a metalloid bromide, a metalloid iodide, and/or the like), a metal telluride, or any combination thereof.

Examples of the metal oxide may include a tungsten oxide (for example, WO, W₂O₃, WO₂, WO₃, W₂O₅, and/or the like), a vanadium oxide (for example, VO, V₂O₃, VO₂, V₂O₅, and/or the like), a molybdenum oxide (MoO, Mo₂O₃, MoO₂, MoO₃, Mo₂O₅, and/or the like), and a rhenium oxide (for example, ReO₃, and/or the like).

Examples of the metal halide may include an alkali metal halide, an alkaline earth metal halide, a transition metal halide, a post-transition metal halide, and a lanthanide metal halide.

Examples of the alkali metal halide may include LiF, NaF, KF, RbF, CsF, LiCl, NaCl, KCI, RbCl, CsCl, LiBr, NaBr, KBr, RbBr, CsBr, Lil, Nal, KI, Rbl, and CsI.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of the transition metal halide may include a titanium halide (for example, TiF₄, TiCl₄, TiBr₄, TiI₄, and/or the like), a zirconium halide (for example, ZrF₄, ZrCl₄, ZrBr₄, ZrI₄, and/or the like), a hafnium halide (for example, HfF₄, HfCl₄, HfBr₄, HfI₄, and/or the like), a vanadium halide (for example, VF₃, VCl₃, VBr₃, VI₃, and/or the like), a niobium halide (for example, NbF₃, NbCl₃, NbBr₃, NbI₃, and/or the like), a tantalum halide (for example, TaF₃, TaCl₃, TaBr₃, TaI₃, and/or the like), a chromium halide (for example, CrF₃, CrCl₃, CrBr₃, CrI₃, and/or the like), a molybdenum halide (for example, MoF₃, MoCl₃, MoBr₃, MoI₃, and/or the like), a tungsten halide (for example, WF₃, WCl₃, WBr₃, WI₃, and/or the like), a manganese halide (for example, MnF₂, MnCl₂, MnBr₂, MnI₂, and/or the like), a technetium halide (for example, TcF₂, TcCl₂, TcBr₂, TcI₂, and/or the like), a rhenium halide (for example, ReF₂, ReCl₂, ReBr₂, ReI₂, and/or the like), an iron halide (for example, FeF₂, FeCl₂, FeBr₂, FeI₂, and/or the like), a ruthenium halide (for example, RuF₂, RuCl₂, RuBr₂, RuI₂, and/or the like), an osmium halide (for example, OsF₂, OsCl₂, OsBr₂, OsI₂, and/or the like), a cobalt halide (for example, CoF₂, CoCl₂, CoBr₂, CoI₂, and/or the like), a rhodium halide (for example, RhF₂, RhCl₂, RhBr₂, RhI₂, and/or the like), an iridium halide (for example, IrF₂, IrCl₂, IrBr₂, IrI₂, and/or the like), a nickel halide (for example, NiF₂, NiCl₂, NiBr₂, NiI₂, and/or the like), a palladium halide (for example, PdF₂, PdCl₂, PdBr₂, PdI₂, and/or the like), a platinum halide (for example, PtF₂, PtCl₂, PtBr₂, PtI₂, and/or the like), a copper halide (for example, CuF, CuCl, CuBr, Cul, and/or the like), a silver halide (for example, AgF, AgCl, AgBr, AgI, and/or the like), and a gold halide (for example, AuF, AuCl, AuBr, Aul, and/or the like).

Examples of the post-transition metal halide may include a zinc halide (for example, ZnF₂, ZnCl₂, ZnBr₂, ZnI₂, and/or the like), an indium halide (for example, InI₃, and/or the like), and a tin halide (for example, SnI₂, and/or the like).

Examples of the lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, and SmI₃.

Examples of the metalloid halide may include an antimony halide (for example, SbCl₅, and/or the like).

Examples of the metal telluride may include an alkali metal telluride (for example, Li₂Te, Na₂Te, K₂Te, Rb₂Te, Cs₂Te, and/or the like), an alkaline earth metal telluride (for example, BeTe, MgTe, CaTe, SrTe, BaTe, and/or the like), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), a post-transition metal telluride (for example, ZnTe, and/or the like), and a lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

In one or more embodiments, the emission layer may include a host and a dopant (or emitter). In one or more embodiments, the emission layer may further include an auxiliary dopant that promotes energy transfer to a dopant (or emitter), in addition to the host and the dopant (or emitter). When the emission layer includes the dopant (or emitter) and the auxiliary dopant, the dopant (or emitter) and the auxiliary dopant are different from each other.

The organometallic compound represented by Formula 1 herein may serve as the dopant (or emitter), or may serve as the auxiliary dopant.

The amount (weight) of the dopant (or emitter) in the emission layer may be about 0.01 parts by weight to about 15 parts by weight based on 100 parts by weight of the host.

The emission layer may include the organometallic compound represented by Formula 1. The amount (weight) of the organometallic compound in the emission layer may be about 0.001 parts by weight to about 30 parts by weight, about 0.1 parts by weight to about 20 parts by weight, or about 0.1 parts by weight to about 15 parts by weight based on 100 parts by weight of the emission layer.

The thickness of the emission layer may be about 100 Å to about 1,000 Å, for example, about 200 Å to about 600 Å. When the thickness of the emission layer is within the range described above, excellent or suitable luminescence characteristics may be obtained without a substantial increase in driving voltage.

### Host

The host in the emission layer may include the second compound, the third compound, or any combination thereof.

In one or more embodiments, the host may include a compound represented by Formula 301.

Formula 301 [Ar₃₀₁]_{xb11}-[(L₃₀₁)_{xb1}-R₃₀₁]_{xb21}

In Formula 301,
Ar₃₀₁ and L₃₀₁ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ (*e.g*. C₁-C₂₀) alkyl group that is unsubstituted or substituted with at least one R₁₀ₐ, a C₂-C₆₀ (*e.g*. C₂-C₂₀) alkenyl group that is unsubstituted or substituted with at least one R₁₀ₐ, a C₂-C₆₀ (*e.g*. C₂-C₂₀) alkynyl group that is unsubstituted or substituted with at least one R₁₀ₐ, a C₁-C₆₀ (*e.g*. C₁-C₂₀) alkoxy group that is unsubstituted or substituted with at least one R₁₀ₐ, a C₃-C₆₀ (*e.g*. C₃-C₃₀) carbocyclic group that is unsubstituted or substituted with at least one R₁₀ₐ, a C₁-C₆₀ (*e.g*. C₁-C₂₀) heterocyclic group that is unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ are each as described in connection with Q₁ herein.

In one or more embodiments, when xb11 in Formula 301 is 2 or more, two or more of Ar₃₀₁ may be linked together via a single bond.

In one or more embodiments, the host may include a compound represented by Formula 301-1, a compound represented by Formula 301-2, or any combination thereof: 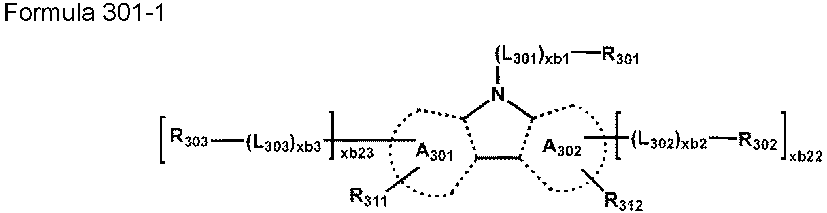 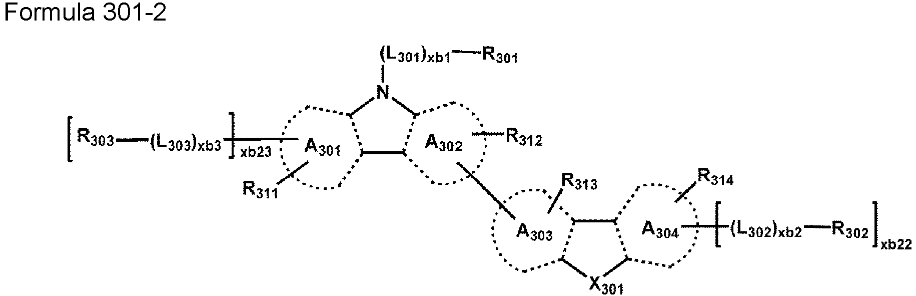 wherein, in Formulae 301-1 and 301-2,
ring A₃₀₁ to ring A₃₀₄ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R10a,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ are each as described herein,
L₃₀₂ to L₃₀₄ may each independently be as described in connection with L₃₀₁,
xb2 to xb4 may each independently be as described in connection with xb1, and
R₃₀₂ to R₃₀₅ and R₃₁₁ to R₃₁₄ are each as described in connection with R₃₀₁.

In one or more embodiments, the host may include an alkali earth metal complex, a post-transition metal complex, or any combination thereof. In one or more embodiments, the host may include a Be complex (for example, Compound H55), an Mg complex, a Zn complex, or any combination thereof.

In one or more embodiments, the host may include at least one selected from among Compounds H1 to H128, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and/or any combination thereof:

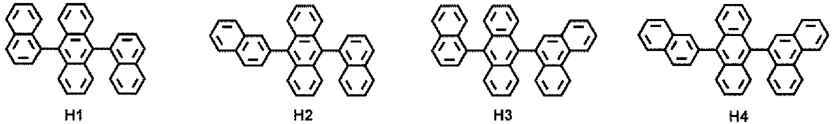

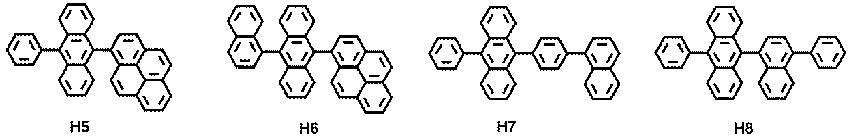

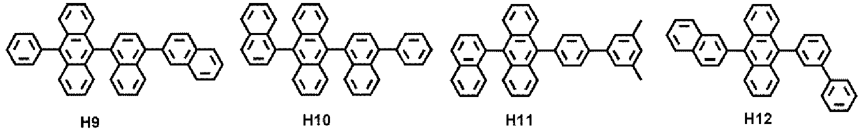

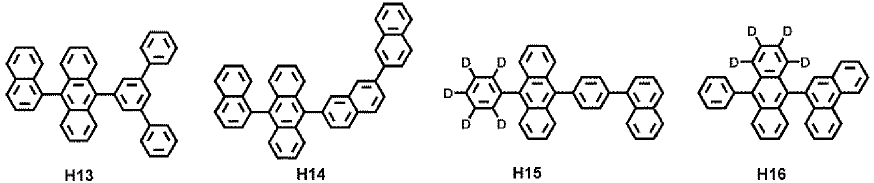

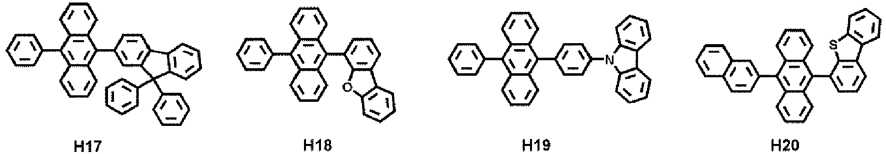

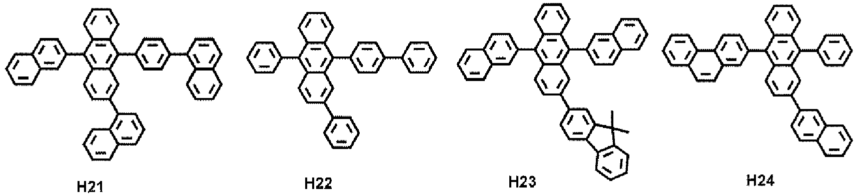

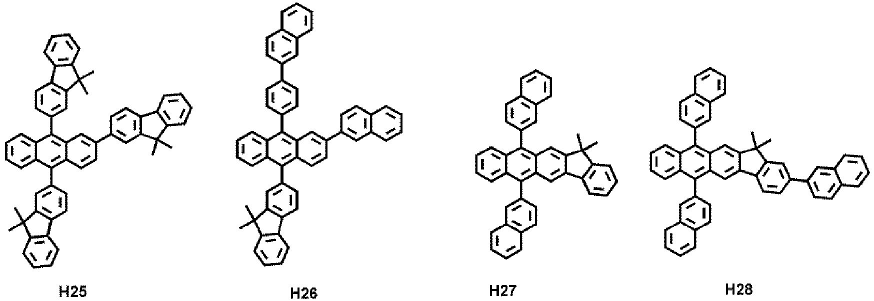

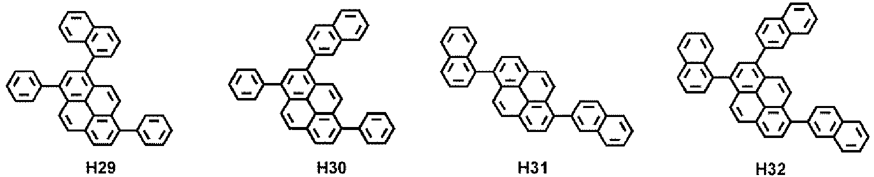

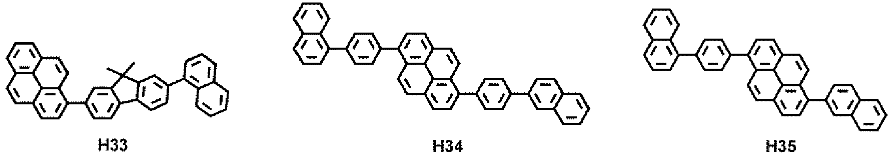

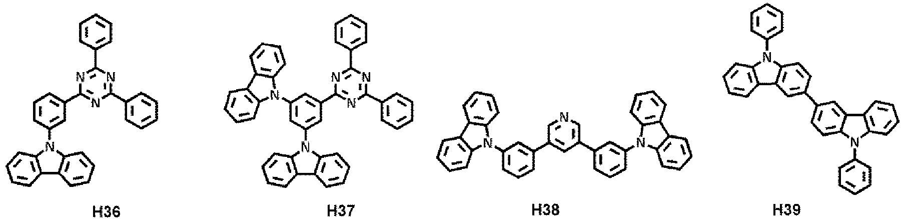

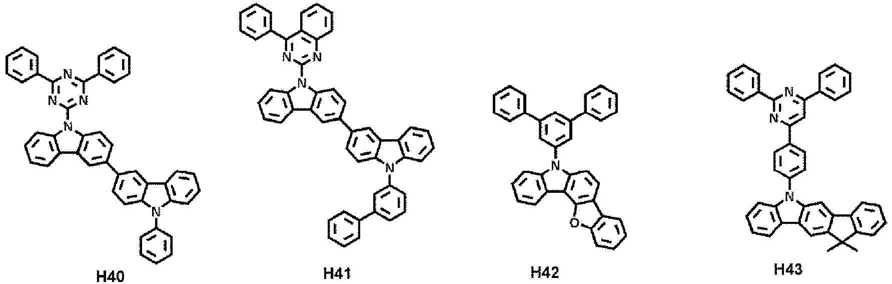

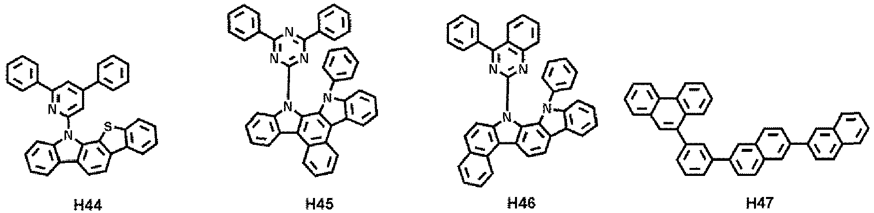

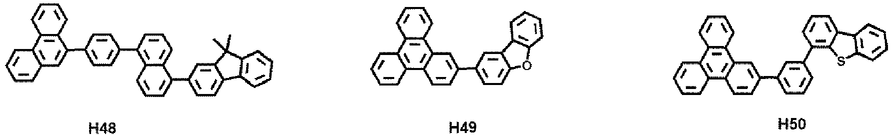

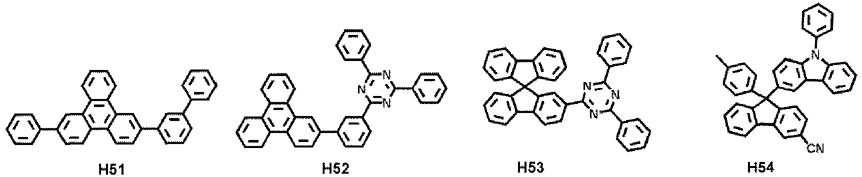

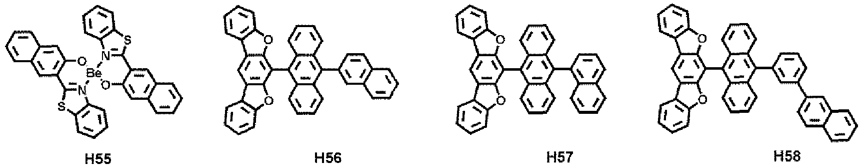

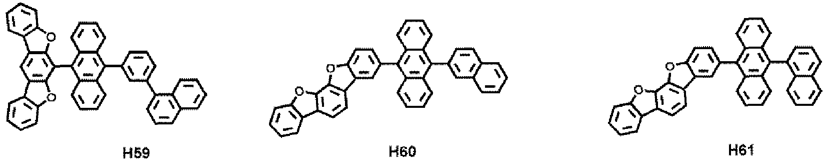

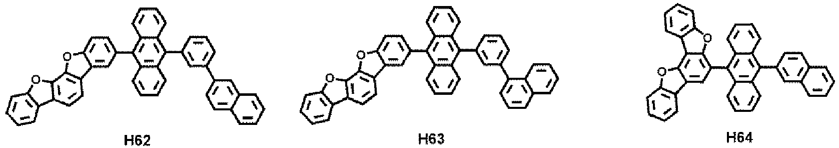

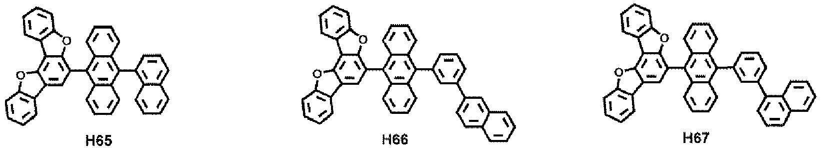

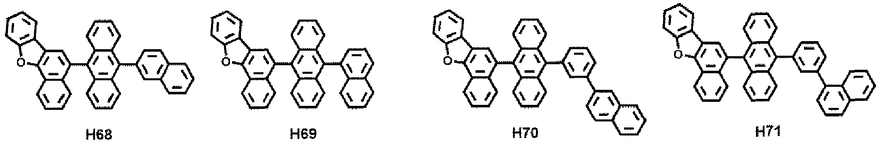

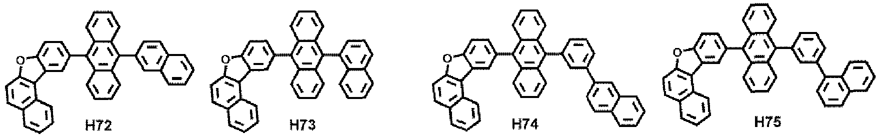

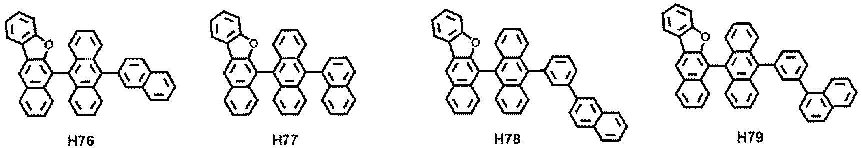

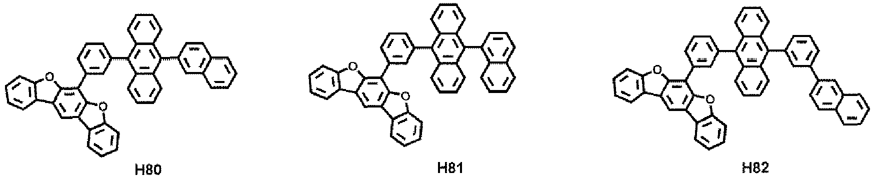

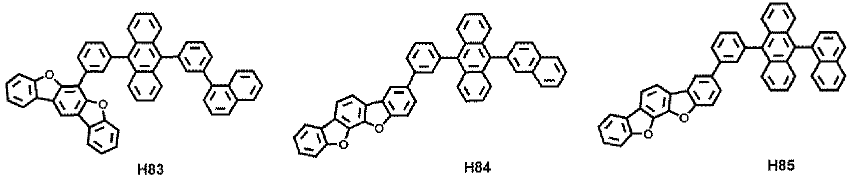

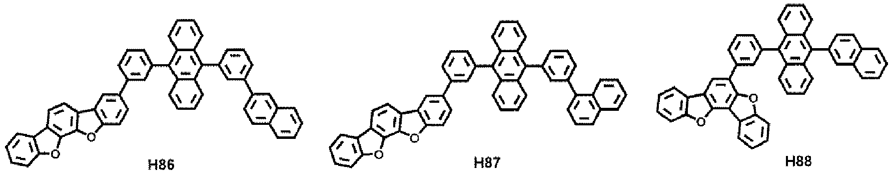

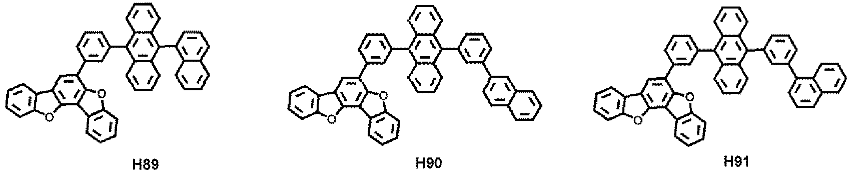

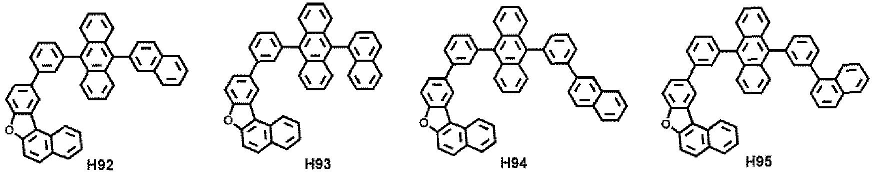

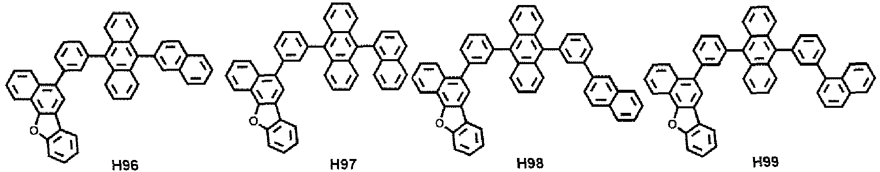

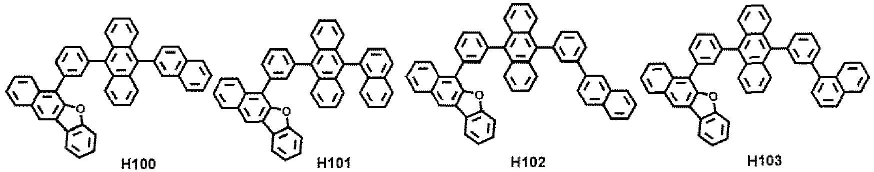

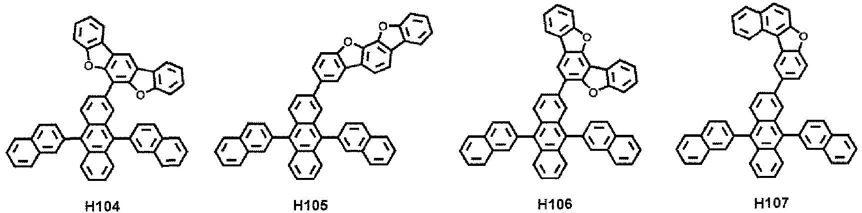

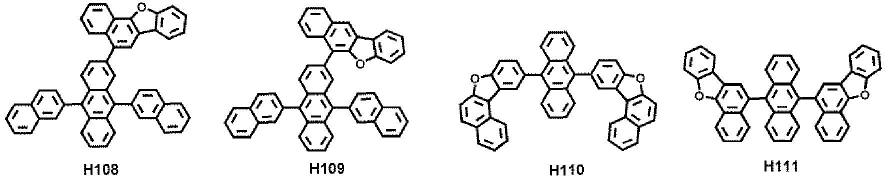

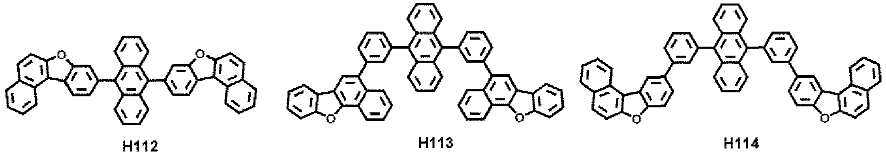

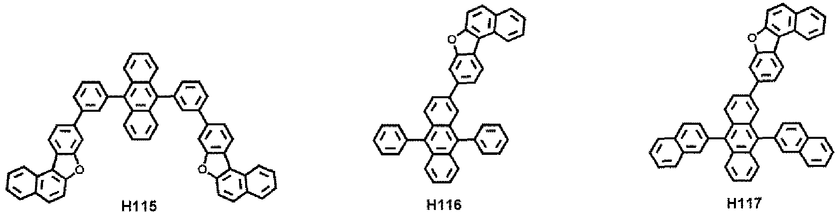

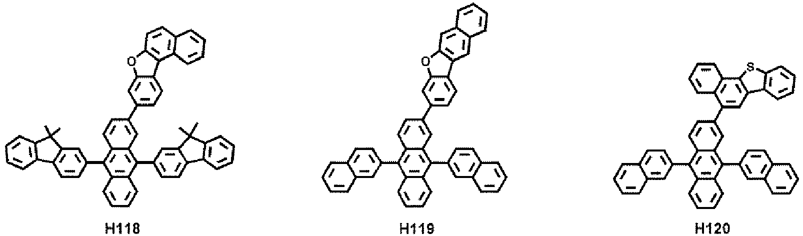

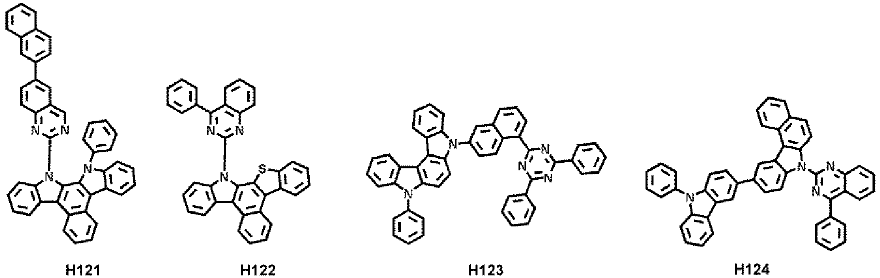

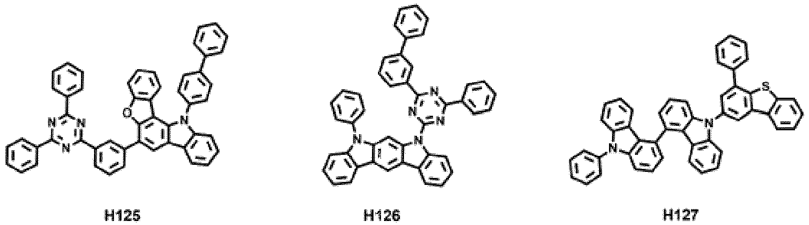

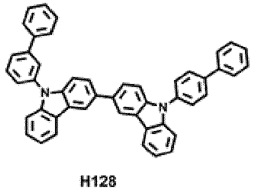

In one or more embodiments, the host may include a silicon-containing compound, a phosphine oxide-containing compound, or any combination thereof.

The host may include only one kind of compound or may include two or more different kinds of compounds, and one or more suitable modification may be made. Phosphorescent dopant

The emission layer may include, as a phosphorescent dopant, the organometallic compound represented by Formula 1 as described herein.

In one or more embodiments, when the emission layer includes the organometallic compound represented by Formula 1 as described herein, and the organometallic compound represented by Formula 1 as described herein acts as an auxiliary dopant, the emission layer may include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In one or more embodiments, the phosphorescent dopant may include an organometallic compound represented by Formula 401:

Formula 401 M(L₄₀₁)_{xc1}(L₄₀₂)_{xc2}

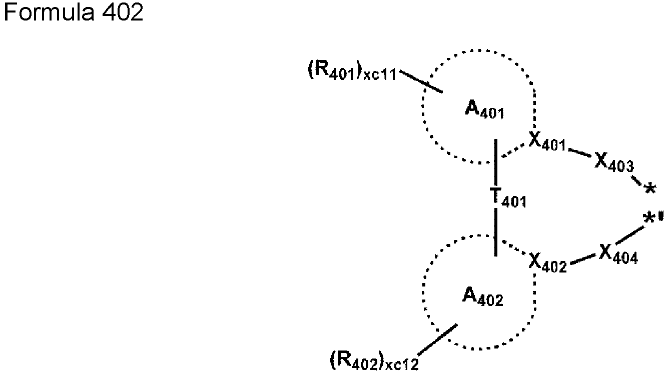

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 is 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be N or C,
ring A₄₀₁ and ring A₄₀₂ may each independently be a C₃-C₆₀ (*e.g*. C₃-C₃₀) carbocyclic group or a C₁-C₆₀ (*e.g*. C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ are each as described in connection with Q₁ herein,
R₄₀₁ and R₄₀₂ may each independently be hydrogen, deuterium, -F, -Cl, -Br, - I, a hydroxyl group, a cyano group, a nitro group, a C₁-C₂₀ alkyl group that is unsubstituted or substituted with at least one R₁₀ₐ, a C₁-C₂₀ alkoxy group that is unsubstituted or substituted with at least one R₁₀ₐ, a C₃-C₆₀ (*e.g*. C₃-C₃₀) carbocyclic group that is unsubstituted or substituted with at least one R₁₀ₐ, a C₁-C₆₀ (*e.g*. C₁-C₂₀) heterocyclic group that is unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O)(Q₄₀₁)(Q₄₀₂),
Q₄₀₁ to Q₄₀₃ are each as described in connection with Q₁ herein,
xc11 and xc12 may each independently be an integer from 0 to 10, and
* and *' in Formula 402 each indicate a binding site to M in Formula 401.

In one or more embodiments, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 401 is 2 or more, two ring A₄₀₁ among two or more selected from L₄₀₁ may be optionally linked together via T₄₀₂, which is a linking group, and two ring A₄₀₂ among two or more selected from L₄₀₁ may be optionally linked together via T₄₀₃, which is a linking group (see Compounds PD1 to PD4 and PD7). T₄₀₂ and T₄₀₃ are each as described in connection with T₄₀₁ herein.

L₄₀₂ in Formula 401 may be an organic ligand. In one or more embodiments, L₄₀₂ may include a halogen group, a diketone group (for example, an acetylacetonate group), a carboxylic acid group (for example, a picolinate group), -C(=O), an isonitrile group, a -CN group, a phosphorus group (for example, a phosphine group, a phosphite group, and/or the like), or any combination thereof.

The phosphorescent dopant may include, for example, one selected from among Compounds PD1 to PD39, and/or any combination thereof:

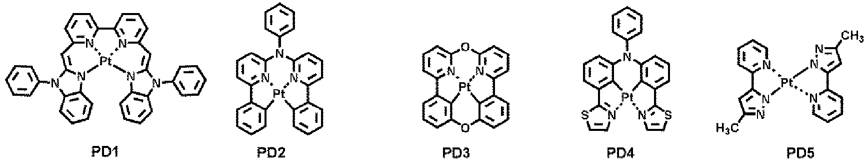

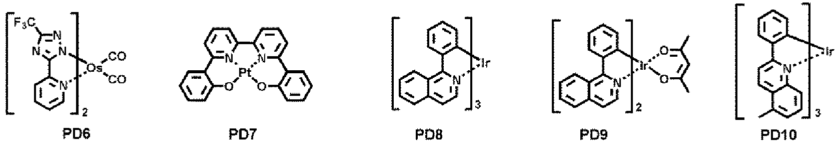

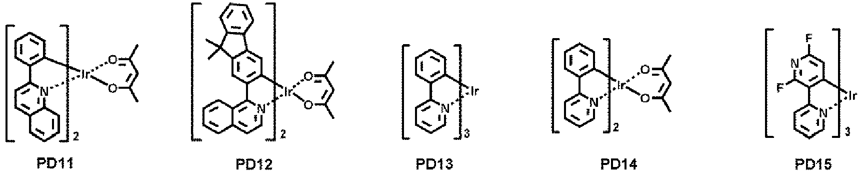

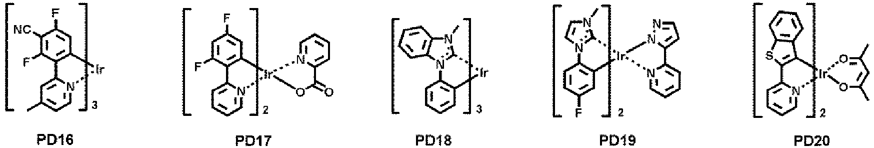

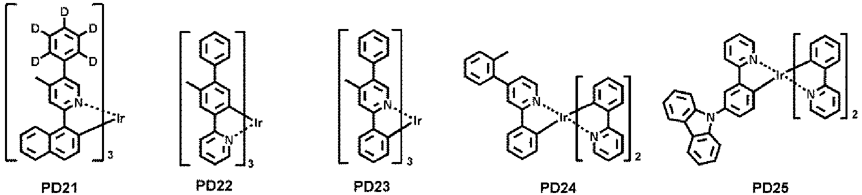

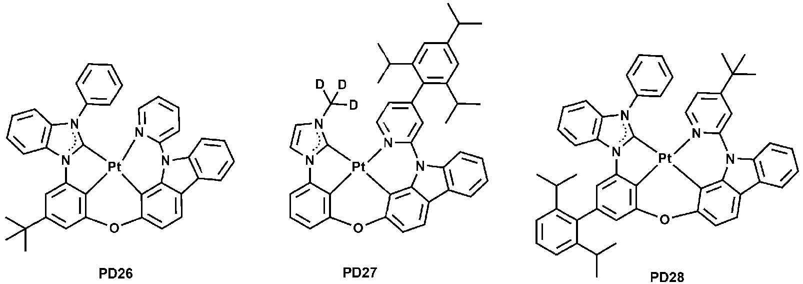

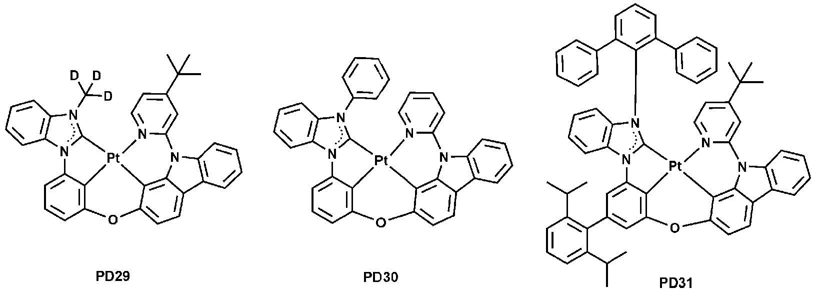

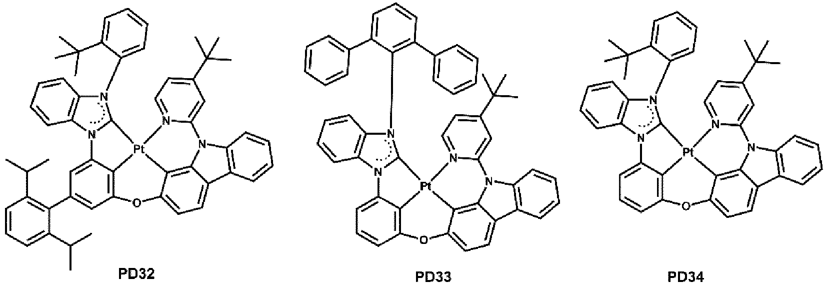

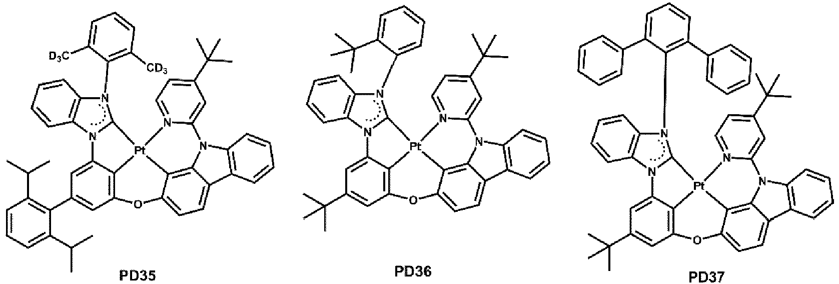

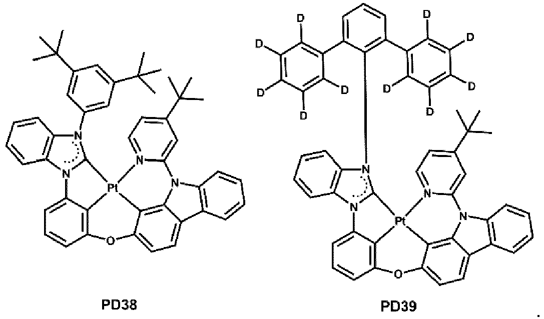

### Fluorescent dopant

When the emission layer includes the organometallic compound represented by Formula 1 as described herein, and the organometallic compound represented by Formula 1 as described herein acts as an auxiliary dopant, the emission layer may include a fluorescent dopant.

In one or more embodiments, when the emission layer includes the organometallic compound represented by Formula 1 as described herein, and the organometallic compound represented by Formula 1 as described herein acts as a phosphorescent dopant, the emission layer may further include an auxiliary dopant.

The fluorescent dopant and the auxiliary dopant may each independently include an arylamine compound, a styrylamine compound, a boron-containing compound, or any combination thereof.

In one or more embodiments, the fluorescent dopant and the auxiliary dopant may each independently include a compound represented by Formula 501: 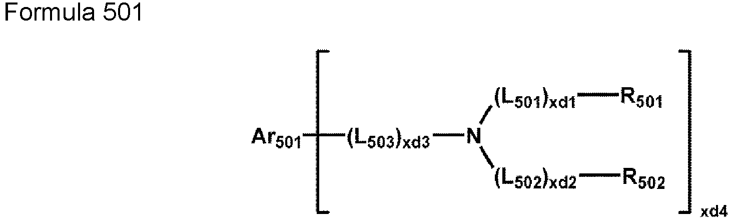 wherein, in Formula 501,
Ar₅₀₁, L₅₀₁ to L₅₀₃, R₅₀₁, and R₅₀₂ may each independently be a C₃-C₆₀ (*e.g*. C₃-C₃₀) carbocyclic group that is unsubstituted or substituted with at least one R₁₀ₐ or a C₁-C₆₀ (*e.g*. C₁-C₂₀) heterocyclic group that is unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (for example, an anthracene group, a chrysene group, a pyrene group, and/or the like) in which three or more monocyclic groups are condensed together.

In one or more embodiments, xd4 in Formula 501 may be 2.

In one or more embodiments, the fluorescent dopant and the auxiliary dopant may each include one selected from among Compounds FD1 to FD37, DPVBi, DPAVBi, and/or any combination thereof:

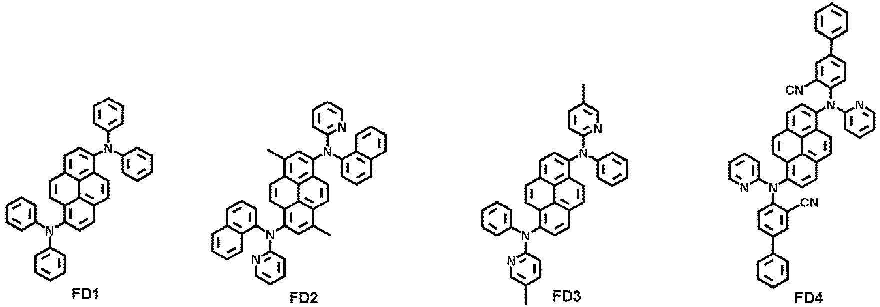

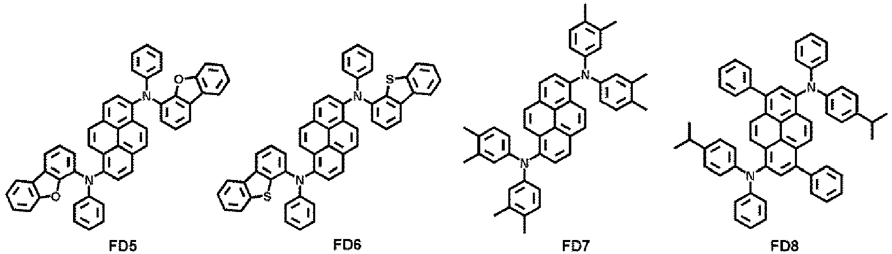

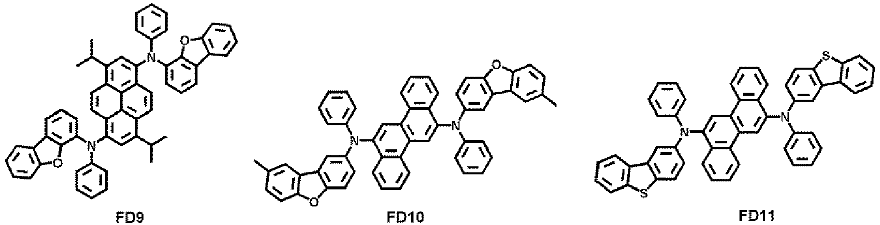

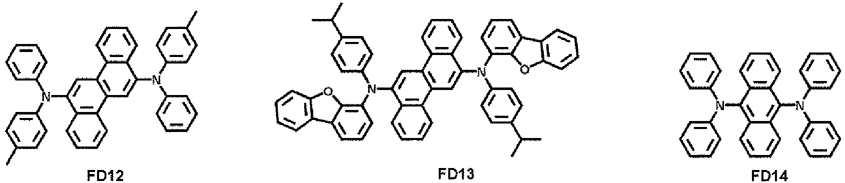

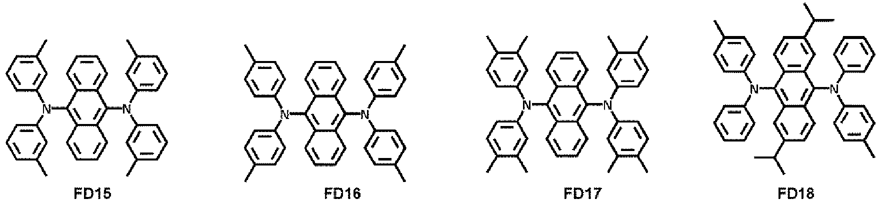

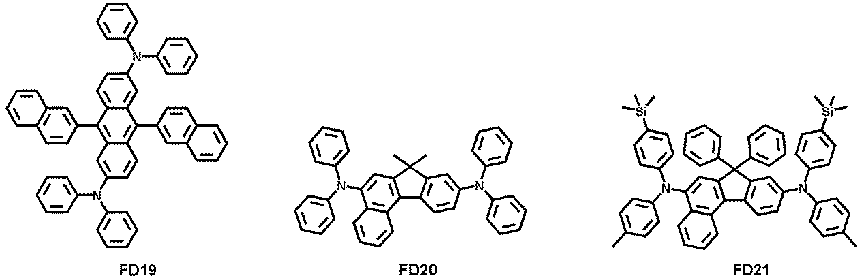

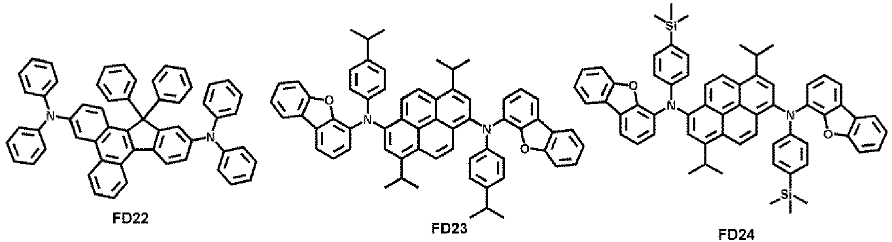

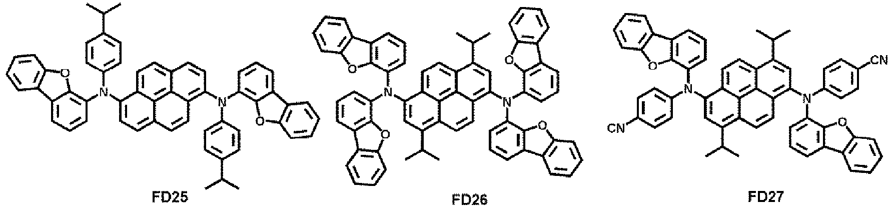

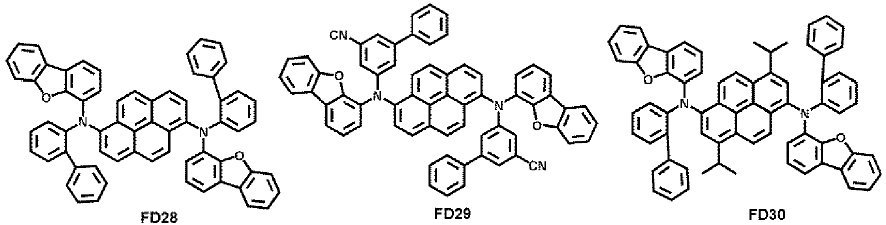

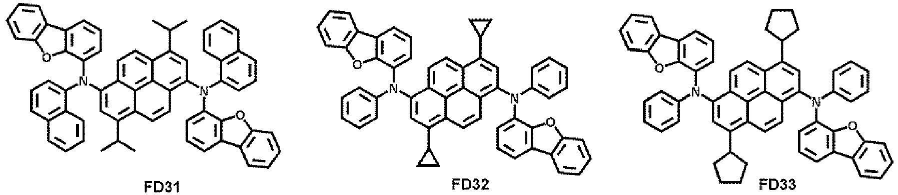

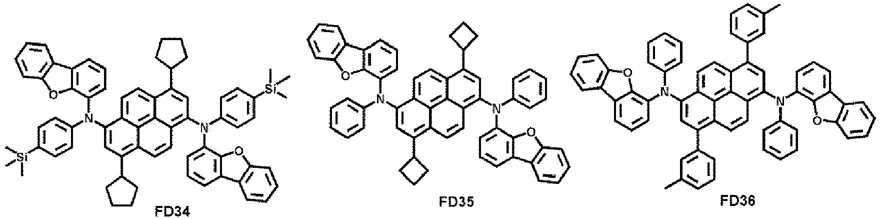

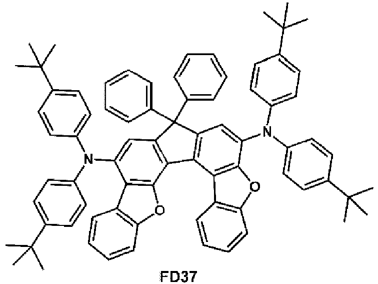

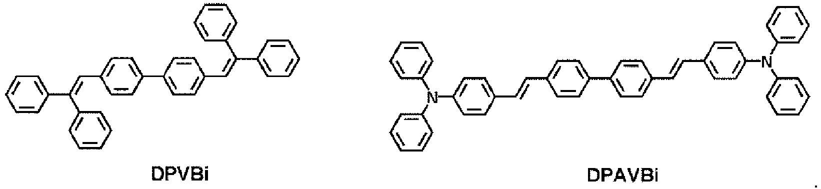

In one or more embodiments, the fluorescent dopant and the auxiliary dopant may each independently include the fourth compound represented by Formula 502 or 503 as described herein.

### Delayed fluorescence material

The emission layer may include a delayed fluorescence material.

Herein, the delayed fluorescence material may be selected from compounds capable of emitting delayed fluorescence based on a delayed fluorescence emission mechanism.

The delayed fluorescence material included in the emission layer may act as a host or a dopant depending on the type or kind of other materials included in the emission layer.

In one or more embodiments, a difference between a triplet energy level (eV) of the delayed fluorescence material and the singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material is satisfied within the range as described, up-conversion from the triplet state to the singlet state of the delayed fluorescence materials may effectively occur, and thus, the luminescence efficiency of the light-emitting device 10 may be increased.

In one or more embodiments, the delayed fluorescence material may include:
i) a material including at least one electron donor (for example, a π electron-rich C₃-C₆₀ (*e.g*. C₃-C₃₀) cyclic group such as a carbazole group) and at least one electron acceptor (for example, a sulfoxide group, a cyano group, a π electron-deficient nitrogen-containing C₁-C₆₀ (*e.g*. C₁-C₃₀) cyclic group, and/or the like), and/or
ii) a material including a C₈-C₆₀ (*e.g*. C₈-C₃₀) polycyclic group including at least two cyclic groups that are condensed with each other while sharing boron (B).

Examples of the delayed fluorescence material may include at least one selected from among Compounds DF1 to DF14:

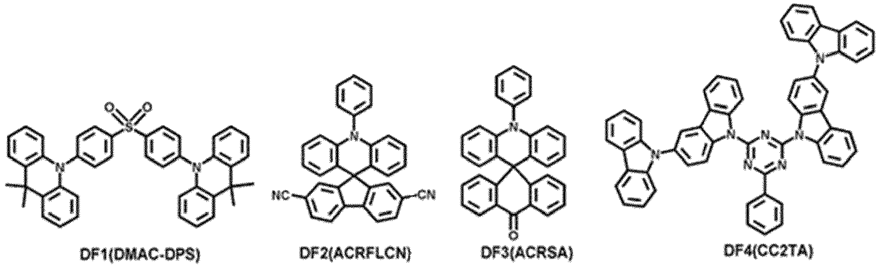

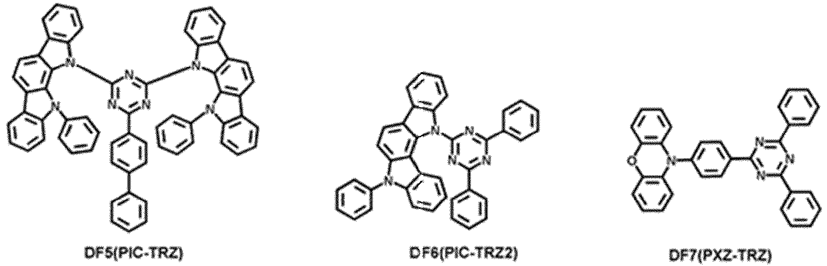

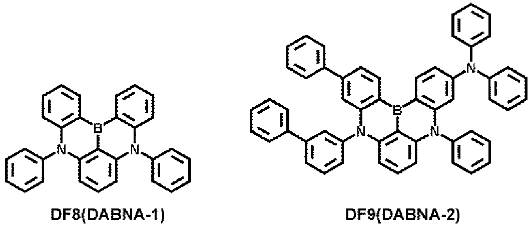

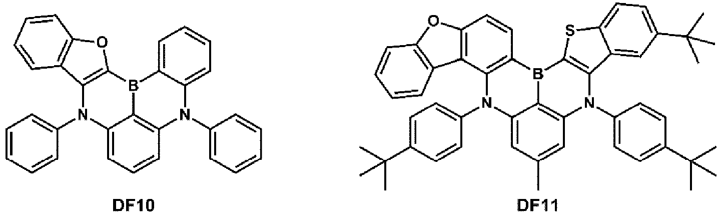

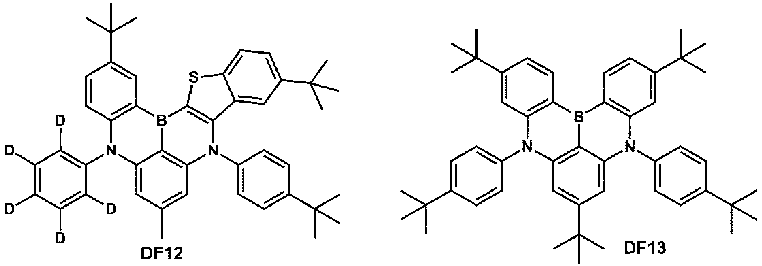

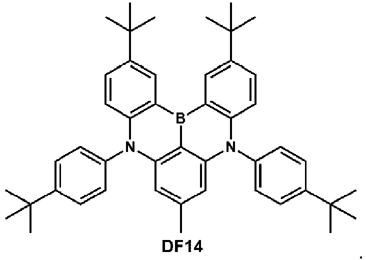

### Quantum dot

The emission layer may include quantum dots.

Herein, a "quantum dot" refers to a crystal of a semiconductor compound, and may include any material capable of emitting light of one or more suitable emission wavelengths according to the size of the crystal.

The diameter of the quantum dot may be, for example, about 1 nm to about 10 nm. In the present disclosure, when dots or dot particles are spherical, "diameter" indicates a particle diameter or an average particle diameter, and when the particles are non-spherical, the "diameter" indicates a major axis length or an average major axis length. The diameter of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter is referred to as D50. D50 refers to the average diameter of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The quantum dot may be synthesized by a wet chemical process, a metal organic chemical vapor deposition process, a molecular beam epitaxy process, or any process similar thereto.

The wet chemical process is a method including mixing a precursor material with an organic solvent and then growing quantum dot particle crystals. When the crystal grows, the organic solvent naturally acts as a dispersant coordinated on the surface of the quantum dot crystal and controls the growth of the crystal so that the growth of quantum dot particles can be controlled or selected through a process which costs lower, and is easier than vapor deposition methods, such as metal organic chemical vapor deposition (MOCVD) or molecular beam epitaxy (MBE).

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound may include: a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or any combination thereof.

Examples of the Group III-V semiconductor compound may include: a binary compound, such as GaN, GaP, GaAs, GaSb, AIN, AlP, AlAs, AlSb, InN, InP, InAs, or InSb; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, or InPSb; a quaternary compound, such as GaAlNP, GaAINAs, GaAINSb, GaAlPAs, GaAlPSb, GaInNP, GaInNAs, GaInNSb, GaInPAs, GaInPSb, InAlNP, InAINAs, InAlNSb, InAlPAs, or InAlPSb; or any combination thereof. In one or more embodiments, the Group III-V semiconductor compound may further include a Group II element. Examples of the Group III-V semiconductor compound further including the Group II element may include InZnP, InGaZnP, and InAlZnP.

Examples of the Group III-VI semiconductor compound may include: a binary compound, such as GaS, GaSe, Ga₂Se₃, GaTe, InS, InSe, In₂S₃, In₂Se₃, or InTe; a ternary compound, such as InGaS₃ or InGaSe₃; or any combination thereof.

Examples of the Group I-III-VI semiconductor compound may include: a ternary compound, such as AgInS, AgInS₂, CuInS, CuInS₂, CuGaO₂, AgGaO₂, or AgAlO₂; or any combination thereof.

Examples of the Group IV-VI semiconductor compound may include: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or any combination thereof.

Examples of the Group IV element or compound may include: a single element compound, such as Si or Ge; a binary compound, such as SiC or SiGe; or any combination thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or may have a core-shell dual structure. In one or more embodiments, a material included in the core and a material included in the shell may be different from each other.

The shell of the quantum dot may act as a protective layer which prevents chemical denaturation of the core to maintain semiconductor characteristics, and/or as a charging layer which imparts electrophoretic characteristics to the quantum dot. The shell may be a single layer or a multilayer. The interface between the core and the shell may have a concentration gradient in which the concentration of an element existing in the shell decreases toward the center of the core.

Examples of the shell of the quantum dot are an oxide of metal, metalloid, or non-metal, a semiconductor compound, or a combination thereof. Examples of the oxide of metal, metalloid, or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; or any combination thereof. Examples of the semiconductor compound may include: as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. In one or more embodiments, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width at half maximum (FWHM) of the emission wavelength spectrum of about 45 nm or less, about 40 nm or less, or for example, about 30 nm or less, and in these ranges, color purity or color reproducibility may be increased. In some embodiments, because light emitted through the quantum dot is emitted in all directions, the wide viewing angle may be improved.

In some embodiments, the quantum dot may be in the form of one or more of (e.g., one or more selected from among) spherical, pyramidal, multi-arm, and/or cubic nanoparticles, nanotubes, nanowires, nanofibers, and/or nanoplate particles.

Because the energy band gap may be adjusted by controlling the size of the quantum dot, light having one or more suitable wavelength bands may be obtained from the quantum dot emission layer. Accordingly, by utilizing quantum dots of different sizes, a light-emitting device that emits light of one or more suitable wavelengths may be implemented. In detail, the size of the quantum dot may be selected to emit red light, green light, and/or blue light. In some embodiments, the size of the quantum dot may be configured to emit white light by combination of light of one or more suitable colors.

### Electron transport region in interlayer 130

The electron transport region may have:
i) a single-layered structure including (e.g., consisting of) a single layer including (e.g., consisting of) a single material,
ii) a single-layered structure including (e.g., consisting of) a single layer including (e.g., consisting of) a plurality of materials that are different from each other, or
iii) a multilayer structure including a plurality of layers including a plurality of materials that are different from each other.

The electron transport region may include a buffer layer, a hole blocking layer, an electron control layer, an electron transport layer, an electron injection layer, or any combination thereof.

In one or more embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer.

The electron transport region (for example, a buffer layer, a hole blocking layer, an electron control layer, or an electron transport layer in the electron transport region) may include a metal-free compound including at least one π electron-deficient nitrogen-containing C₁-C₆₀ (e.g. C₁-C₃₀) heterocyclic group.

In one or more embodiments, the electron transport region may include a compound represented by Formula 601.

Formula 601 [Ar₆₀₁]ₓₑ₁₁-[(L₆₀₁)ₓₑ₁-R₆₀₁]ₓₑ₂₁.

In Formula 601,
Ar₆₀₁ and L₆₀₁ may each independently be a C₃-C₆₀ (e.g. C₃-C₃₀) carbocyclic group that is unsubstituted or substituted with at least one R₁₀ₐ or a C₁-C₆₀ (e.g. C₁-C₂₀) heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (e.g. C₃-C₃₀) carbocyclic group that is unsubstituted or substituted with at least one R₁₀ₐ, a C₁-C₆₀ (e.g. C₁-C₂₀) heterocyclic group that is unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), or -P(=O)(Q₆₀₁)(Q₆₀₂),
Q₆₀₁ to Q₆₀₃ are each as described in connection with Q₁ herein,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ (e.g. C₁-C₃₀) cyclic group that is unsubstituted or substituted with at least one R₁₀ₐ.

In one or more embodiments, when xe11 in Formula 601 is 2 or more, two or more of Ar₆₀₁ may be linked together via a single bond.

In one or more embodiments, Ar₆₀₁ in Formula 601 may be a substituted or unsubstituted anthracene group.

In one or more embodiments, the electron transport region may include a compound represented by Formula 601-1: 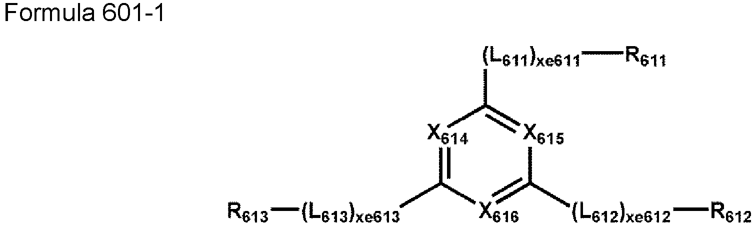 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ are each as described in connection with L₆₀₁,
xe611 to xe613 are each as described in connection with xe1,
R₆₁₁ to R₆₁₃ are each as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ (e.g. C₁-C₁₀) alkyl group, a C₁-C₂₀ (e.g. C₁-C₁₀) alkoxy group, a C₃-C₆₀ (e.g. C₃-C₃₀) carbocyclic group that is unsubstituted or substituted with at least one R₁₀ₐ, or a C₁-C₆₀ (e.g. C₁-C₂₀) heterocyclic group that is unsubstituted or substituted with at least one R₁₀ₐ.

In one or more embodiments, xe1 and xe611 to xe613 in Formulae 601 and 601-1 may each independently be 0, 1, or 2.

The electron transport region may include: one of or including (e.g., one selected from among) Compounds ET1 to ET45; 2,9-dimethyl-4,7-diphenyl-1,10-phenanthroline (BCP); 4,7-diphenyl-1,10-phenanthroline (Bphen); Alq₃; BAlq; TAZ; NTAZ; and/or any combination thereof:

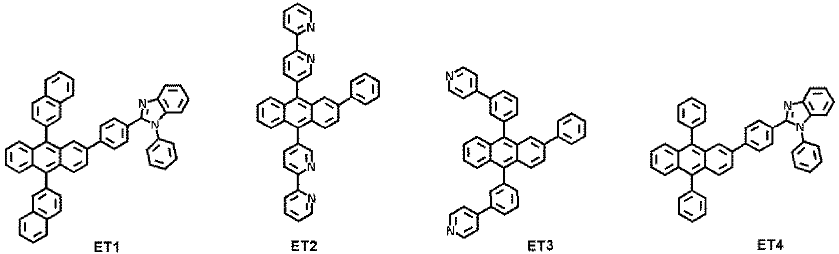

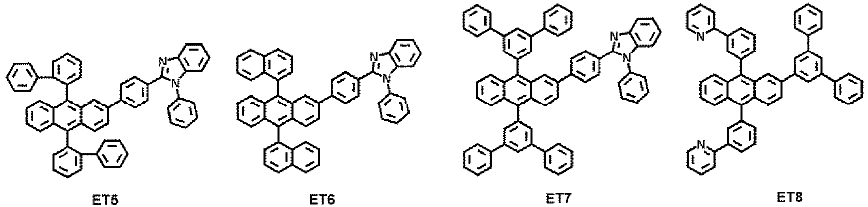

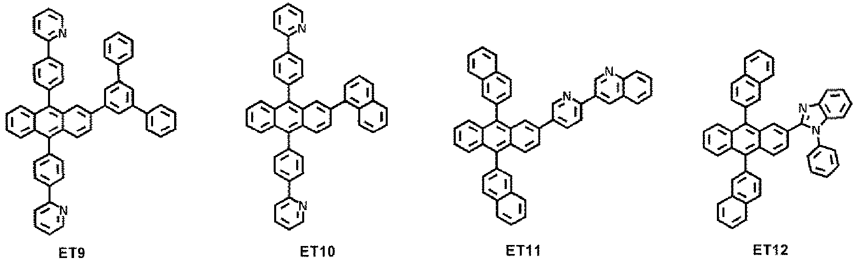

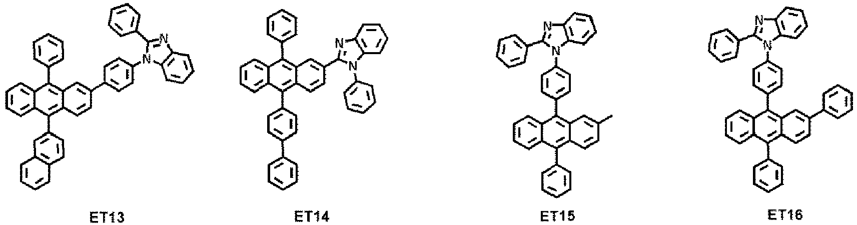

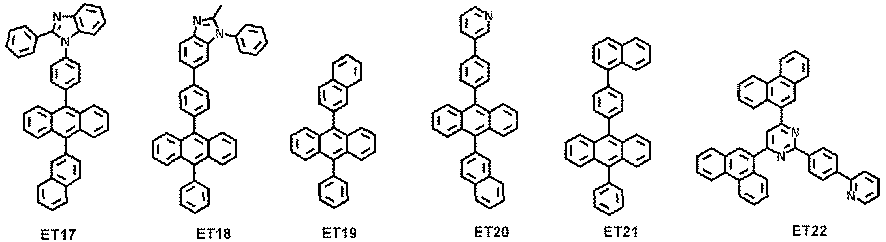

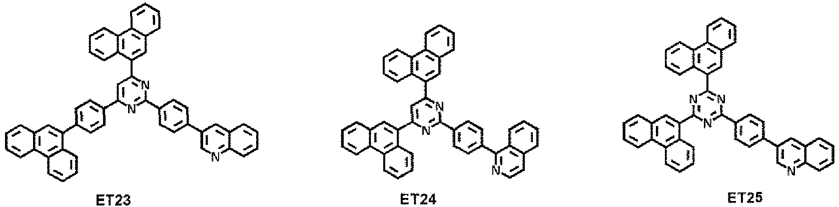

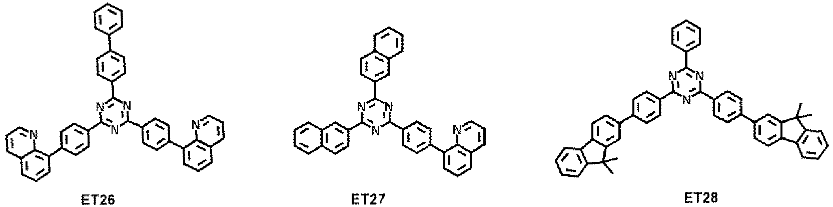

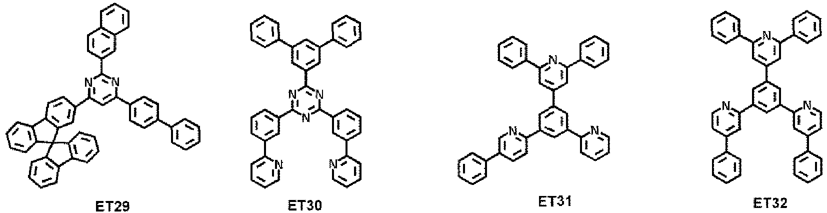

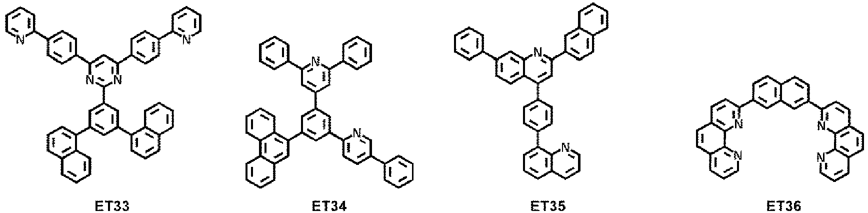

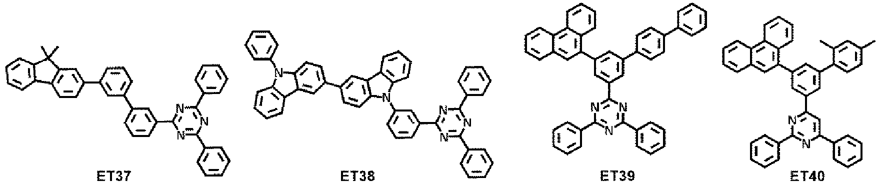

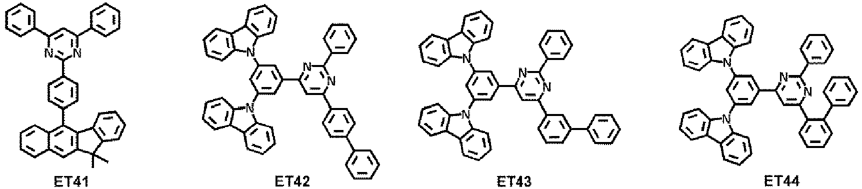

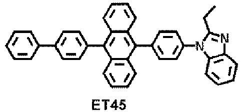

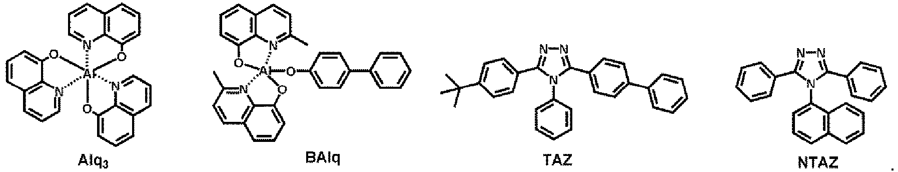

The thickness of the electron transport region may be about 100 Å to about 5,000 Å, for example, about 160 Å to about 4,000 Å. When the electron transport region includes a buffer layer, a hole blocking layer, an electron control layer, an electron transport layer, or any combination thereof, the thickness of the buffer layer, the hole blocking layer, or the electron control layer may be about 20 Å to about 1,000 Å, for example, about 30 Å to about 300 Å, and the thickness of the electron transport layer may be about 100 Å to about 1,000 Å, for example, about 150 Å to about 500 Å. When the thickness of the buffer layer, the hole blocking layer, the electron control layer, the electron transport layer, and/or the electron transport layer is within the ranges as described, satisfactory electron transporting characteristics may be obtained without a substantial increase in driving voltage.

The electron transport region (for example, the electron transport layer in the electron transport region) may further include, in addition to the materials described, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In one or more embodiments, the metal-containing material may include a Li complex. The Li complex may include, for example, Compound ET-D1 (LiQ) or ET-D2:

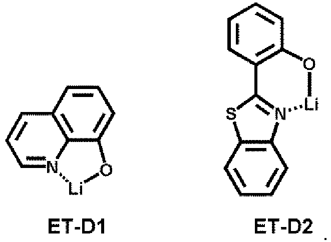

The electron transport region may include an electron injection layer that facilitates the injection of electrons from the second electrode 150. The electron injection layer may directly contact the second electrode 150.

The electron injection layer may have:
i) a single-layered structure including (e.g., consisting of) a single layer including (e.g., consisting of) a single material,
ii) a single-layered structure including (e.g., consisting of) a single layer including (e.g., consisting of) a plurality of layers that are different from each other, or
iii) a multilayer structure including a plurality of layers including a plurality of materials that are different from each other.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, iodides, and/or the like), or tellurides of the alkali metal, the alkaline earth metal, and the rare earth metal, or any combination thereof.

The alkali metal-containing compound may include alkali metal oxides, such as Li₂O, Cs₂O, or K₂O, alkali metal halides, such as LiF, NaF, CsF, KF, Lil, Nal, CsI, or KI, or any combination thereof. The alkaline earth metal-containing compound may include an alkaline earth metal compound, such as BaO, SrO, CaO, BaₓSr₁₋ₓO (x is a real number satisfying 0<x<1), or BaₓCa₁₋ₓO (x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include
i) at least one selected from among metal ions of the alkali metal, the alkaline earth metal, and the rare earth metal, and
ii) as a ligand bonded to the metal ions (i.e., the selected metal ions), for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described. In one or more embodiments, the electron injection layer may further include an organic material (for example, a compound represented by Formula 601).

In one or more embodiments, the electron injection layer may include (e.g., consist of)
i) an alkali metal-containing compound (for example, alkali metal halide),
ii) a) an alkali metal-containing compound (for example, alkali metal halide); and b) an alkali metal, an alkaline earth metal, a rare earth metal, or any combination thereof. In one or more embodiments, the electron injection layer may be a KI:Yb co-deposited layer, an RbI:Yb co-deposited layer, a LiF:Yb co-deposited layer, and/or
iii) the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly or non-uniformly dispersed in a matrix including the organic material.

The thickness of the electron injection layer may be about 1 Å to about 100 Å, and, for example, about 3 Å to about 90 Å. When the thickness of the electron injection layer is within the range as described, satisfactory electron injection characteristics may be obtained without a substantial increase in driving voltage. Second electrode 150

The second electrode 150 is arranged on the interlayer 130. The second electrode 150 may be a cathode, which is an electron injection electrode, and as a material for forming the second electrode 150, a metal, an alloy, an electrically conductive compound, or any combination thereof, each having a low work-function, may be utilized. The term "low work-function material" as utilized herein refers to a substance (e.g., a metal or metal alloy) that requires a relatively small, or low, amount of energy to emit electrons from its surface.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layer structure or a multilayer structure including a plurality of layers.

### Capping layer

The first capping layer may be arranged outside (and, e.g., on) the first electrode 110, and/or the second capping layer may be arranged outside (and, e.g., on) the second electrode 150. For example, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a semi-transmissive electrode or a transmissive electrode, and the first capping layer. Light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, such that the luminescence efficiency of the light-emitting device 10 may be increased.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from among the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be optionally substituted with a substituent including O, N, S, Se, Si, F, Cl, Br, I, or any combination thereof. In one or more embodiments, at least one of the first capping layer or the second capping layer may each independently include an amine group-containing compound.

In one or more embodiments, at least one selected from among the first capping layer and the second capping layer may each independently include a compound represented by Formula 201, a compound represented by Formula 202, or any combination thereof.

In one or more embodiments, at least one selected from among the first capping layer and the second capping layer may each independently include one selected from among Compounds HT28 to HT33, one selected from among Compounds CP1 to CP6, β-NPB, and/or any combination thereof:

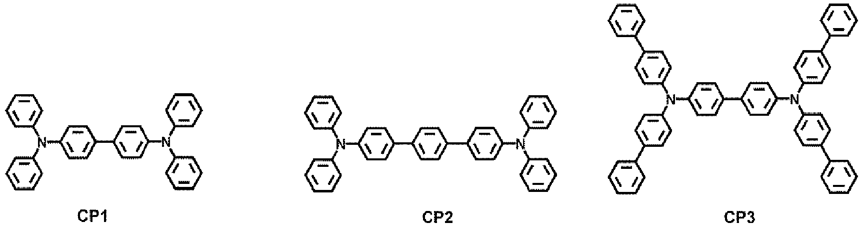

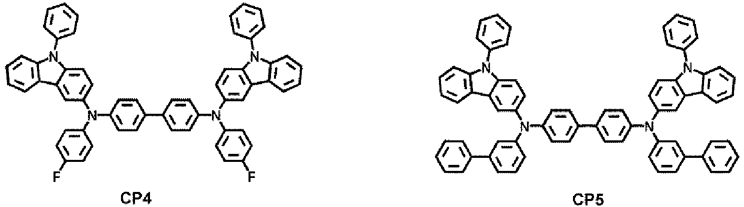

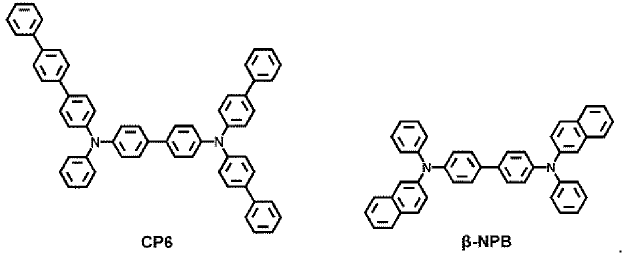

### Electronic apparatus

The light-emitting device may be included in one or more suitable electronic apparatuses. In one or more embodiments, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. In one or more embodiments, light emitted from the light-emitting device may be blue light, green light, or white light. A detailed description of the light-emitting device is provided. In one or more embodiments, the color conversion layer may include quantum dots.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths. In one or more embodiments, the first color light may be red light, the second color light may be green light, and the third color light may be blue light. In one or more embodiments, the plurality of color filter areas (or the plurality of color conversion areas) may include quantum dots. In detail, the first area may include red quantum dots, the second area may include green quantum dots, and the third area may not include (e.g., may exclude any) quantum dots. A detailed description of the quantum dots is provided herein. The first area, the second area, and/or the third area may each further include a scatterer.

In one or more embodiments, the light-emitting device may be to emit (e.g., configured to emit) first light, the first area may be to absorb (e.g., configured to absorb) the first light to emit first-first color light, the second area may be to absorb (e.g., configured to absorb) the first light to emit second-first color light, and the third area may be to absorb (e.g., configured to absorb) the first light to emit third-first color light. In this case, the first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further include a thin-film transistor, in addition to the light-emitting device as described. The thin-film transistor may include a source electrode, a drain electrode, and an activation layer, wherein one of the source electrode or the drain electrode may be electrically connected to one of the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

One or more suitable functional layers may be additionally arranged on the sealing portion, in addition to the color filter and/or the color conversion layer, according to the use of the electronic apparatus. Examples of the functional layers may include a touch screen layer and a polarizing layer. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, and/or the like).

The authentication apparatus may further include, in addition to the light-emitting device as described, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like. Electronic equipment

The light-emitting device may be included in one or more suitable electronic equipment.

In one or more embodiments, the electronic equipment including the light-emitting device may be at least one select from among a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, a signboard, and combinations thereof.

Because the light-emitting device has excellent or suitable luminescence efficiency and long lifespan, the electronic equipment including the light-emitting device may have characteristics with high luminance, high resolution, and low power consumption.

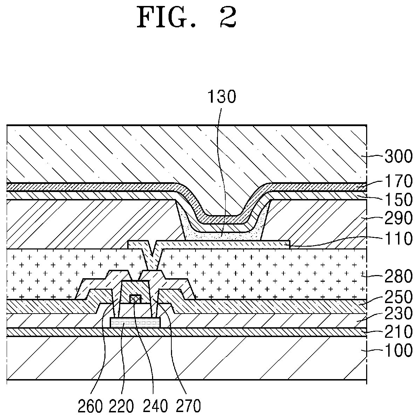

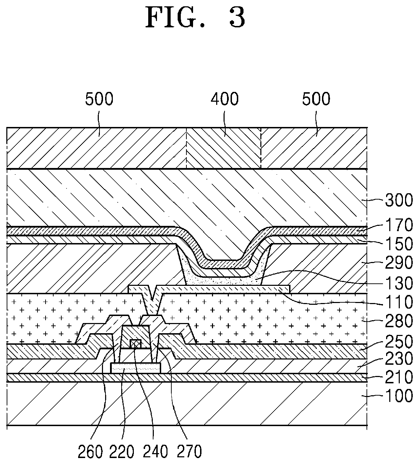

### Description of FIGS. 2 and 3

FIG. 2 is a cross-sectional view of a light-emitting apparatus as an example of the electronic apparatus according to one or more embodiments.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent or reduce penetration of impurities through the substrate 100 and may provide a flat surface on the substrate 100.

The TFT may be arranged on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged to be in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a certain region of the drain electrode 270, not fully covering the drain electrode 270, and the first electrode 110 may be arranged to be connected to the exposed region of the drain electrode 270.

A pixel-defining film 290 including an insulating material may be arranged on the first electrode 110. The pixel-defining film 290 may expose a certain region of the first electrode 110, and the interlayer 130 may be formed in the exposed region of the first electrode 110. The pixel-defining film 290 may be a polyimide-based organic film or a polyacrylic organic film. In one or more embodiments, at least some layers of the interlayer 130 may extend beyond the upper portion of the pixel-defining film 290 to be arranged in the form of a common layer.

The second electrode 150 may be arranged on the interlayer 130, and a second capping layer 170 may be additionally formed on the second electrode 150. The second capping layer 170 may be formed to cover the second electrode 150.

The encapsulation portion 300 may be arranged on the second capping layer 170. The encapsulation portion 300 may be arranged on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or a combination of the inorganic film(s) and the organic film(s).

FIG. 3 is a cross-sectional view of a light-emitting apparatus as an example of the electronic apparatus according to another embodiment.

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

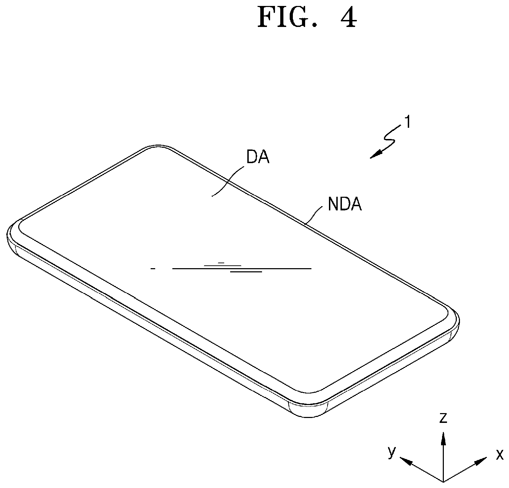

### Description of FIG. 4

FIG. 4 is a schematic perspective view of electronic equipment 1 including a light-emitting device according to one or more embodiments. The electronic equipment 1 may be, as an apparatus that displays a moving image or a still image, portable electronic equipment, such as a mobile phone, a smartphone, a tablet personal computer (PC), a mobile communication terminal, an electronic notebook, an electronic book, a portable multimedia player (PMP), a navigation, or a ultra-mobile PC (UMPC), as well as one or more suitable products, such as a television, a laptop, a monitor, a billboard, or an Internet of things (IOT). The electronic equipment 1 may be such a product or a part thereof. In some embodiments, the electronic equipment 1 may be a wearable device, such as a smart watch, a watch phone, a glasses-type or kind display, or a head mounted display (HMD), or a part of the wearable device. However, the disclosure is not limited thereto. In one or more embodiments, the electron equipment 1 may include a dashboard of a vehicle, a center fascia of a vehicle, a center information display arranged on a dashboard of a vehicle, a room mirror display replacing a side-view mirror of a vehicle, an entertainment display for the rear seat of a vehicle or a display arranged on the back of the front seat, or a head up display (HUD) installed in the front of a vehicle or projected on a front window glass, a computer generated hologram augmented reality head up display (CGH AR HUD). FIG. 4 illustrates a case in which the electronic equipment 1 is a smartphone for convenience of explanation.

The electronic equipment 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printed circuit board, may be electrically connected may be arranged.

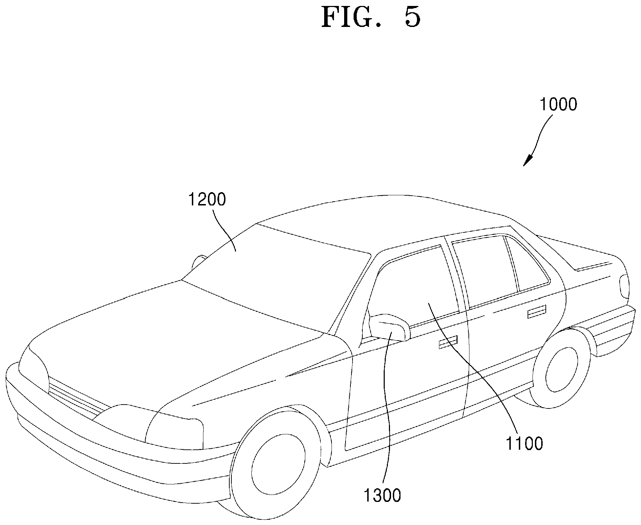

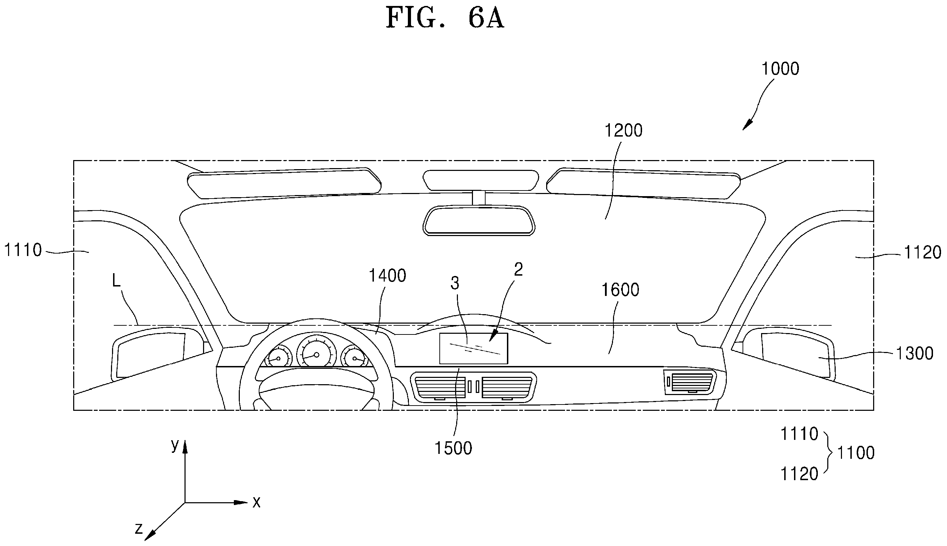

In the electronic equipment 1, the length in an x-axis direction and the length in a y-axis direction may be different from each other. In one or more embodiments, as shown in FIG. 4, the length in the x-axis direction may be smaller than the length in the y-axis direction. In one or more embodiments, the length in the x-axis direction may be the same as the length in the y-axis direction. In one or more embodiments, the length in the x-axis direction may be greater than the length in the y-axis direction. Descriptions of FIGS. 5 and 6A to 6C

FIG. 5 is a schematic view of the exterior of a vehicle 1000 as an electronic apparatus including a light-emitting device according to one or more embodiments. FIGS. 6A to 6C are each a schematic view of the interior of the vehicle 1000 according to one or more embodiments.

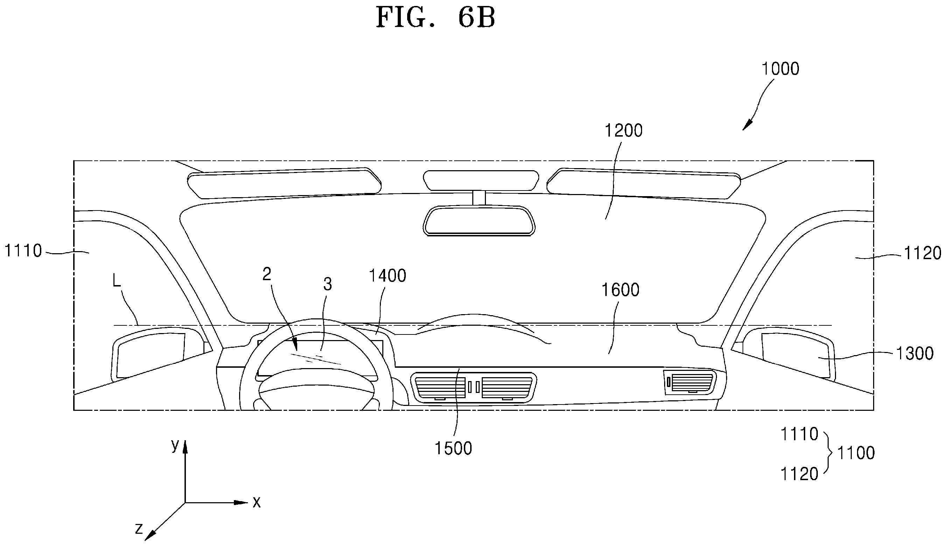

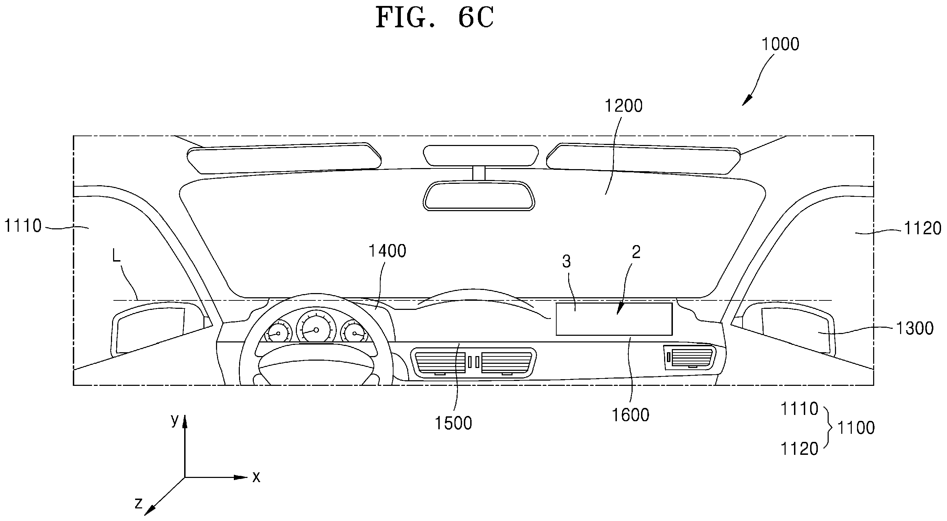

Referring to FIGS. 5, 6A, 6B, and 6C, the vehicle 1000 may refer to one or more suitable apparatuses for moving a subject to be transported, such as a human, an object, or an animal, from a departure point to a destination point. The vehicle 1000 may include a vehicle (e.g., automobile) traveling on a road or track, a vessel moving over the sea or river, an airplane flying in the sky utilizing the action of air, and/or the like.

The vehicle 1000 may travel on a road or a track. The vehicle 1000 may move in a certain direction according to rotation of at least one wheel. In one or more embodiments, the vehicle 1000 may include a three-wheeled or four-wheeled vehicle, a construction machine, a two-wheeled vehicle, a prime mover device, a bicycle, and/or a train running on a track.

The vehicle 1000 may include a vehicle body having an interior and an exterior, and a chassis in which mechanical apparatuses necessary for driving are installed as other parts except for the vehicle body. The exterior of the vehicle body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side-view mirror 1300, a cluster 1400, a center fascia 1500, a passenger seat dashboard 1600, and a display device 2.

The side window glass 1100 and the front window glass 1200 may be partitioned by a filler arranged between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in an x direction or a -x direction. In one or more embodiments, the first side window glass 1110 and the second side window glass 1120 may be spaced apart from each other in the x direction or the -x direction. In other words, an imaginary straight line L connecting the side window glasses 1100 may extend in the x direction or the -x direction. In one or more embodiments, an imaginary straight line L connecting the first side window glass 1110 and the second side window glass 1120 to each other may extend in the x direction or the -x direction.

The front window glass 1200 may be installed in front of the vehicle 1000. The front window glass 1200 may be arranged between the side window glasses 1100 facing each other.

The side-view mirror 1300 may provide a rear view of the vehicle 1000. The side-view mirror 1300 may be installed on the exterior of the vehicle body. In one or more embodiments, a plurality of side-view mirrors 1300 may be provided. Any one of the plurality of side-view mirrors 1300 may be arranged outside the first side window glass 1110. The other one of the plurality of side-view mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are provided. The center fascia 1500 may be arranged on one side of the cluster 1400.

The passenger seat dashboard 1600 may be spaced apart from the cluster 1400 with the center fascia 1500 arranged therebetween. In one or more embodiments, the cluster 1400 may be arranged to correspond to a driver seat, and the passenger seat dashboard 1600 may be arranged to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In one or more embodiments, the display device 2 may be arranged between the side window glasses 1100 facing each other. The display device 2 may be arranged on at least one of the cluster 1400, the center fascia 1500, and the passenger seat dashboard 1600.

The display device 2 may include an organic light-emitting display device, an inorganic EL display device, a quantum dot display device, and/or the like. Hereinafter, an organic light-emitting display device including the light-emitting device according to the disclosure will be described as an example of the display device 2 according to one or more embodiments, but one or more suitable types (kinds) of display devices as described may be utilized in embodiments.

Referring to FIG. 6A, the display device 2 may be arranged on the center fascia 1500. In one or more embodiments, the display device 2 may display navigation information. In one or more embodiments, the display device 2 may display audio, video, or information regarding vehicle settings.

Referring to FIG. 6B, the display device 2 may be arranged on the cluster 1400. In this case, the cluster 1400 may display driving information and/or the like through the display device 2. In other words, the cluster 1400 may be implemented digitally. The digital cluster 1400 may display vehicle information and driving information as images. In one or more embodiments, a needle and a gauge of a tachometer and one or more suitable warning light icons may be displayed by a digital signal.

Referring to FIG. 6C, the display device 2 may be arranged on the passenger seat dashboard 1600. The display device 2 may be embedded in the passenger seat dashboard 1600 or arranged on the passenger seat dashboard 1600. In one or more embodiments, the display device 2 arranged on the passenger seat dashboard 1600 may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are formed by vacuum deposition, the deposition may be performed at a deposition temperature of about 100 °C to about 500 °C, at a vacuum degree of about 10⁻⁸ torr to about 10⁻³ torr, and at a deposition speed of about 0.01 angstrom per second (Å/sec) to about 100 Å/sec, depending on a material to be included in a layer to be formed and the structure of a layer to be formed.

### Definition of terms

The term "C₃-C₆₀ carbocyclic group" as utilized herein refers to a cyclic group consisting of carbon only as a ring-forming atom and having three to sixty carbon atoms, and the term "C₁-C₆₀ heterocyclic group" as utilized herein refers to a cyclic group that has one to sixty carbon atoms and further includes, in addition to the carbon atoms, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In one or more embodiments, the number of ring-forming atoms of the C₁-C₆₀ heterocyclic group may be 3 to 61.

The "cyclic group" as utilized herein may include both (e.g., simultaneously) the C₃-C₆₀ carbocyclic group and the C₁-C₆₀ heterocyclic group.

The term "π electron-rich C₃-C₆₀ cyclic group" as utilized herein refers to a cyclic group that has three to sixty carbon atoms and does not include *-N=*' as a ring-forming moiety, and the term "π electron-deficient nitrogen-containing C₁-C₆₀ heterocyclic group" as utilized herein refers to a heterocyclic group that has one to sixty carbon atoms and includes *-N=*' as a ring-forming moiety.

In one or more embodiments,
the C₃-C₆₀ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ heterocyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ heterocyclic group" as utilized herein may refer to a group condensed to any cyclic group, a monovalent group, or a polyvalent group (for example, a divalent group, a trivalent group, a tetravalent group, and/or the like) according to the structure of a formula for which the corresponding term is utilized. In one or more embodiments, the "benzene group" may be a benzo group, a phenyl group, a phenylene group, and/or the like, which may be easily understood by those of ordinary skill in the art according to the structure of a formula including the "benzene group."

Depending on context, a divalent group may refer or be a polyvalent group (e.g., trivalent, tetravalent, etc., and not just divalent) per, e.g., the structure of a formula in connection with which of the terms are utilized.

In one or more embodiments, examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as utilized herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as utilized herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as utilized herein refers to a monovalent group represented by -OA₁₀₁ (wherein A₁₀₁ is the C₁-C₆₀ alkyl group), and examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as utilized herein refers to a monovalent saturated hydrocarbon cyclic group having three to ten carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group that has one to ten carbon atoms and further includes, in addition to the carbon atoms, at least one heteroatom as a ring-forming atom, and examples thereof include a 1,2,3,4-oxatriazolidinyl group, a tetrahydrofuranyl group, and a tetrahydrothiophenyl group. The term "C₁-C₁₀ heterocycloalkylene group" as utilized herein refers to a divalent group having the same structure as the C₁-C₁₀ heterocycloalkyl group.

The term "C₃-C₁₀ cycloalkenyl group" as utilized herein refers to a monovalent cyclic group that has three to ten carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group that has one to ten carbon atoms, further includes, in addition to the carbon atoms, at least one heteroatom as a ring-forming atom, and has at least one double bond in the ring thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of six to sixty carbon atoms, and the term "C₆-C₆₀ arylene group" as utilized herein refers to a divalent group having a carbocyclic aromatic system of six to sixty carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the two or more rings may be condensed with each other. Corresponding definitions apply to other ranges given for the number of carbon atoms in an aryl/arylene group.

The term "C₁-C₆₀ heteroaryl group" as utilized herein refers to a monovalent group having a heterocyclic aromatic system that has one to sixty carbon atoms and further includes, in addition to the carbon atoms, at least one heteroatom as a ring-forming atom. The term "C₁-C₆₀ heteroarylene group" as utilized herein refers to a divalent group having a heterocyclic aromatic system that has one to sixty carbon atoms and further includes, in addition to the carbon atoms, at least one heteroatom as a ring-forming atom. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the two or more rings may be condensed with each other. Corresponding definitions apply to other ranges given for the number of carbon atoms in a heteroaryl/heteroarylene group.

The term "monovalent non-aromatic condensed polycyclic group" as utilized herein refers to a monovalent group having two or more rings condensed with each other, only carbon atoms (for example, eight to sixty carbon atoms) as ring-forming atoms, and no aromaticity in its molecular structure when considered as a whole. Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having the same structure as the monovalent non-aromatic condensed polycyclic group.

The term "monovalent non-aromatic condensed heteropolycyclic group" as utilized herein refers to a monovalent group that has two or more rings condensed with each other, further includes, in addition to carbon atoms (for example, one to sixty carbon atoms), at least one heteroatom as a ring-forming atom, and has no aromaticity in its molecular structure when considered as a whole. Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as the monovalent non-aromatic condensed heteropolycyclic group.

The term "C₆-C₆₀ aryloxy group" as utilized herein refers to -OA₁₀₂ (wherein A₁₀₂ is the C₆-C₆₀ aryl group), and the term "C₆-C₆₀ arylthio group" as utilized herein refers to -SA₁₀₃ (wherein A₁₀₃ is the C₆-C₆₀ aryl group). Corresponding definitions apply to other ranges given for the number of carbon atoms in an aryloxy group and an arylthio group

The term "C₇-C₆₀ arylalkyl group" as utilized herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as utilized herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, or a C₂-C₆₀ (e.g. C₂-C₂₀) heteroarylalkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q₃, Q₁₁ to Q₁₃, Q₂₁ to Q₂₃, and Q₃₁ to Q₃₃ as utilized herein may each independently be: hydrogen; deuterium; -F; -Cl; -Br; -I; a hydroxyl group; a cyano group; a nitro group; or a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any combination thereof.

The term "heteroatom" as utilized herein refers to any atom other than a carbon atom. Examples of the heteroatom include O, S, N, P, Si, B, Ge, Se, or any combination thereof.

The term "third-row transition metal" as utilized herein includes hafnium (Hf), tantalum (Ta), tungsten (W), rhenium (Re), osmium (Os), iridium (Ir), platinum (Pt), and gold (Au).

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group that is substituted with a phenyl group." In other words, the "biphenyl group" may be a substituted phenyl group having a C₆-C₆₀ aryl group as a substituent.

The term "terphenyl group" as utilized herein refers to "a phenyl group substituted with a biphenyl group." In other words, the "terphenyl group" may be a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

In the specification, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6.

The light emitting device and/or any other relevant devices or components according to embodiments of the present disclosure described herein may be implemented utilizing any suitable hardware, firmware (e.g., an application-specific integrated circuit), software, or a combination of software, firmware, and hardware. For example, the various components of the light emitting device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Hereinafter, compounds according to embodiments and light-emitting devices according to embodiments will be described in more detail with reference to the following synthesis examples and examples. The wording "B was utilized instead of A" utilized in describing Synthesis Examples refers to that an identical molar equivalent of B was utilized in place of A.

### Examples

### Synthesis Example 1: Synthesis of Compound BD1

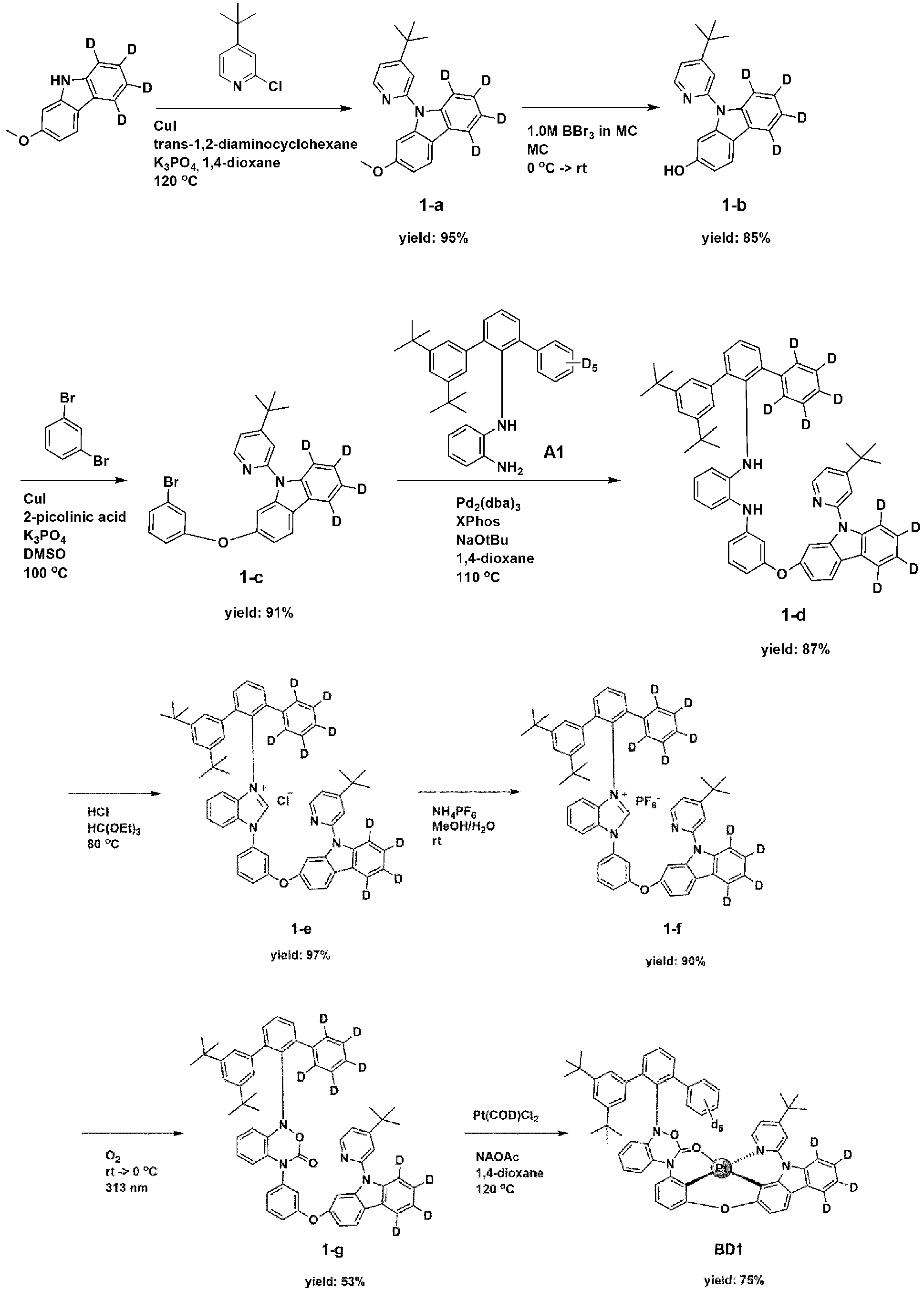

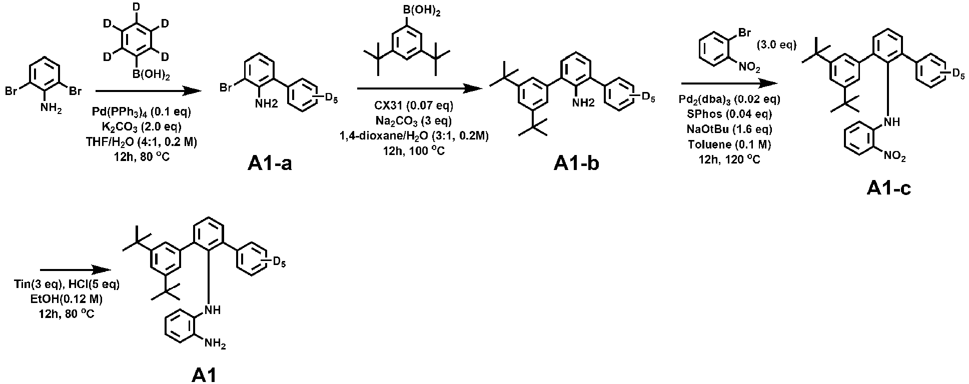

### (1-1) Synthesis of Intermediate 1-a

8.4 g (1.0 eq) of 7-methoxy-1,2,3,4-D-9H-carbazole, 1.0 eq of 4-tert-butyl-2-chloropyridine, 0.1 eq of Cul, 1.2 eq of trans-1,2-diaminocyclohexane, and 2.0 eq of K₃PO₄ were placed in 16.6 mL of 1,4-dioxane and then stirred at 120 °C for 12 hours to synthesize 8.0 g of Intermediate 1-a (yield: 95%).

Hereinbefore and hereinafter, the equivalent (eq) refers to a gram equivalent with respect to a reference material.

### (1-2) Synthesis of Intermediate 1-b

8.0 g (1.0 eq) of Intermediate 1-a was placed in 62.5 mL of methylene chloride (MC), 1.0 M BBr₃ in MC was added thereto, the temperature was changed from 0 °C to room temperature, and stirring was made for 12 hours, to synthesize 6.8 g of Intermediate 1-b (yield: 85%).

### (1-3) Synthesis of Intermediate 1-c

6.8 g (1.0 eq) of Intermediate 1-b, 0.1 eq of Cul, 0.2 eq of 2-picolinic acid, and 2.0 eq of K₃PO₄ were placed in 7.1 mL of dimethyl sulfoxide (DMSO) and then stirred at 100 °C for 12 hours to synthesize 7.1 g of Intermediate 1-c (yield: 91%).

### (2-1) Synthesis of Intermediate A1-a

13.4 g (1.0 eq) of 2,6-dibromoaniline, 1.0 eq of phenyl-d5-boronic acid, 0.1 eq of Pd(PPh₃)₄, and 2.0 eq of K₂CO₃ were placed in 7.8 mL of a solution in which THF and H₂O were mixed in a ratio (e.g., amount) of 4:1, and then stirred at 80 °C for 12 hours to synthesize 12.3 g of Intermediate A1-a (yield: 92%).

### (2-2) Synthesis of Intermediate A1-b

12.3 g (1.0 eq) of Intermediate A1-a, 1.0 eq of 3,5-di-tert-butylphenylboronic acid, 0.07 eq of Umicore CX31 catalyst, and 3.0 eq of Na₂CO₃ were placed in 6.6 mL of a solution in which 1,4-dioxane and H₂O were mixed in a ratio (e.g., amount) of 3:1, and then stirred at 100 °C for 12 hours to synthesize 11.7 g of Intermediate A1-b (yield: 95%).

### (2-3) Synthesis of Intermediate A1-c

11.7 g (1.0 eq) of Intermediate A1-b, 3.0 eq of 1-bromo-2-nitrobenzene, 0.02 eq of Pd₂(dba)₃, 0.04 eq of SPhos, and 1.6 eq of NaOtBu were placed in 10.9 mL of toluene and then stirred at 120 °C for 12 hours to synthesize 10.5 g of Intermediate A1-c (yield: 90%).

### (2-4) Synthesis of Intermediate A1

10.5 g (1.0 eq) of Intermediate A1-c, 3.0 eq of tin, and 5.0 eq of HCl were placed in 7.1 mL of EtOH and then stirred at 80 °C for 12 hours to synthesize 10.1 g of Intermediate A1 (yield: 96%).

### (3) Synthesis of Intermediate 1-d

7.1 g (1.0 eq) of Intermediate 1-c, 10.1 g of Intermediate A1, 0.02 eq of Pd₂(dba)₃, 0.04 eq of XPhos, and 1.6 eq of NaOtBu were placed in 8.3 mL of 1,4-dioxane and then stirred at 110 °C for 4 hours to synthesize 11 g of Intermediate 1-d (yield: 87%).

### (4) Synthesis of Intermediate 1-e

11 g (1.0 eq) of Intermediate 1-d and 1.2 eq of HCl were placed in 50.0 eq of HC(OEt)₃ and then stirred at 80 °C for 12 hours to synthesize 11.2 g of Intermediate 1-e (yield: 97%).

### (5) Synthesis of Intermediate 1-f

11.2 g (1.0 eq) of Intermediate 1-e and 3.0 eq of NH₄PF₆ were placed in 2.5 mL of a solution in which MeOH and H₂O were mixed in a ratio (e.g., amount) of 2:1, and then stirred at room temperature for 4 hours to synthesize 10.9 g of Intermediate 1-f (yield: 90%).

### (6) Synthesis of Intermediate 1-g

10.9 g of Intermediate 1-f was heated from 0 °C to room temperature under an oxygen (O₂) atmosphere, and concurrently (e.g., simultaneously), light of 313 nm was irradiated, to synthesize 5.7 g of Intermediate 1-g (yield: 53%).

### (7) Synthesis of Compound BD1

5.7 g (1.0 eq) of Intermediate 1-g, 1.1 eq of Pt(COD)Cl₂, and 3.0 eq of NaOAc were placed in 2.1 mL of 1,4-dioxane and then stirred at 120 °C for 48 hours to synthesize 4.2 g of Compound BD1 (yield: 75%).

### Synthesis Example 2: Synthesis of Compound BD17

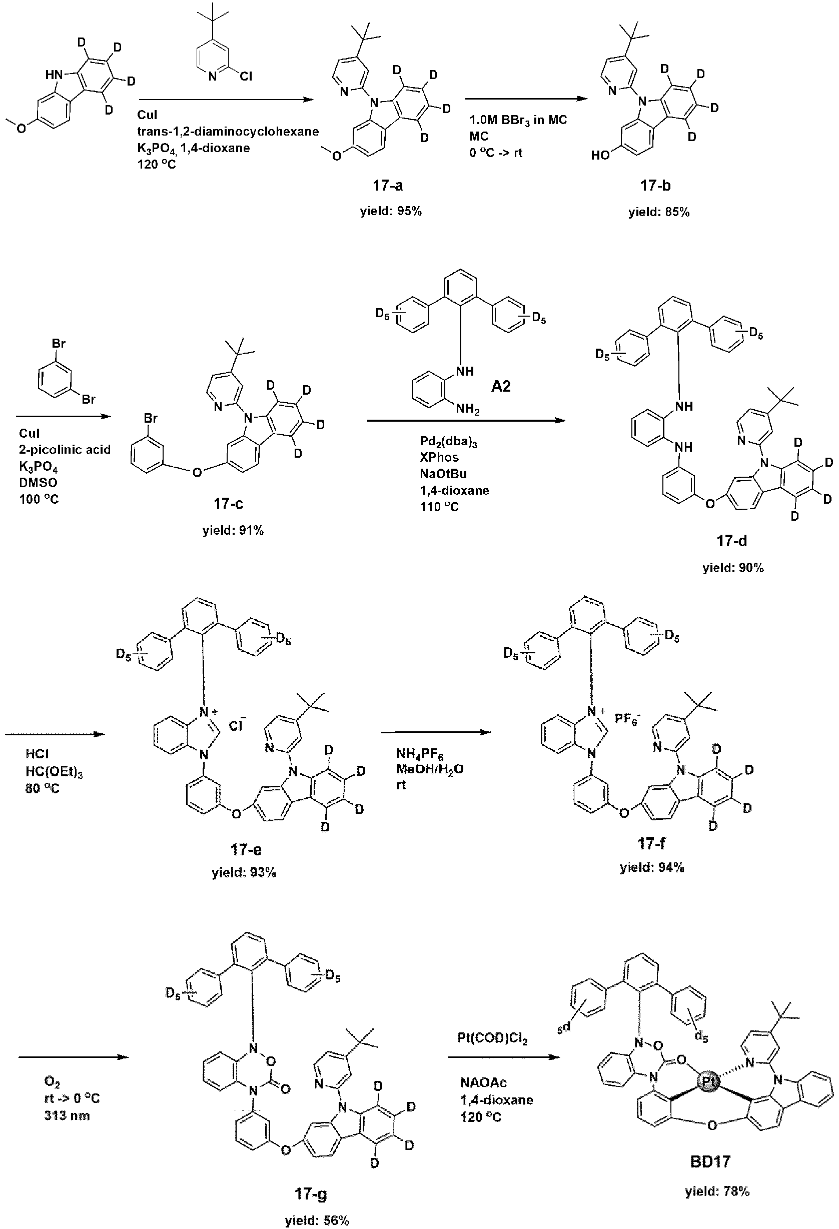

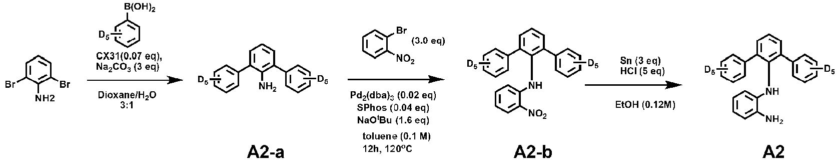

### (1) Synthesis of Intermediate 17-c

Intermediate 17-c was synthesized in substantially the same manner as in the synthesis of Intermediate 1-a to the synthesis of Intermediate 1-c of Synthesis Example 1.

### (2-1) Synthesis of Intermediate A2-a

10.3 g (1.0 eq) of 2,6-dibromoaniline, 2.0 eq of phenyl-d5-boronic acid, 0.07 eq of Umicore CX31 catalyst, and 3.0 eq of Na₂CO₃ were placed in 6.6 mL of solution in which 1,4-dioxane and H₂O were mixed in a ratio (e.g., amount) of 3:1, and then stirred at 100 °C for 12 hours to synthesize 9.8 g of Intermediate A2-a (yield: 95%).

### (2-2) Synthesis of Intermediate A2

Intermediate A2 was synthesized in substantially the same manner as in the synthesis of Intermediate A1-c and the synthesis of Intermediate A1 of Synthesis Example 1, except that 9.8 g (1.0 eq) of Intermediate A2-a was utilized instead of 11.7 g (1.0 eq) of Intermediate A1-b.

### (3) Synthesis of Compound BD17

Compound BD17 was synthesized in substantially the same manner as in the synthesis of Intermediate 1-d to the synthesis of Compound BD1 of Synthesis Example 1, except that 9.8 g of Intermediate A2 was utilized instead of 10.1 g of Intermediate A1 during the synthesis of Intermediate 17-d.

### Synthesis Example 3: Synthesis of Compound BD33

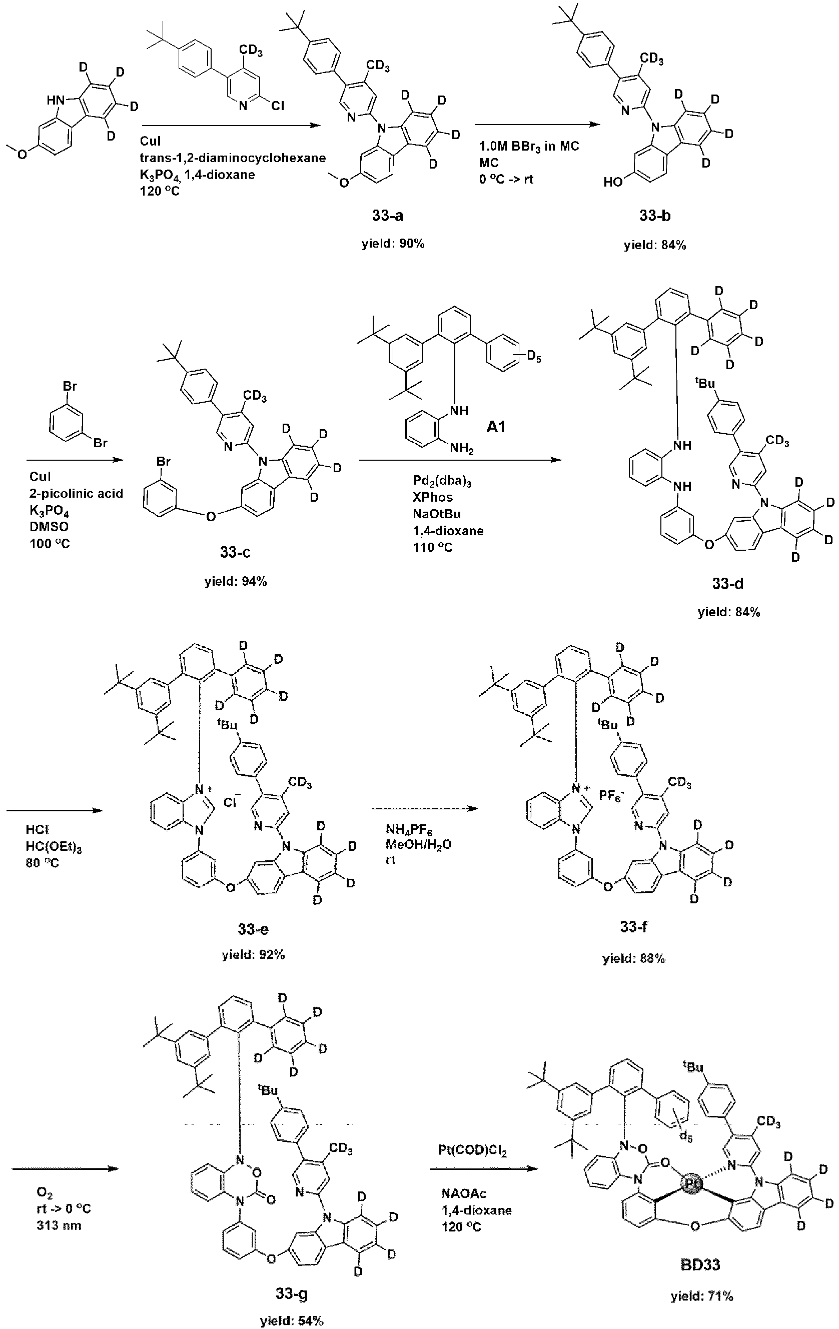

### (1) Synthesis of Intermediate 33-c

Intermediate 33-c was synthesized in substantially the same manner as in the synthesis of Intermediate 1-a to the synthesis of Intermediate 1-c of Synthesis Example 1, except that 1.0 eq of 5-(4-tert-butylphenyl)-2-chloro-4-(methyl-d3)pyridine was utilized instead of 1.0 eq of 4-tert-butyl-2-chloropyridine during the synthesis of Intermediate 1-a of Synthesis Example 1.

### (2) Synthesis of Compound BD33

Compound BD33 was synthesized in substantially the same manner as in the synthesis of Intermediate 1-d to the synthesis of Compound BD1 of Synthesis Example 1, except that 8.4 g (1.0 eq) of Intermediate 33-c was utilized instead of 7.1 g (1.0 eq) of Intermediate 1-c.

### Synthesis Example 4: Synthesis of Compound BD41

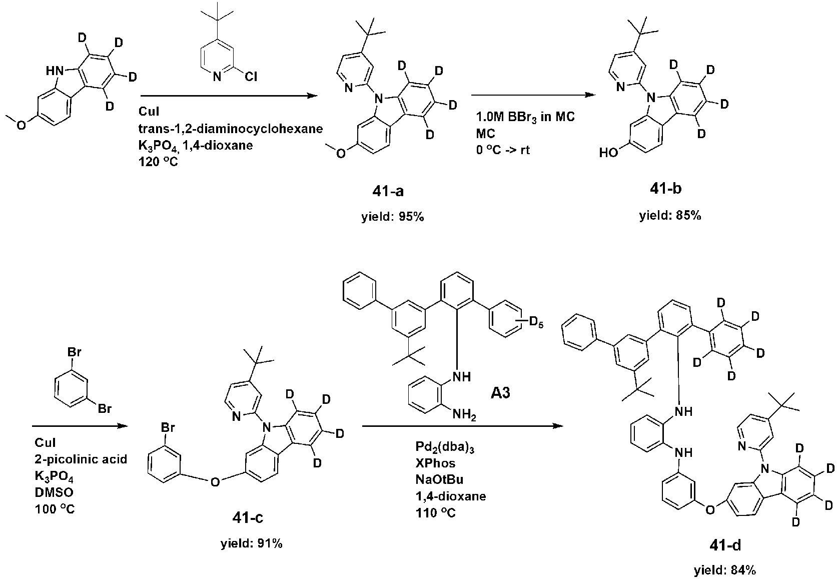

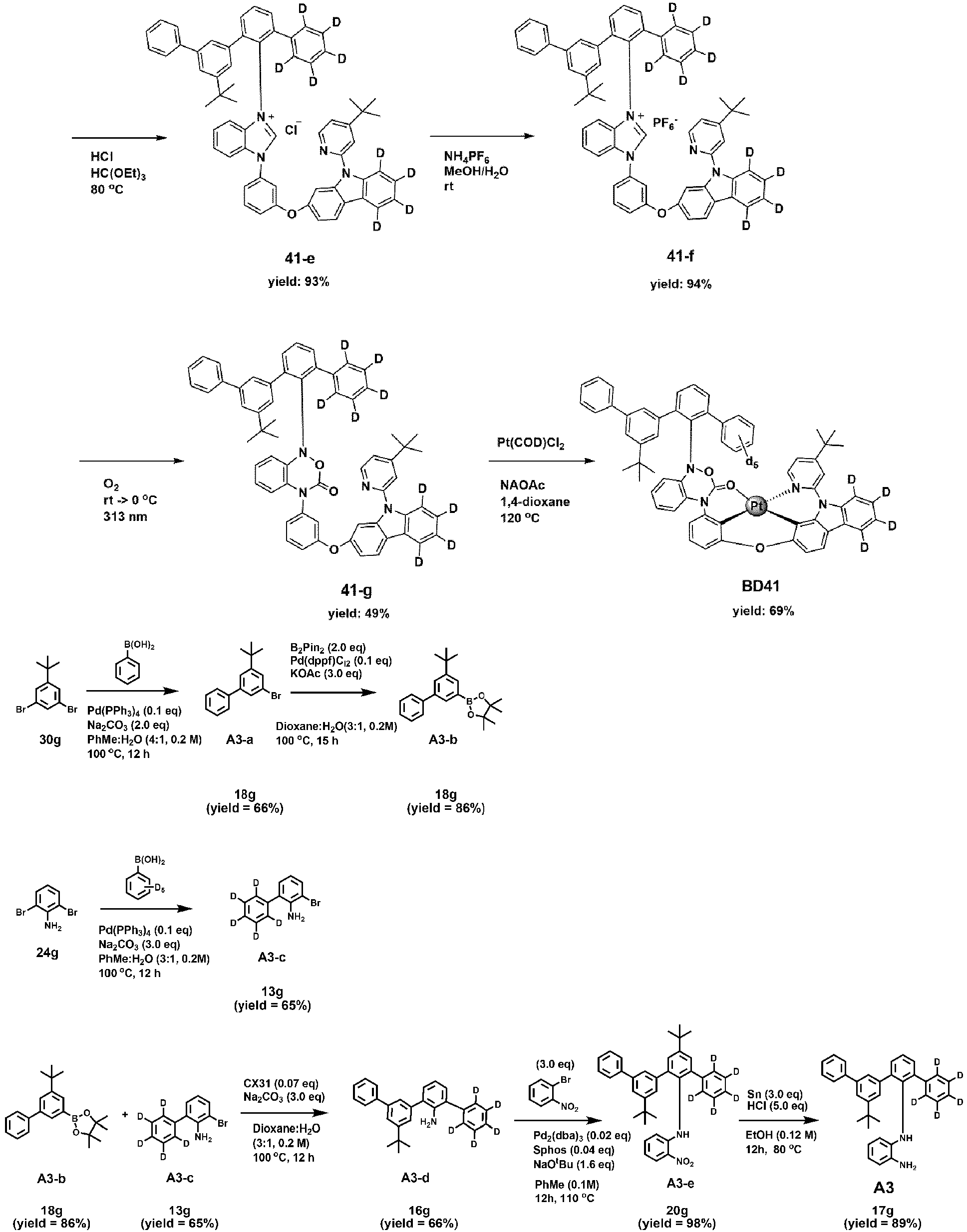

### (1) Synthesis of Intermediate 41-c

Intermediate 41-c was synthesized in substantially the same manner as in the synthesis of Intermediate 1-a to the synthesis of Intermediate 1-c of Synthesis Example 1.

### (2-1) Synthesis of Intermediate A3-a

30 g (1.0 eq) of 1,3-dibromo-5-tert-butylbenzene, 1.0 eq of phenylboronic acid, 0.1 eq of Pd(PPh₃)₄, and 2.0 eq of Na₂CO₃ were placed in 8.7 mL of a solution in which PhMe and H₂O were mixed in a ratio (e.g., amount) of 4:1, and then stirred at 100 °C for 12 hours to synthesize 18 g of Intermediate A3-a (yield: 66%).

### (2-2) Synthesis of Intermediate A3-b

18 g (1.0 eq) of Intermediate A3-a, 2.0 eq of bis pinacolato diboron (B₂Pin₂), 0.1 eq of Pd(dppf)Cl₂, and 3.0 eq of KOAc were placed in 6.6 mL of a solution in which 1,4-dioxane and H₂O were mixed in a ratio (e.g., amount) of 3:1, and then stirred at 100 °C for 15 hours to synthesize 18 g of Intermediate A3-b (yield: 86%).

### (2-3) Synthesis of Intermediate A3-c

24 g (1.0 eq) of 2,6-dibromoaniline, 1.0 eq of phenyl-d5-boronic acid, 0.1 eq of Pd(PPh₃)₄, and 3.0 eq of Na₂CO₃ were placed in 7.3 mL of a solution in which PhMe and H₂O were mixed in a ratio (e.g., amount) of 3:1, and then stirred at 100 °C for 12 hours to synthesize 13 g of Intermediate A3-c (yield: 65%).

### (2-4) Synthesis of Intermediate A3-d

18 g (1.0 eq) of Intermediate A3-b, 13 g of Intermediate A3-c, 0.07 eq of Umicore CX31 catalyst, and 3.0 eq of Na₂CO₃ were placed in 6.6 mL of a solution in which 1,4-dioxane and H₂O were mixed in a ratio (e.g., amount) of 3:1, and then stirred at 100 °C for 12 hours to synthesize 16 g of Intermediate A3-d (yield: 66%).

### (2-5) Synthesis of Intermediate A3

Intermediate A3 was synthesized in substantially the same manner as in the synthesis of Intermediate A1-c and the synthesis of Intermediate A1 of Synthesis Example 1, except that 16 g (1.0 eq) of Intermediate A3-d was utilized instead of 11.7 g (1.0 eq) of Intermediate A1-b, and during the synthesis of Intermediate A3-e, stirring was done at a temperature of 110 °C.

### (3) Synthesis of Compound BD41

Compound BD41 was synthesized in substantially the same manner as in the synthesis of Intermediate 1-d to the synthesis of Compound BD1 of Synthesis Example 1, except that 17 g of Intermediate A3 was utilized instead of 10.1 g of Intermediate A1 during the synthesis of Intermediate 41-d.

¹H NMR and MS/FAB of the compounds synthesized according to the Synthesis Examples are shown in Table 1. Synthesis methods of compounds other than the compounds synthesized in the Synthesis Examples may be easily recognized by those of ordinary skill in the art by referring to the synthesis paths and source materials.

**Table 1**

| Compound No. | ¹H NMR (CDCl₃ , 400 MHz) | MS/FAB | |
|---|---|---|---|
| | | found | calc. |
| BD1 | 8.74(d, 1H), 8.39(d, 1H), 8.20-8.19(m. 3H), 7.73(m, 2H), 7.61-7.50(m, 4H), 7.43-7.28(m, 9H), 7.20(m, 1H), 7.13-7.08(m, 4H), 6.84(m, 1H), 6.69(d, 1H), 2.87(m, 1H), 1.32(d, 18H), 1.20(d, 6H) | 1092.43 | 1093.26 |
| BD17 | 8.74(d, 1H), 8.39(d, 1H), 8.20-8.19(m, 3H), 7.61-7.58(m, 2H), 7.50-7.08(m, 20H), 6.84(m, 1H), 6.69(m, 1H), 1.32(d, 9H), | 991.31 | 992.05 |
| BD33 | 9.08(d, 1H), 8.39(d, 1H), 8.20-8.19(m, 3H), 7.73(m, 2H), 7.61-7.50(m, 5H), 7.43-7.28(m, 11H), 7.20(m, 1H), 7.13-7.08(m, 4H), 6.84(m, 1H), 6.69(m, 1H), 2.68(d, 3H), 1.33-1.32(d, 27H) | 1185.50 | 1186.40 |
| BD41 | 8.74(d, 1H), 8.39(d, 1H), 8.20-8.19(m, 3H), 8.03(m, 2H), 7.75-7.74(m, 3H), 7.61-7.58(m, 2H), 7.50-7.31(m, 13H), 7.20(m, 1H), 7.13-7.08(m, 4H), 6.84(m, 1H), 6.69(m, 1H), 1.32(d, 18H) | 1112.40 | 1113.25 |

### Evaluation Example 1

The HOMO energy level (eV), LUMO energy level (eV), T1 energy level (eV, nm), dipole moment size (Debye), and existence ratio of triplet metal-to-ligand charge transfer state (³MLCT) of Compounds BD1, BD17, BD33, BD41, CE1 and CE2 were evaluated by utilizing the DFT method of the Gaussian program which is structure-optimized at the B3LYP/6-311G(d,p) level. Results thereof are shown in Table 2.

**Table 2**

| Compound No. | HOMO (eV) | LUMO (eV) | T1 (eV) | T1 (nm) | Dipole (Debye) | ³MLCT (%) |
|---|---|---|---|---|---|---|
| BD1 | -4.95 | -1.58 | 2.79 | 445.19 | 6.77 | 13.83 |
| BD17 | -4.96 | -1.44 | 2.79 | 444.76 | 6.55 | 14.83 |
| BD33 | -4.95 | -1.36 | 2.77 | 447.65 | 6.94 | 14.99 |
| BD41 | -4.98 | -1.41 | 2.79 | 444.36 | 6.30 | 15.00 |
| CE1 | -4.88 | -1.50 | 2.66 | 466.57 | 8.05 | 12.90 |
| CE2 | -4.89 | -1.34 | 2.77 | 447.85 | 7.47 | 15.75 |

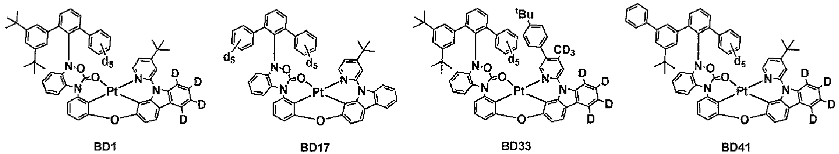

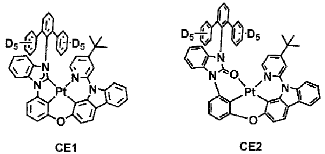

### Example 1

As an anode, a glass substrate with 15 ohm per square centimeter (Ω/cm²) 1,200 angstrom (Å) ITO formed thereon was cut to a size of 50 millimeter (mm) x 50 mm x 0.7 mm, sonicated with isopropyl alcohol and pure water each for 5 minutes, and then cleaned by irradiation of ultraviolet rays and exposure of ozone thereto for 30 minutes. The resultant glass substrate was loaded onto a vacuum deposition apparatus.

2-TNATA was vacuum-deposited on the anode to form a hole injection layer having a thickness of 600 Å, and NPB was vacuum-deposited on the hole injection layer to form a hole transport layer having a thickness of 300 Å.

Compound BD1, which is a dopant, and a host in which ETH2 and HTH2 were mixed in a weight ratio of 5:5, were co-deposited on the hole transport layer to form an emission layer having a thickness of 300 Å, wherein the ratio of the dopant to the emission layer was 10%, and the emission layer was a blue fluorescent emission layer. Subsequently, ETH2 was vacuum-deposited thereon to form a hole blocking layer having a thickness of 50 Å. Then, after Alq₃ was deposited on the emission layer to form an electron transport layer having a thickness of 300 Å, LiF, which is a halogenated alkali metal, was deposited on the electron transport layer to form an electron injection layer having a thickness of 10 Å, and Al was vacuum-deposited thereon to form a cathode electrode having a thickness of 3,000 Å, to thereby form an LiF/Al electrode, thereby completing the manufacture of an organic electroluminescent device.

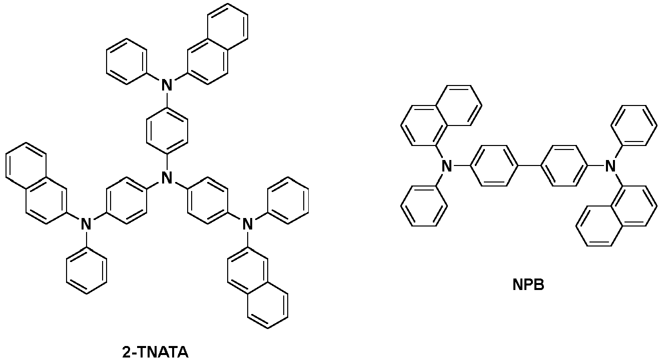

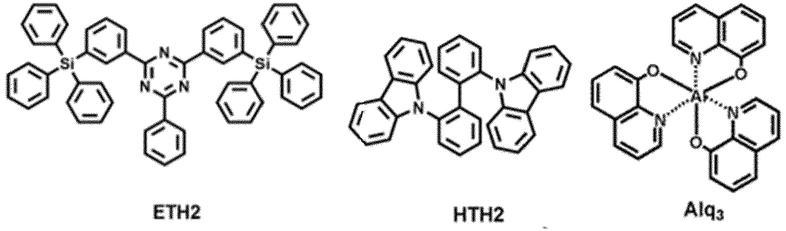

### Examples 2 to 4 and Comparative Examples 1 and 2

Organic light-emitting devices were manufactured in substantially the same manner as in Example 1, except that, in forming the emission layer, Compound BD1 was changed as shown in Table 3.

### Evaluation Example 2

The driving voltage (V) at 1,000 candela per square meter (cd/m²), efficiency (candela per ampere (cd/A)), maximum emission wavelength (nanometer (nm)), and lifespan (T₉₀) of the light-emitting devices manufactured in Examples 1 to 4 (ME-1 to ME-4) and Comparative Examples 1 and 2 (CE-1 to CE-2) were each measured by utilizing a Keithley MU 236 and a luminance meter PR650. Results thereof are shown in Table 3. In Table 3, the lifespan (T₉₀) is a measure of the time (h) taken for the luminance to reach 90 % of the initial luminance.

**Table 3**

| | Dopan t | Luminance (cd/m²) | Driving voltage (V) | Luminescence efficiency (cd/A) | Maximum emission wavelength (nm) | Lifespan (T₉₀, h) (at 1,000 cd/m²) |
|---|---|---|---|---|---|---|
| Example 1 | BD1 | 1000 | 4.4 | 22.4 | 461 | 98 |
| Example 2 | BD17 | 1000 | 4.5 | 22.6 | 460 | 100 |
| Example 3 | BD33 | 1000 | 4.5 | 23.2 | 462 | 102 |
| Example 4 | BD41 | 1000 | 4.4 | 22.4 | 459 | 99 |
| Comparative Example 1 | CE1 | 1000 | 4.7 | 16.8 | 462 | 65 |
| Comparative Example 2 | CE2 | 1000 | 4.6 | 20. 5 | 460 | 71 |

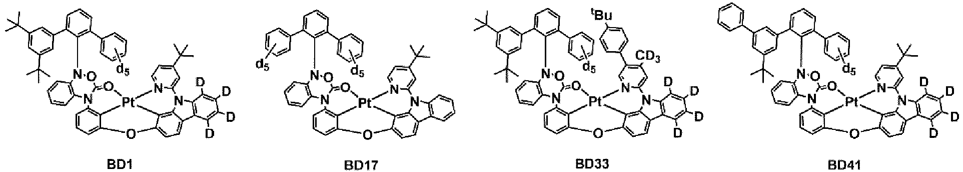

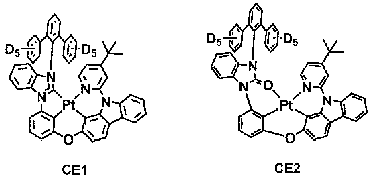

From Table 3, it may be confirmed that the organic light-emitting devices according to Examples 1 to 4 each had superior driving voltage, luminescence efficiency, and device lifespan to those of the organic light-emitting devices according to Comparative Examples 1 and 2.

A light-emitting device having reduced driving voltage and increased luminescence efficiency and lifespan and a high-quality electronic apparatus including the light-emitting device may be manufactured by utilizing the organometallic compound.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims.

## Claims

1. A light-emitting device comprising:
a first electrode (110);
a second electrode (150) facing the first electrode;
an interlayer (130) arranged between the first electrode and the second electrode and comprising an emission layer; and
an organometallic compound represented by Formula 1: 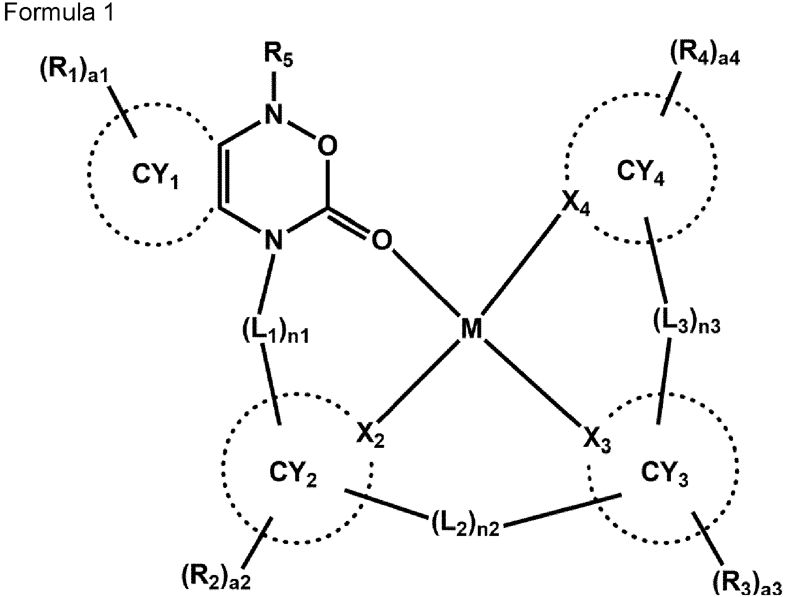 wherein, in Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₂ to X₄ are each independently C or N,
rings CY₁ to CY₄ are each independently a C₅-C₃₀ carbocyclic group or a C₁-C₃₀ heterocyclic group,
L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom,
n1 to n3 are each independently an integer from 1 to 5,
R₁ to R₅, R₁ₐ, and R_{1b} are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₁-C₆₀ alkylthio group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 to a4 are each independently an integer from 1 to 20,
two or more neighboring groups of R₁ to R₅ are optionally bonded together to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -CI, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

2. The light-emitting device of claim 1, wherein the emission layer comprises a host and a dopant, and
the dopant comprises the organometallic compound.

3. The light-emitting device of claim 1 or claim 2, further comprising a second compound comprising at least one π electron-deficient nitrogen-containing C₁-C₆₀ heterocyclic group, a third compound comprising a group represented by Formula 3, a fourth compound capable of emitting delayed fluorescence, or any combination thereof,
wherein the organometallic compound, the second compound, the third compound, and the fourth compound are different from each other: 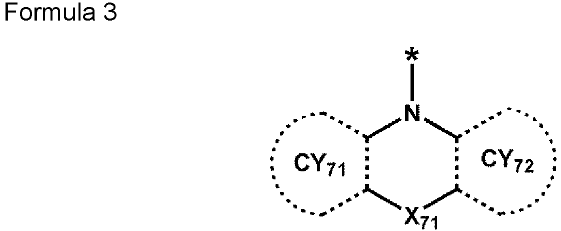 wherein, in Formula 3,
ring CY₇₁ and ring CY₇₂ are each independently a π electron-rich C₃-C₆₀ cyclic group or a pyridine group,
X₇₁ is a single bond, or a linking group comprising O, S, N, B, C, Si, or any combination thereof, and
* indicates a binding site to any atom included in a remaining part other than Formula 3 in the third compound.

4. The light-emitting device of claim 3, wherein the second compound comprises a pyridine group, a pyrimidine group, a pyrazine group, a pyridazine group, a triazine group, or any combination thereof, and
the fourth compound comprises at least one cyclic group comprising boron (B) and nitrogen (N) as ring-forming atoms.

5. The light-emitting device of claim 3, wherein the emission layer comprises:
i) the organometallic compound; and
ii) the second compound, the third compound, the fourth compound, or any combination thereof, and
the emission layer is configured to emit blue light.

6. An electronic apparatus comprising the light-emitting device of any one of claims 1 to 5.

7. The electronic apparatus of claim 6, further comprising a thin-film transistor,
wherein the thin-film transistor comprises a source electrode and a drain electrode, and
the first electrode of the light-emitting device is electrically connected to the source electrode of the thin-film transistor or the drain electrode of the thin-film transistor.

8. The electronic apparatus of claim 6, further comprising a color filter, a color conversion layer, a touch screen layer, a polarizing layer, or any combination thereof.

9. An electronic equipment comprising the light-emitting device of any one of claims 1 to 5.

10. The electronic equipment of claim 9, wherein the electronic equipment is at least one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, a signboard, and combinations thereof.

11. An organometallic compound represented by Formula 1: 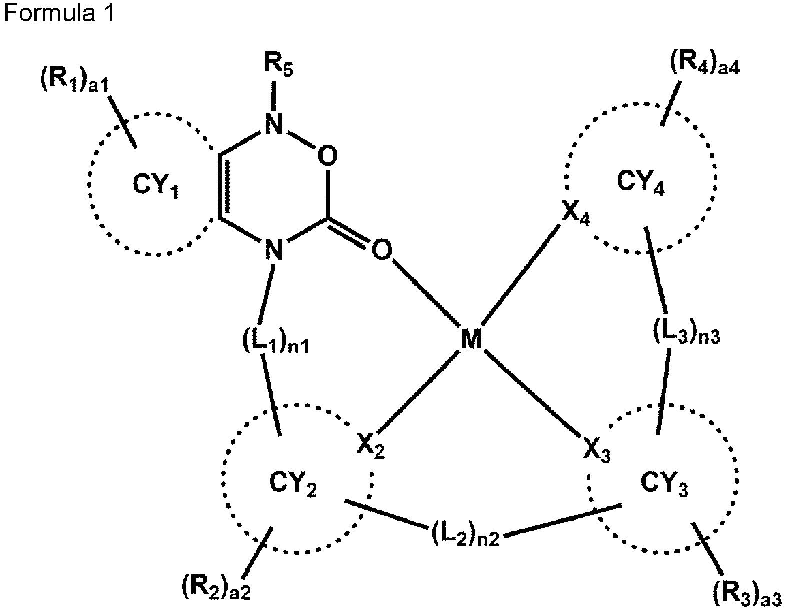 wherein, in Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₂ to X₄ are each independently C or N,
rings CY₁ to CY₄ are each independently a C₅-C₃₀ carbocyclic group or a C₁-C₃₀ heterocyclic group,
L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom, n1 to n3 are each independently an integer from 1 to 5,
R₁ to R₅, R₁ₐ, and R_{1b} are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₁-C₆₀ alkylthio group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 to a4 are each independently an integer from 1 to 20,
two or more neighboring groups of R₁ to R₅ are optionally bonded together to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₁₀ₐ is:
deuterium -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -CI, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -CI, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

12. The organometallic compound of claim 11, wherein M is platinum (Pt),
X₂ and X₃ are each C, and X₄ is N,
a bond between X₂ and M and a bond between X₃ and M are each a covalent bond, and a bond between X₄ and M is a coordinate bond.

13. The organometallic compound of claim 11 or claim 12, wherein rings CY₁ to CY₄ are each independently a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodihydrodisiline group, a dibenzodihydrosiline group, a dibenzodioxine group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group.

14. The organometallic compound any one of claims 11 to 13, wherein R₁ to R₅ are each independently:
hydrogen, deuterium, a cyano group, or a C₁-C₂₀ alkyl group;
a C₁-C₂₀ alkyl group that is substituted with deuterium, -CD₃, -CD₂H, -CDH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -CD₃, -CD₂H, -CDH₂, a cyano group, a C₁-C₂₀ alkyl group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, -Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ are each independently: hydrogen; deuterium; a cyano group; a C₁-C₆₀ alkyl group; a C₂-C₆₀ alkenyl group; a C₂-C₆₀ alkynyl group; or a C₃-C₆₀ carbocyclic group that is unsubstituted or substituted with deuterium, a cyano group, a C₁-C₆₀ alkyl group, a phenyl group, a biphenyl group, or any combination thereof.

15. The organometallic compound of any one of claims 11 to 14, wherein R₅ is a group represented by Formula 1-1: 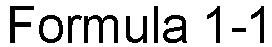 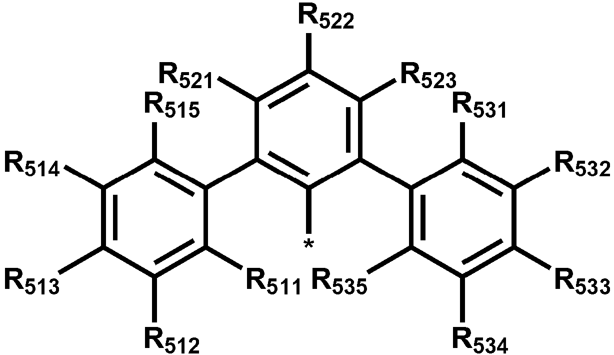 wherein, in Formula 1-1,
R₅₁₁ to R₅₁₅, R₅₂₁ to R₅₂₃, and R₅₃₁ to R₅₃₅ are each as described in connection with R₅ in Formula 1, and
* indicates a binding site to N in Formula 1.

16. The organometallic compound of any one of claims 11 to 15, wherein: in Formula 1, a group represented by 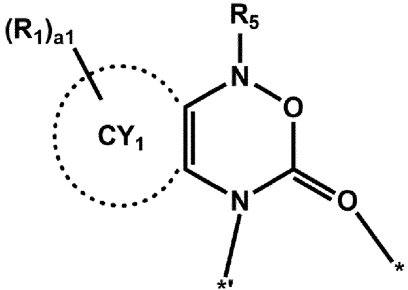 is selected from groups represented by Formulae CY1-1 to CY1-14: 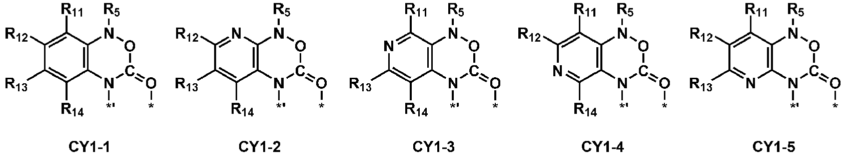 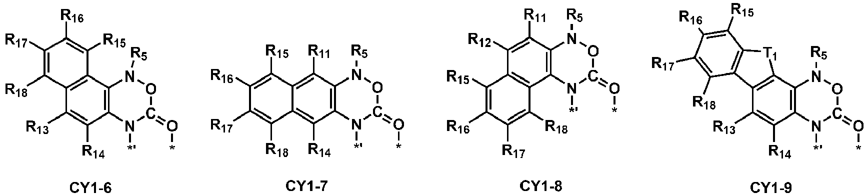 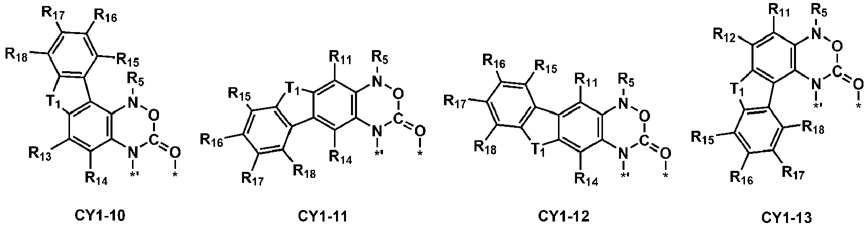 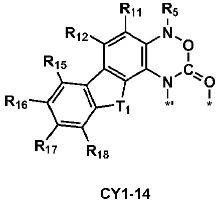 and, wherein, in Formulae CY1-1 to CY1-14,
T₁ is C(Y₁₁)(Y₁₂), N(Y₁₁), O, S, or Si(Y₁₁)(Y₁₂),
Y₁₁ and Y₁₂ are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₁-C₆₀ alkylthio group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
R₁₀ₐ and Q₁ to Q₃ are each as described in Formula 1,
R₁₁ to R₁₈ are each as described in connection with R₁ in Formula 1,
R₅ is as described in Formula 1,
* indicates a binding site to M in Formula 1, and
*' indicates a binding site to L₁ in Formula 1.

17. The organometallic compound of any one of claims 11 to 16, wherein, in Formula 1, a group represented by 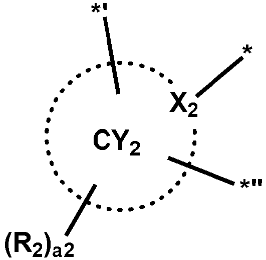 is selected from groups represented by Formulae CY2-1 to CY2-16: 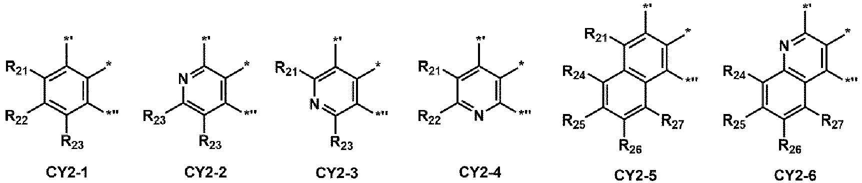 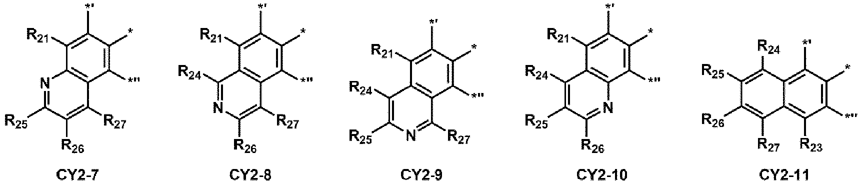 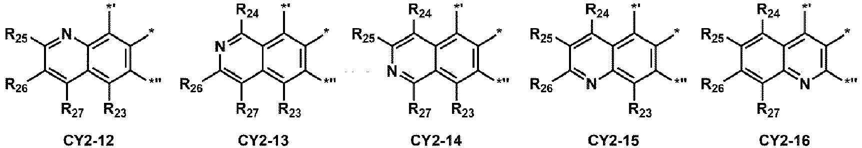 and, wherein, in Formulae CY2-1 to CY2-16,
R₂₁ to R₂₇ are each as described in connection with R₂ in Formula 1,
* indicates a binding site to M in Formula 1,
*' indicates a binding site to L₁ in Formula 1, and
*" indicates a binding site to L₂ in Formula 1.

18. The organometallic compound of any one of claims 11 to 17, wherein, in Formula 1, a group represented by 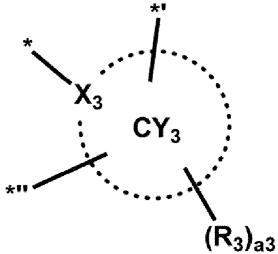 is selected from groups represented by Formulae CY3-1 to CY3-16: 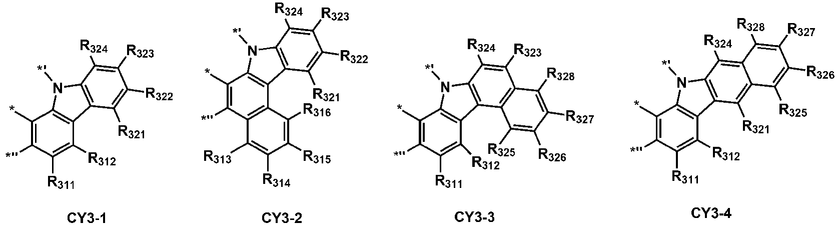 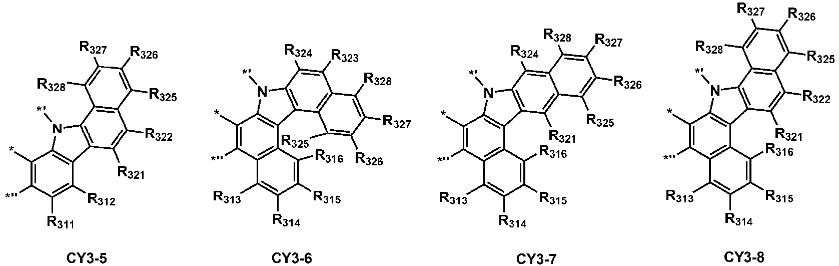 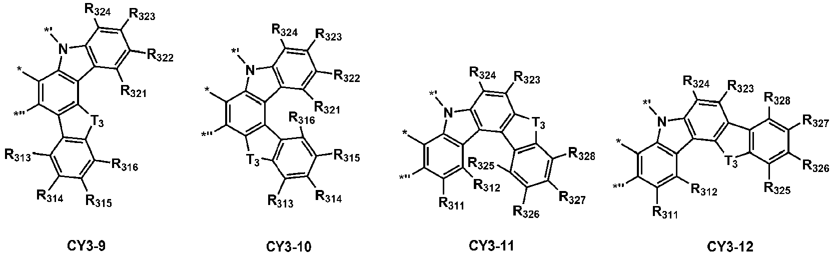 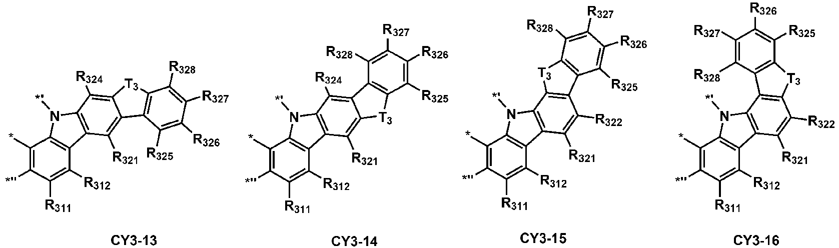 and, wherein, in Formulae CY3-1 to CY3-16,
T₃ is C(Y₃₁)(Y₃₂), N(Y₃₁), O, S, or Si(Y₃₁)(Y₃₂),
Y₃₁ and Y₃₂ are each independently hydrogen, deuterium, -F, -CI, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₁-C₆₀ alkylthio group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
R₁₀ₐ and Q₁ to Q₃ are each as described in Formula 1,
R₃₁₁ to R₃₁₆ and R₃₂₁ to R₃₂₈ are each as described in connection with R₃ in Formula 1,
* indicates a binding site to M in Formula 1,
*' indicates a binding site to L₃ in Formula 1, and
*" indicates a binding site to L₂ in Formula 1.

19. The organometallic compound of any one of claims 11 to 18, wherein, in Formula 1, a group represented by 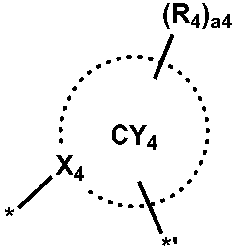 is selected from groups represented by Formulae CY4-1 to CY4-19: 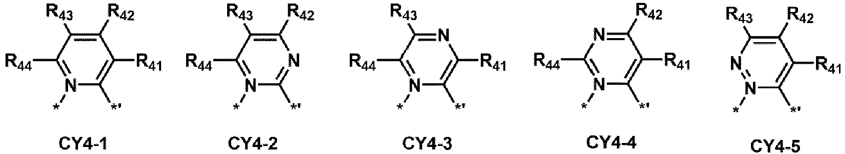 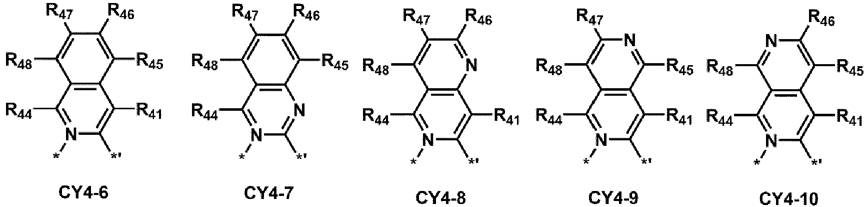 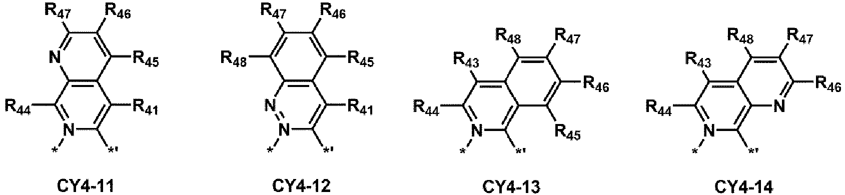 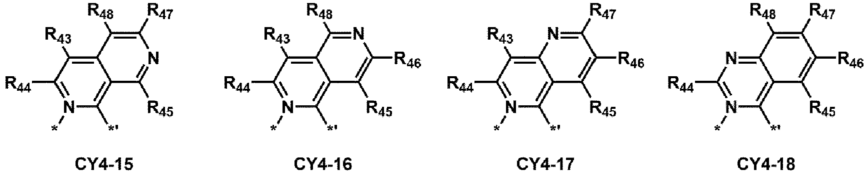 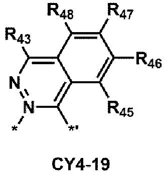 and, wherein, in Formulae CY4-1 to CY4-19,
R₄₁ to R₄₈ are each as described in connection with R₄ in Formula 1,
* indicates a binding site to M in Formula 1, and
*' indicates a binding site to L₃ in Formula 1.

20. The organometallic compound of claim 11, wherein the organometallic compound represented by Formula 1 is represented by Formula 1-2: 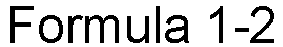 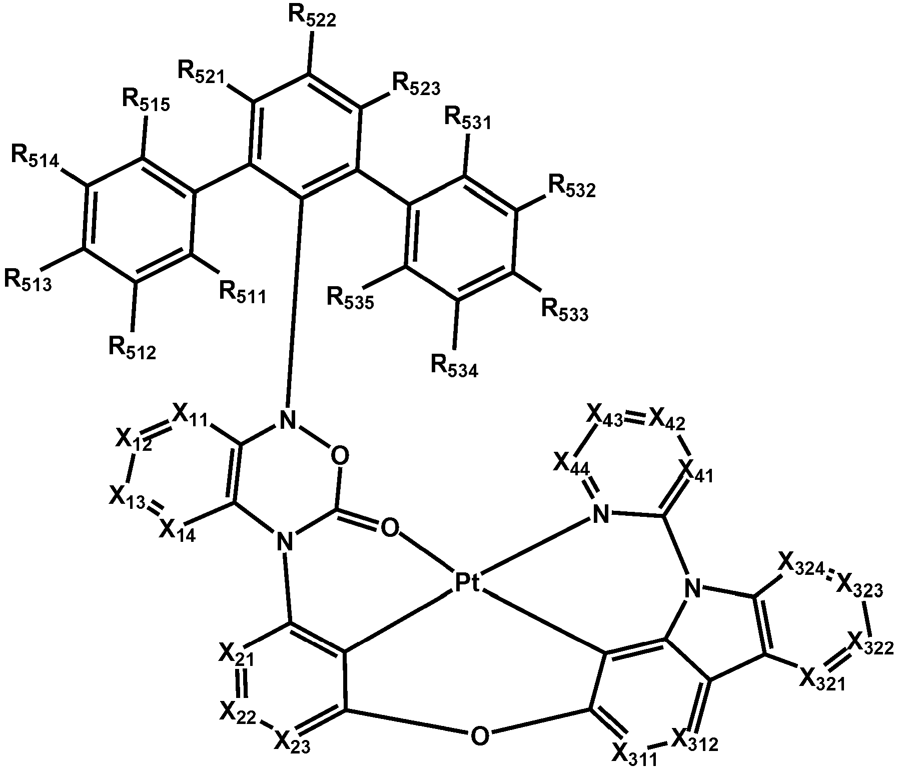 and, wherein, in Formula 1-2,
X₁₁ is C(R₁₁) or N, X₁₂ is C(R₁₂) or N, X₁₃ is C(R₁₃) or N, and X₁₄ is C(R₁₄) or N,
X₂₁ is C(R₂₁) or N, X₂₂ is C(R₂₂) or N, and X₂₃ is C(R₂₃) or N,
X₃₁₁ is C(R₃₁₁) or N, X₃₁₂ is C(R₃₁₂) or N, X₃₂₁ is C(R₃₂₁) or N, X₃₂₂ is C(R₃₂₂) or N, X₃₂₃ is C(R₃₂₃) or N, and X₃₂₄ is C(R₃₂₄) or N,
X₄₁ is C(R₄₁) or N, X₄₂ is C(R₄₂) or N, X₄₃ is C(R₄₃) or N, and X₄₄ is C(R₄₄) or N,
R₁₁ to R₁₄ are each as described in connection with R₁ in Formula 1,
R₂₁ to R₂₃ are each as described in connection with R₂ in Formula 1,
R₃₁₁, R₃₁₂, and R₃₂₁ to R₃₂₄ are each as described in connection with R₃ in Formula,
R₄₁ to R₄₄ are each as described in connection with R₄ in Formula 1,
R₅₁₁ to R₅₁₅, R₅₂₁ to R₅₂₃, and R₅₃₁ to R₅₃₅ are each as described in connection with R₅ in Formula 1, and
two or more neighboring groups of R₁₁ to R₁₄, R₂₁ to R₂₃, R₃₁₁, R₃₁₂, R₃₂₁ to R₃₂₄, R₄₁ to R₄₄, R₅₁₁ to R₅₁₅, R₅₂₁ to R₅₂₃, and R₅₃₁ to R₅₃₅ are optionally bonded together to form a C₃-C₆₀ carbocyclic group that is unsubstituted or substituted with at least one R₁₀ₐ or a C₁-C₆₀ heterocyclic group that is unsubstituted or substituted with at least one R₁₀ₐ.

## Patentansprüche

1. Lichtemittierende Vorrichtung, umfassend:
eine erste Elektrode (110);
eine zweite Elektrode (150), die der ersten Elektrode zugewandt ist;
eine Zwischenschicht (130), die zwischen der ersten Elektrode und der zweiten Elektrode angeordnet ist und eine Emissionsschicht umfasst; und
eine organometallische Verbindung, dargestellt durch Formel 1: 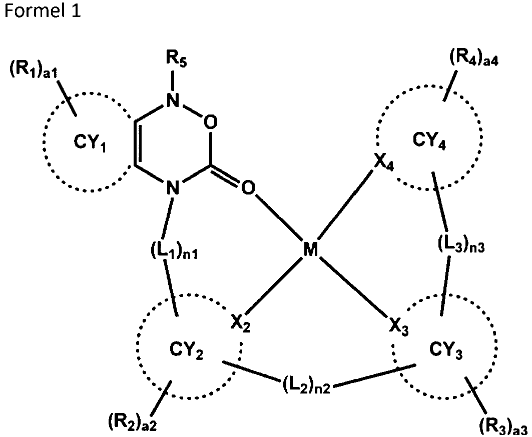 wobei in Formel 1
M Platin (Pt), Palladium (Pd), Kupfer (Cu), Silber (Ag), Gold (Au), Rhodium (Rh), Ruthenium (Ru), Osmium (Os), Titan (Ti), Zirkonium (Zr), Hafnium (Hf), Europium (Eu), Terbium (Tb) oder Thulium (Tm) ist,
X₂ bis X₄ jeweils unabhängig C oder N sind,
Ringe CY₁ bis CY₄ jeweils unabhängig eine carbocyclische C₅-C₃₀-Gruppe oder eine heterocyclische C₁-C₃₀-Gruppe sind,
L₁ bis L₂ jeweils unabhängig eine Einfachbindung, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ )-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*' oder *-Ge(R₁ₐ)(R_{1b})-*' sind und *und *' jeweils eine Bindungsstelle zu einem benachbarten Atom anzeigt,
n1 bis n3 jeweils unabhängig voneinander ganze Zahlen von 1 bis 5 sind,
R₁ bis R₅, R₁ₐ und R_{1b} jeweils unabhängig voneinander Wasserstoff, Deuterium, -F, - Cl, -Br, -I, eine Hydroxylgruppe, eine Cyanogruppe, eine Nitrogruppe, eine C₁-C₆₀-Alkylgruppe, die unsubstituiert oder mit mindestens einem R₁₀ₐ substituiert ist, eine C₂-C₆₀-Alkenylgruppe, die unsubstituiert oder mit mindestens einem R₁₀ₐ substituiert ist, eine C₂-C₆₀-Alkinylgruppe, die unsubstituiert oder mit mindestens einem R₁₀ₐ substituiert ist, eine C₁₋C₆₀-Alkoxygruppe, die unsubstituiert oder mit mindestens einem R₁₀ₐ substituiert ist, eine C₁-C₆₀-Alkylthiogruppe, die unsubstituiert oder mit mindestens einem R₁₀ₐ substituiert ist, oder eine C₃-C₆₀ carbocyclische Gruppe, die unsubstituiert oder mit mindestens einem R₁₀ₐ substituiert ist, eine C₁-C₆₀ heterocyclische Gruppe, die unsubstituiert ist oder mit mindestens einem R₁₀ₐ substituiert ist, eine C₆-C₆₀-Aryloxygruppe, die unsubstituiert ist oder mit mindestens einem R₁₀ₐ substituiert ist, eine C₆-C₆₀-Arylthiogruppe, die unsubstituiert ist oder mit mindestens einem R₁₀ₐ substituiert ist, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), oder - P(=O)(Q₁)(Q₂) sind,
a1 bis a4 jeweils unabhängig voneinander ganze Zahlen von 1 bis 20 sind,
zwei oder mehr benachbarte Gruppen von R₁ bis R₅ optional miteinander verbunden sind, um eine C₃-C₆₀ carbocyclische Gruppe, die unsubstituiert oder mit mindestens einem R₁₀ₐ substituiert ist, oder eine C₁-C₆₀ heterocyclische Gruppe, die unsubstituiert oder mit mindestens einem R₁₀ₐsubstituiert ist, zu bilden,
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁₋C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂) oder einer Kombination davon;
eine carbocyclische C₃-C₆₀-Gruppe, eine heterocyclische C₁-C₆₀-Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁₋C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder - P(=O)(Q₃₁)(Q₃₂) und
wobei Q₁ bis Q₃, Q₁₁ bis Q₁₃, Q₂₁ bis Q₂₃und Q₃₁ bis Q₃₃ jeweils unabhängig sind: Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe; oder eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁₋C₆₀-Alkoxygruppe, einer Phenylgruppe, einer Biphenylgruppe oder einer Kombination davon sind.

2. Lichtemittierende Vorrichtung nach Anspruch 1, wobei die Emissionsschicht ein Wirtsmaterial und einen Dotierstoff umfasst und
der Dotierstoff die organometallische Verbindung umfasst.

3. Lichtemittierende Vorrichtung nach Anspruch 1 oder Anspruch 2, ferner umfassend eine zweite Verbindung, die mindestens eine π-elektronenarme, stickstoffhaltige C₁-C₆₀ heterocyclische Gruppe umfasst, eine dritte Verbindung, die eine durch Formel 3 dargestellte Gruppe umfasst, eine vierte Verbindung, die zur Emission verzögerter Fluoreszenz fähig ist, oder eine Kombination davon,
wobei die organometallische Verbindung, die zweite Verbindung, die dritte Verbindung und die vierte Verbindung sich voneinander unterscheiden: 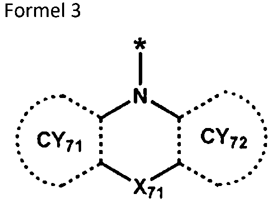 wobei in Formel 3
Ring CY₇₁ und Ring CY₇₂ jeweils unabhängig voneinander eine πelektronenreiche C₃-C₆₀ cyclische Gruppe oder eine Pyridin-Gruppe sind,
X₇₁ eine Einfachbindung oder eine Verbindungsgruppe ist, die O, S, N, B, C, Si oder eine Kombination davon umfasst, und
* eine Bindungsstelle für jedes Atom bezeichnet, das in einem verbleibenden Teil außer Formel 3 in der dritten Verbindung beinhaltet ist.

4. Lichtemittierende Vorrichtung nach Anspruch 3, wobei die zweite Verbindung eine Pyridingruppe, Pyrimidingruppe, Pyrazingruppe, Pyridazingruppe oder Triazingruppe oder eine beliebige Kombination davon umfasst, und
die vierte Verbindung mindestens eine cyclische Gruppe umfasst, die Bor (B) und Stickstoff (N) als ringbildende Atome umfasst.

5. Lichtemittierende Vorrichtung nach Anspruch 3, wobei die Emissionsschicht Folgendes umfasst:
i) die organometallische Verbindung; und
ii) die zweite Verbindung, die dritte Verbindung, die vierte Verbindung oder eine Kombination davon, und
die Emissionsschicht so konfiguriert ist, dass sie blaues Licht emittiert.

6. Elektronische Einrichtung, umfassend die lichtemittierende Vorrichtung nach einem der Ansprüche 1 bis 5.

7. Elektronische Vorrichtung nach Anspruch 6, ferner umfassend einen Dünnschichttransistor,
wobei der Dünnschichttransistor eine Source-Elektrode und eine Drain-Elektrode umfasst und
die erste Elektrode der lichtemittierenden Vorrichtung elektrisch mit der Source-Elektrode des Dünnschichttransistors oder der Drain-Elektrode des Dünnschichttransistors verbunden ist.

8. Elektronische Vorrichtung nach Anspruch 6, ferner umfassend einen Farbfilter, eine Farbumwandlungsschicht, eine Touchscreen-Schicht, eine Polarisationsschicht oder eine Kombination davon.

9. Elektronisches Gerät, umfassend die lichtemittierende Vorrichtung nach einem der Ansprüche 1 bis 5.

10. Elektronisches Gerät nach Anspruch 9, wobei das elektronische Gerät mindestens eines ist, ausgewählt aus einem Flachbildschirm, einem gekrümmten Bildschirm, einem Computermonitor, einem medizinischen Monitor, einem Fernseher, einer Werbetafel, einer Innen- oder Außenbeleuchtung und/oder einem Lichtsignal, einem Head-up-Display, einem vollständig oder teilweise transparenten Display, einem flexiblen Display, einem rollbaren Display, einem faltbaren Display, einem dehnbaren Display, einem Laserdrucker, einem Telefon, einem Mobiltelefon, einem Tablet-PC, einem Phablet, einem persönlichen digitalen Assistenten (PDA), einer tragbaren Vorrichtung, einem Laptop, einer Digitalkamera, einem Camcorder, einem Sucher, einem Mikrodisplay, einem dreidimensionalen, (3D)-, Display, einem Virtual-Reality- oder Augmented-Reality-Display, einem Fahrzeug, einer Videowand mit mehreren zusammengefügten Displays, einer Theater- oder Stadionleinwand, einer Phototherapievorrichtung, einem Schild und Kombinationen davon.

11. Organometallische Verbindung, dargestellt durch Formel 1: 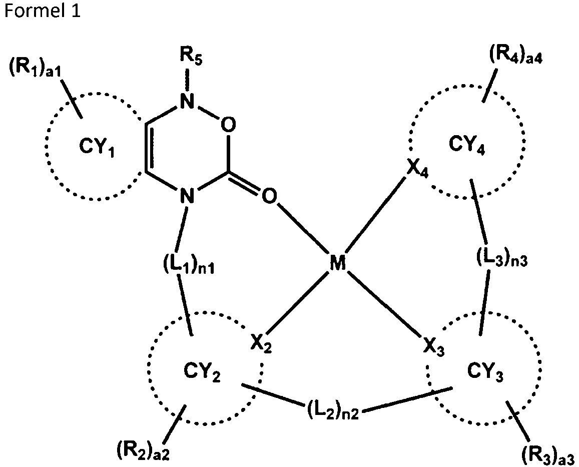 wobei in Formel 1
M Platin (Pt), Palladium (Pd), Kupfer (Cu), Silber (Ag), Gold (Au), Rhodium (Rh), Ruthenium (Ru), Osmium (Os), Titan (Ti), Zirkonium (Zr), Hafnium (Hf), Europium (Eu), Terbium (Tb) oder Thulium (Tm) ist,
X₂ bis X₄ jeweils unabhängig C oder N sind,
Ringe CY₁ bis CY₄ jeweils unabhängig eine carbocyclische C₅-C₃₀-Gruppe oder eine heterocyclische C₁-C₃₀-Gruppe sind,
L₁ bis L₃ jeweils unabhängig eine Einfachbindung, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *- O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂- *' oder *-Ge(R₁ₐ)(R_{1b})-*', sind und *und *' jeweils eine Bindungsstelle zu einem benachbarten Atom anzeigen,
n1 bis n3 jeweils unabhängig voneinander ganze Zahlen von 1 bis 5 sind,
R₁ bis R₅, R₁ₐund R_{1b} jeweils unabhängig voneinander Wasserstoff, Deuterium, -F, - Cl, -Br, -I, eine Hydroxylgruppe, eine Cyanogruppe, eine Nitrogruppe, eine C₁-C₆₀-Alkylgruppe, die unsubstituiert oder mit mindestens einem R₁₀ₐ substituiert ist, eine C₂-C₆₀-Alkenylgruppe, die unsubstituiert oder mit mindestens einem R₁₀ₐ substituiert ist, eine C₂-C₆₀-Alkinylgruppe, die unsubstituiert oder mit mindestens einem R₁₀ₐ substituiert ist, eine C₁₋C₆₀-Alkoxygruppe, die unsubstituiert oder mit mindestens einem R₁₀ₐ substituiert ist, eine C₁-C₆₀-Alkylthiogruppe, die unsubstituiert oder mit mindestens einem R₁₀ₐ substituiert ist, oder eine C₃-C₆₀ carbocyclische Gruppe, die unsubstituiert oder mit mindestens einem R₁₀ₐ substituiert ist, eine C₁-C₆₀ heterocyclische Gruppe, die unsubstituiert ist oder mit mindestens einem R₁₀ₐ substituiert ist, eine C₆-C₆₀-Aryloxygruppe, die unsubstituiert ist oder mit mindestens einem R₁₀ₐ substituiert ist, eine C₆-C₆₀-Arylthiogruppe, die unsubstituiert ist oder mit mindestens einem R₁₀ₐ substituiert ist, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁) oder - P(=O)(Q₁)(Q₂) sind,
a1 bis a4 jeweils unabhängig voneinander ganze Zahlen von 1 bis 20 sind,
zwei oder mehr benachbarte Gruppen von R₁ bis R₅ optional miteinander verbunden sind, um eine C₃-C₆₀ carbocyclische Gruppe, die unsubstituiert oder mit mindestens einem R₁₀ₐ substituiert ist, oder eine C₁-C₆₀ heterocyclische Gruppe, die unsubstituiert oder mit mindestens einem R₁₀ₐsubstituiert ist, zu bilden,
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁₋C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂) oder einer Kombination davon;
eine carbocyclische C₃-C₆₀-Gruppe, eine heterocyclische C₁-C₆₀-Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁₋C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder-P(=O)(Q₃₁)(Q₃₂) und
wobei Q₁ bis Q₃, Q₁₁ bis Q₁₃, Q₂₁ bis Q₂₃und Q₃₁ bis Q₃₃ jeweils unabhängig sind: Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe; oder eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁₋C₆₀-Alkoxygruppe, einer Phenylgruppe, einer Biphenylgruppe oder einer Kombination davon sind.

12. Organometallische Verbindung nach Anspruch 11, wobei M Platin (Pt) ist,
X₂ und X₃ jeweils C sind und X₄ N ist,
eine Bindung zwischen X₂ und M und eine Bindung zwischen X₃ und M jeweils eine kovalente Bindung sind und eine Bindung zwischen X₄ und M eine koordinative Bindung ist.

13. Organometallische Verbindung nach Anspruch 11 oder 12, wobei Ringe CY₁ bis CY₄ jeweils unabhängig voneinander eine Benzolgruppe, eine Naphthalingruppe, eine Anthracengruppe, eine Phenanthrengruppe, eine Triphenylengruppe, eine Pyrengruppe, eine Chrysengruppe, eine Cyclopentadiengruppe, eine Furangruppe, eine Thiophengruppe, eine Silolgruppe, eine Indengruppe, eine Fluorengruppe, eine Indolgruppe, eine Carbazolgruppe, eine Benzofurangruppe, eine Dibenzofurangruppe, eine Benzothiophengruppe, eine Dibenzothiophengruppe, eine Benzosilolgruppe, eine Dibenzosilolgruppe, eine Azafluorengruppe, eine Azacarbazolgruppe, eine Azadibenzofurangruppe, eine Azadibenzothiophengruppe, eine Azadibenzosilolgruppe, eine Pyridingruppe, eine Pyrimidingruppe, eine Pyrazingruppe, Pyridazingruppe, Triazingruppe, Chinolingruppe, Isochinolingruppe, Chinoxalingruppe, Chinazolingruppe, Phenanthrolingruppe, Pyrrolgruppe, Pyrazolgruppe, Imidazolgruppe, Triazolgruppe, Oxazolgruppe, Isoxazolgruppe, Thiazolgruppe, Isothiazolgruppe, Oxadiazolgruppe, Thiadiazolgruppe, Benzopyrazolgruppe, Benzimidazolgruppe, Benzoxazolgruppe, Benzothiazolgruppe, Benzoxadiazolgruppe, Benzothiadiazolgruppe, Dibenzooxasilingruppe, Dibenzothiasilingruppe, Dibenzodihydroazasilingruppe, Dibenzodihydrodihydrodisilingruppe, Dibenzodihydrosilingruppe, Dibenzodioxingruppe, Dibenzooxathiingruppe, Dibenzooxazingruppe, eine Dibenzopyrangruppe, eine Dibenzodithiingruppe, eine Dibenzothiazingruppe, eine Dibenzothiopyrangruppe, eine Dibenzocyclohexadiengruppe, eine Dibenzodihydropyridingruppe oder eine Dibenzodihydropyrazingruppe sind.

14. Organometallische Verbindung nach einem der Ansprüche 11 bis 13, wobei R₁ bis R₅ jeweils unabhängig voneinander sind:
Wasserstoff, Deuterium, eine Cyanogruppe oder eine C₁-C₂₀-Alkylgruppe;
eine C₁-C₂₀-Alkylgruppe, die mit Deuterium substituiert ist, -CD₃, -CD₂H, -CDH₂, eine Cyanogruppe, eine C₁-C₁₀-Alkylgruppe, eine Cyclopentylgruppe, eine Cyclohexylgruppe, eine Cycloheptylgruppe, eine Cyclopentenylgruppe, eine Cyclohexenylgruppe, eine Cycloheptenylgruppe, eine Phenylgruppe, eine Biphenylgruppe, eine Naphthylgruppe oder eine beliebige Kombination davon;
eine Cyclopentylgruppe, eine Cyclohexylgruppe, eine Cycloheptylgruppe, eine Cyclopentenylgruppe, eine Cyclohexenylgruppe, eine Cycloheptenylgruppe, eine Phenylgruppe, eine Biphenylgruppe, eine C₁-C₁₀-Alkylphenylgruppe oder eine Naphthylgruppe, jeweils unsubstituiert oder mit Deuterium substituiert, -CD₃,-CD₂H, - CDH₂, eine Cyanogruppe, eine C₁-C₂₀-Alkylgruppe, eine Cyclopentylgruppe, eine Cyclohexylgruppe, eine Cycloheptylgruppe, eine Cyclopentenylgruppe, eine Cyclohexenylgruppe, eine Cycloheptenylgruppe, eine Phenylgruppe, eine Biphenylgruppe, eine C₁-C₁₀-Alkylphenylgruppe, eine Naphthylgruppe, -Si(Q₃₁)(Q₃₂)(Q₃₃) oder eine beliebige Kombination davon; oder
-C(Q₁)(Q₂)(Q₃) oder -Si(Q₁)(Q₂)(Q₃) und
Q₁ bis Q₃ und Q₃₁ bis Q₃₃ jeweils unabhängig voneinander sind: Wasserstoff; Deuterium; eine Cyanogruppe; eine C₁-C₆₀-Alkylgruppe; eine C₂-C₆₀-Alkenylgruppe; eine C₂-C₆₀-Alkinylgruppe; oder eine C₃-C₆₀ carbocyclische Gruppe, die unsubstituiert oder mit Deuterium substituiert ist, eine Cyanogruppe, eine C₁-C₆₀-Alkylgruppe, eine Phenylgruppe, eine Biphenylgruppe oder eine beliebige Kombination davon.

15. Organometallische Verbindung nach einem der Ansprüche 11 bis 14, wobei R₅ eine Gruppe der Formel 1-1 ist: 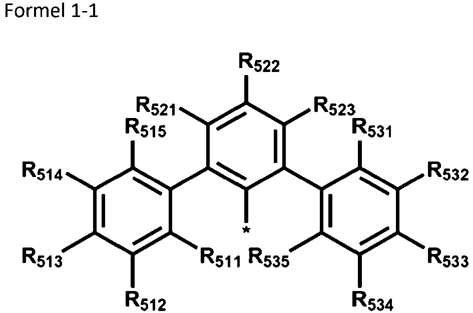 wobei in Formel 1-1
R₅₁₁ bis R₅₁₅, R₅₂₁ bis R₅₂₃und R₅₃₁ bis R₅₃₅ jeweils wie in Verbindung mit R₅ in Formel 1 beschrieben sind, und
* auf eine Bindungsstelle für N in Formel 1 hinweist.

16. Organometallische Verbindung nach einem der Ansprüche 11 bis 15, wobei: in Formel 1 eine durch 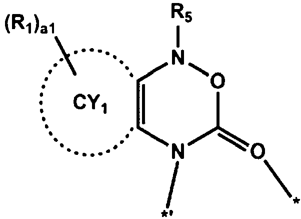 dargestellte Gruppe aus den durch Formeln CY1-1 bis CY1-14 dargestellten Gruppen ausgewählt wird: 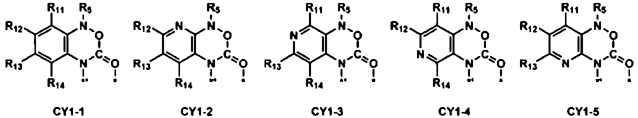 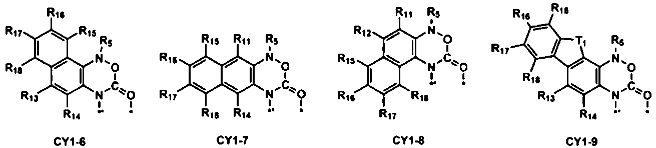 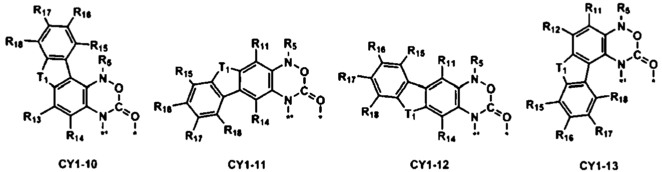 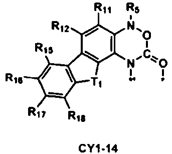 und wobei in den Formeln CY1-1 bis CY1-14,
T₁ C(Y₁₁)(Y₁₂), N(Y₁₁), O, S oder Si(Y₁₁)(Y₁₂) ist,
Y₁₁ und Y₁₂ jeweils unabhängig voneinander Wasserstoff, Deuterium, - F, -Cl, -Br, -I, eine Hydroxylgruppe, eine Cyanogruppe, eine Nitrogruppe, eine C₁-C₆₀-Alkylgruppe, die unsubstituiert oder mit mindestens einem R₁₀ₐsubstituiert ist, eine C₂-C₆₀-Alkenylgruppe, die unsubstituiert oder mit mindestens einem R₁₀ₐsubstituiert ist, eine C₂-C₆₀-Alkinylgruppe, die unsubstituiert oder mit mindestens einem R₁₀ₐsubstituiert ist, eine C₁-C₆₀-Alkoxygruppe, die unsubstituiert oder mit mindestens einem R₁₀ₐsubstituiert ist, eine C₁-C₆₀-Alkylthiogruppe, die unsubstituiert oder mit mindestens einem R₁₀ₐsubstituiert ist, eine C₃-C₆₀ carbocyclische Gruppe, die unsubstituiert oder mit mindestens einem R₁₀ₐsubstituiert ist, eine C₁-C₆₀ heterocyclische Gruppe, die unsubstituiert oder mit mindestens einem R₁₀ₐsubstituiert ist, eine C₆-C₆₀-Aryloxygruppe, die unsubstituiert oder mit mindestens einem R₁₀ₐsubstituiert ist, eine C₆-C₆₀-Arylthiogruppe, die unsubstituiert oder mit mindestens einem R₁₀ₐsubstituiert ist, - C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), oder -P(=O)( Q₁)(Q₂) sind,
R₁₀ₐ und Q₁ bis Q₃ jeweils wie in Formel 1 beschrieben sind,
R₁₁ bis R₁₈ jeweils der Beschreibung in Verbindung mit R₁ in Formel 1 entsprechen,
R₅ der Beschreibung in Formel 1 entspricht,
* auf eine Bindungsstelle für M in Formel 1 hinweist,
*'auf eine Bindungsstelle für L₁ in Formel 1 hinweist.

17. Organometallische Verbindung nach einem der Ansprüche 11 bis 16, wobei in Formel 1 eine durch 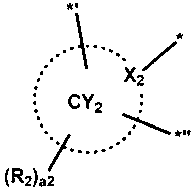 dargestellte Gruppe aus den durch Formeln CY2-1 bis CY2-16 dargestellten Gruppen ausgewählt ist: 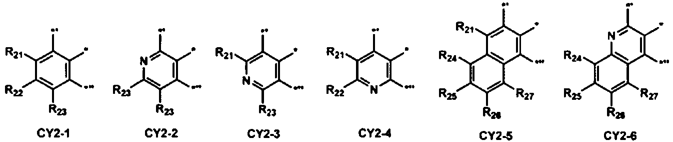 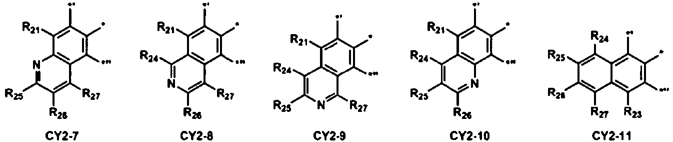 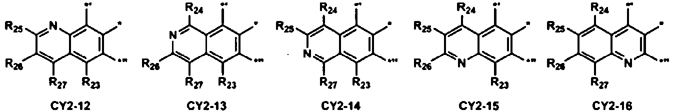 und wobei in den Formeln CY2-1 bis CY2-16,
R₂₁ bis R₂₇ jeweils wie in Verbindung mit R₂ in Formel 1 beschrieben sind,
* auf eine Bindungsstelle für M in Formel 1 hinweist,
*' auf eine Bindungsstelle für L₁ in Formel 1 hinweist und
*" auf eine Bindungsstelle für L₂ in Formel 1 hinweist.

18. Organometallische Verbindung nach einem der Ansprüche 11 bis 17, wobei in Formel 1 eine durch 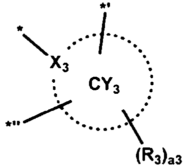 dargestellte Gruppe aus den durch Formeln CY3-1 bis CY3-16 dargestellten Gruppen ausgewählt ist: 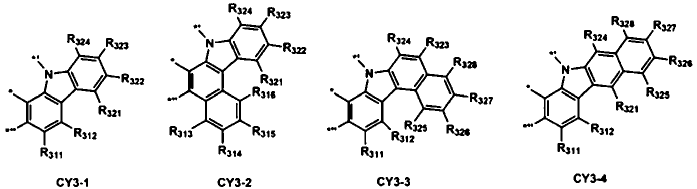 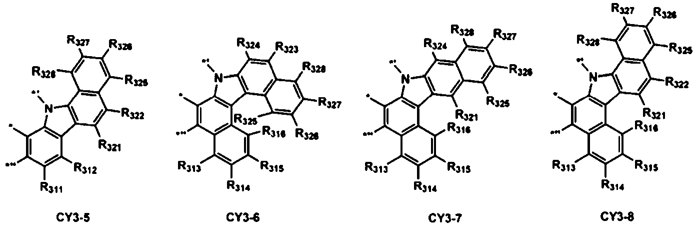 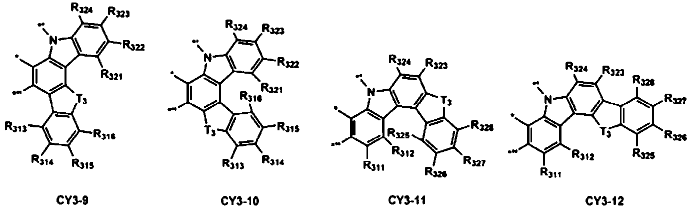 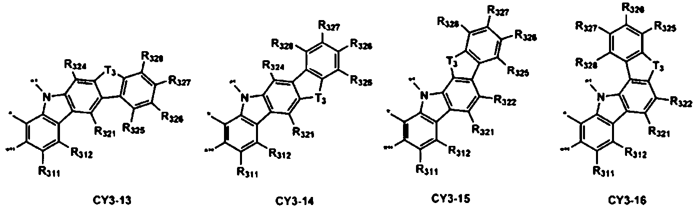 und wobei in den Formeln CY3-1 bis CY3-16,
T₃ C(Y₃₁)(Y₃₂), N(Y₃₁), O, S oder Si(Y₃₁)(Y₃₂) ist,
Y₃₁ und Y₃₂ jeweils unabhängig voneinander Wasserstoff, Deuterium, -F, -Cl, -Br, -I, eine Hydroxylgruppe, eine Cyanogruppe, eine Nitrogruppe, eine C₁-C₆₀-Alkylgruppe, die unsubstituiert oder mit mindestens einem R₁₀ₐ substituiert ist, eine C₂-C₆₀-Alkenylgruppe, die unsubstituiert oder mit mindestens einem R₁₀ₐ substituiert ist, eine C₂-C₆₀-Alkinylgruppe, die unsubstituiert oder mit mindestens einem R₁₀ₐ substituiert ist, eine C₁-C₆₀-Alkoxygruppe, die unsubstituiert oder mit mindestens einem R₁₀ₐ substituiert ist, eine C₁-C₆₀-Alkylthiogruppe, die unsubstituiert oder mit mindestens einem R₁₀ₐ substituiert ist, eine C₃-C₆₀ carbocyclische Gruppe, die unsubstituiert oder mit mindestens einem R₁₀ₐ substituiert ist, eine C₁-C₆₀ heterocyclische Gruppe, die unsubstituiert oder mit mindestens einem R₁₀ₐ substituiert ist, eine C₆-C₆₀-Aryloxygruppe, die unsubstituiert oder mit mindestens einem R₁₀ₐ substituiert ist, eine C₆-C₆₀-Arylthiogruppe, die unsubstituiert oder mit mindestens einem R₁₀ₐ substituiert ist, -C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), oder -P(=O)(Q₁)(Q₂) sind,
R₁₀ₐ und Q₁ bis Q₃ jeweils wie in Formel 1 beschrieben sind,
R₃₁₁ bis R₃₁₆ und R₃₂₁ bis R₃₂₈ jeweils wie in Verbindung mit R₃ in Formel 1 beschrieben sind,
* auf eine Bindungsstelle für M in Formel 1 hinweist,
*' auf eine Bindungsstelle für L₃ in Formel 1 hinweist und
*" auf eine Bindungsstelle für L₂ in Formel 1 hinweist.

19. Organometallische Verbindung nach einem der Ansprüche 11 bis 18, wobei in Formel 1 eine durch 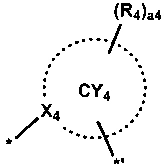 dargestellte Gruppe aus den durch Formeln CY4-1 bis CY4-19 dargestellten Gruppen ausgewählt ist: 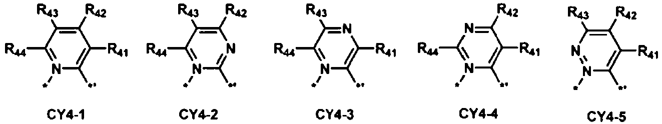 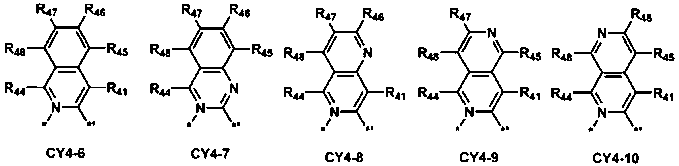 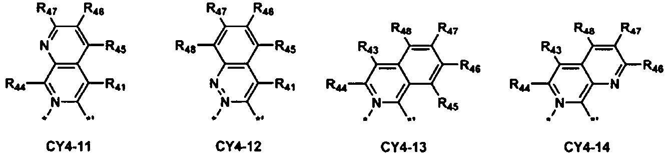 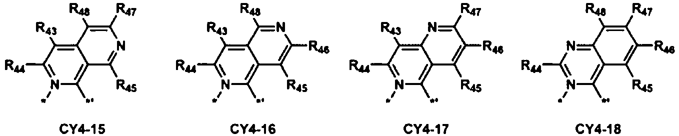 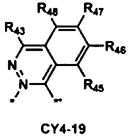 und wobei in Formeln CY4-1 bis CY4-19,
R₄₁ bis R₄₈ jeweils der Beschreibung in Verbindung mit R₄ in Formel 1 entsprechen,
* auf eine Bindungsstelle für M in Formel 1 hinweist,
*' auf eine Bindungsstelle für L₃ in Formel 1 hinweist.

20. Organometallische Verbindung nach Anspruch 11, wobei die durch Formel 1 dargestellte organometallische Verbindung durch Formel 1-2 dargestellt wird: 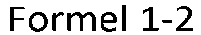 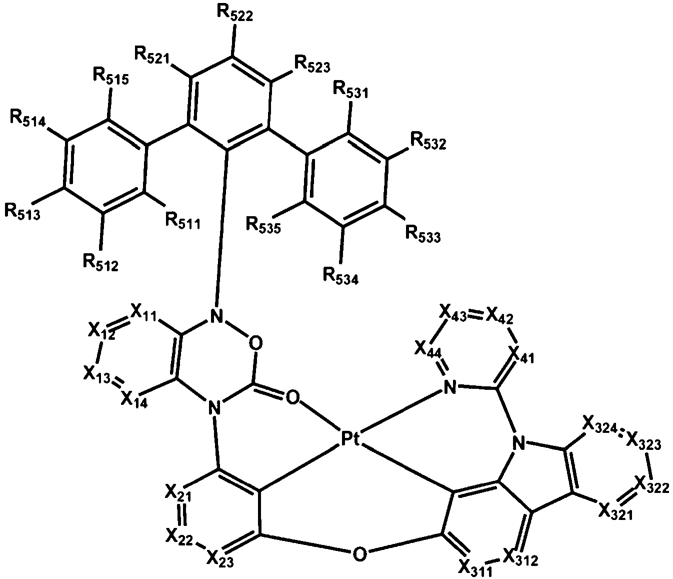 und wobei in Formel 1-2,
X₁₁ C(R₁₁) oder N ist, X₁₂ C(R₁₂) oder N ist, X₁₃ C(R₁₃) oder N ist und X₁₄ C(R₁₄) oder N ist,
X₂₁ C(R₂₁) oder N ist, X₂₂ C(R₂₂) oder N ist und X₂₃ C(R₂₃) oder N ist,
X₃₁₁ C(R₃₁₁) oder N ist, X₃₁₂ C(R₃₁₂) oder N ist, X₃₂₁ C(R₃₂₁) oder N ist, X₃₂₂ C(R₃₂₂) oder N ist, X₃₂₃ C(R₃₂₃) oder N ist und X₃₂₄ C(R₃₂₄) oder N ist,
X41 C(R₄₁) oder N ist, X₄₂ C(R₄₂) oder N ist, X₄₃ C(R₄₃) oder N ist und X₄₄ C(R₄₄) oder N ist,
R₁₁ bis R₁₄ jeweils der Beschreibung in Verbindung mit R₁ in Formel 1 entsprechen,
R₂₁ bis R₂₃ jeweils der Beschreibung in Verbindung mit R₂ in Formel 1 entsprechen,
R₃₁₁, R₃₁₂und R₃₂₁ bis R₃₂₄ jeweils wie in Verbindung mit R₃ in Formel beschrieben sind,
R₄₁ bis R₄₄ jeweils der Beschreibung in Verbindung mit R₄ in Formel 1 entsprechen,
R₅₁₁ bis R₅₁₅, R₅₂₁ bis R₅₂₃und R₅₃₁ bis R₅₃₅ jeweils wie in Verbindung mit Rs in Formel 1 beschrieben sind und
zwei oder mehr benachbarte Gruppen von R₁₁ bis R₁₄, R₂₁ bis R₂₃, R₃₁₁, R₃₁₂, R₃₂₁ bis R₃₂₄, R₄₁ bis R₄₄, R₅₁₁ bis R₅₁₅, R₅₂₁ bis R₅₂₃, und R₅₃₁ bis R₅₃₅ optional miteinander verbunden sein können, um eine C₃-C₆₀ carbocyclische Gruppe, die unsubstituiert oder mit mindestens einem R₁₀ₐ substituiert ist, oder eine C₁-C₆₀ heterocyclische Gruppe, die unsubstituiert oder mit mindestens einem R₁₀ₐsubstituiert ist, zu bilden.

## Revendications

1. Dispositif électroluminescent comprenant :
une première électrode (110) ;
une seconde électrode (150) faisant face à la première électrode ;
une couche intermédiaire (130) agencée entre la première électrode et la seconde électrode et comprenant une couche d'émission ; et
un composé organométallique représenté par la Formule 1 : 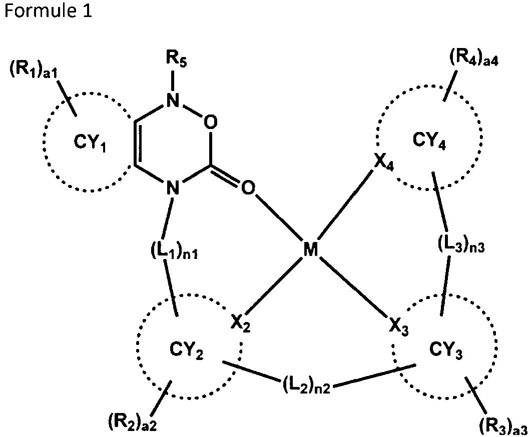 dans lequel, dans la Formule 1,
M est représenté par du platine (Pt), du palladium (Pd), du cuivre (Cu), de l'argent (Ag), de l'or (Au), du rhodium (Rh), du ruthénium (Ru), de l'osmium (Os), du titane (Ti), du zirconium (Zr), du hafnium (Hf), de l'europium (Eu), du terbium (Tb) ou du thulium (Tm),
X₂ à X₄ sont chacun indépendamment C ou N,
les cycles CY₁ à CY₄ sont chacun indépendamment un groupe carbocyclique en C₅-C₃₀ ou un groupe hétérocyclique en C₁-C₃₀,
L₁ à L₃ sont chacun indépendamment une liaison simple, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂- *', ou *-Ge(R₁ₐ)(R_{1b})-*', et * et *' indiquent chacun un site de liaison à un atome voisin,
n1 à n3 sont chacun indépendamment un entier de 1 à 5,
R₁ à R₅, R₁ₐ, et R_{1b} sont chacun indépendamment de l'hydrogène, du deutérium, du -F, du -CI, du -Br, du -I, un groupe hydroxyle, un groupe cyano, un groupe nitro, un groupe alkyle C₁-C₆₀ qui est non-substitué ou substitué par au moins R₁₀ₐ, un groupe alcényle en C₂-C₆₀qui est non-substitué ou substitué par au moins un R₁₀ₐ, un groupe alcynyle en C₂-C₆₀ qui est non-substitué ou substitué par au moins un R₁₀ₐ, un groupe alcoxy en C₁-C₆₀ qui est non-substitué ou substitué par au moins un R₁₀ₐ, un groupe alkylthio en C₁-C₆₀ qui est non-substitué ou substitué par au moins un R₁₀ₐ, un groupe carbocyclique en C₃-C₆₀ qui est non-substitué ou substitué par au moins un R₁₀ₐ, un groupe hétérocyclique en C₁-C₆₀ qui est non-substitué ou substitué par au moins un R₁₀ₐ, un groupe aryloxy en C₆-C₆₀ qui est non-substitué ou substitué par au moins un R₁₀ₐ, un groupe arylthio en C₆-C₆₀ qui est non-substitué ou substitué par au moins un R₁₀ₐ, un -C(Q₁)(Q₂)(Q₃), un - Si(Q₁)(Q₂)(Q₃), un -N(Q₁)(Q₂), un -B(Q₁)(Q₂), un -C(=O)(Q₁), un -S(=O)₂(Q₁), ou un -P(=O)( Q₁)(Q₂),
a1 à a4 sont chacun indépendamment un entier compris entre 1 et 20,
deux ou plusieurs groupes voisins de R₁ à R₅ sont éventuellement liés ensemble pour former un groupe carbocyclique en C₃-C₆₀ non substitué ou substitué par au moins un R₁₀ₐ ou un groupe hétérocyclique en C₁-C₆₀ non substitué ou substitué par au moins un R₁₀ₐ,
R₁₀ₐ est :
un deutérium, -F, -CI, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀ ou un groupe alcoxy en C₁-C₆₀, chacun non substitué ou substitué par un deutérium, -F, -CI, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, un -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), ou une combinaison de ceux-ci ;
un groupe carbocyclique en C₃-C₆₀, un groupe hétérocyclique en C₁-C₆₀, un groupe aryloxy en C₆-C₆₀ ou un groupe arylthio en C₆-C₆₀, chacun non substitué ou substitué par un deutérium, -F, -Cl, - Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, un - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), ou une combinaison de ceux-ci ; ou
un -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou - P(=O)(Q₃₁)(Q₃₂), et
Q₁ à Q₃, Q₁₁ à Q₁₃, Q₂₁ à Q₂₃ et Q₃₁ à Q₃₃ sont chacun indépendamment : un hydrogène ; un deutérium ; -F ; -CI ; -Br ; -I ; un groupe hydroxyle ; un groupe cyano ; un groupe nitro ; un groupe alkyle en C₁-C₆₀ ; un groupe alcényle en C₂-C₆₀ ; un groupe alcynyle en C₂-C₆₀ ; un groupe alcoxy en C₁-C₆₀ ; ou un groupe carbocyclique en C₃-C₆₀ ou un groupe hétérocyclique en C₁-C₆₀, chacun non substitué ou substitué par un deutérium, -F, un groupe cyano, un groupe alkyle en C₁-C₆₀, un groupe alcoxy en C₁-C₆₀, un groupe phényle, un groupe biphényle ou une combinaison de ceux-ci.

2. Dispositif électroluminescent selon la revendication 1, dans lequel la couche démission comprend un matériau hôte et un dopant, et
le dopant comprend le composé organométallique.

3. Dispositif électroluminescent selon la revendication 1 ou 2, comprenant en outre un deuxième composé comprenant au moins un groupe hétérocyclique en C₁-C₆₀ contenant de l'azote et déficient en électrons π, un troisième composé comprenant un groupe représenté par la Formule 3, un quatrième composé capable d'émettre une fluorescence retardée, ou toute combinaison de ceux-ci,
dans lequel le composé organométallique, le deuxième composé, le troisième composé et le quatrième composé sont différents les uns des autres : 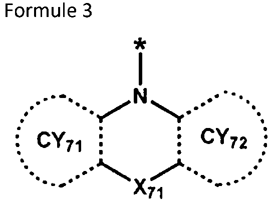 dans lequel, dans la Formule 3,
les cycles CY₇₁ et CY₇₂ sont chacun indépendamment π un groupe cyclique en C₃-C₆₀ riche en électrons ou un groupe pyridine,
X₇₁ est une liaison simple ou un groupe de liaison comprenant O, S, N, B, C, Si ou une combinaison de ceux-ci, et
* indique un site de liaison à tout atome inclus dans une partie restante autre que la Formule 3 dans le troisième composé.

4. Dispositif électroluminescent selon la revendication 3, dans lequel le deuxième composé comprend un groupe pyridine, un groupe pyrimidine, un groupe pyrazine, un groupe pyridazine, un groupe triazine, ou toute combinaison de ceux-ci, et
le quatrième composé comprend au moins un groupe cyclique comprenant du bore (B) et de l'azote (N) comme atomes formant un cycle.

5. Dispositif électroluminescent selon la revendication 3, dans lequel la couche d'émission comprend :
i) le composé organométallique ; et
ii) le deuxième composé, le troisième composé, le quatrième composé, ou toute combinaison de ceux-ci, et
la couche d'émission est configurée pour émettre de la lumière bleue.

6. Appareil électronique comprenant le dispositif électroluminescent selon l'une quelconque des revendications 1 à 5.

7. Appareil électronique selon la revendication 6, comprenant en outre un transistor à couche mince,
dans lequel le transistor à couche mince comprend une électrode source et une électrode drain, et
la première électrode du dispositif électroluminescent est connectée électriquement à l'électrode source du transistor à couche mince ou à l'électrode drain du transistor à couche mince.

8. Appareil électronique selon la revendication 6, comprenant en outre un filtre de couleur, une couche de conversion de couleur, une couche d'écran tactile, une couche polarisante ou toute combinaison de ceux-ci.

9. Équipement électronique comprenant le dispositif électroluminescent selon l'une quelconque des revendications 1 à 5.

10. Équipement électronique selon la revendication 9, dans lequel l'équipement électronique est au moins un élément choisi parmi un écran plat, un écran incurvé, un moniteur d'ordinateur, un moniteur médical, un téléviseur, un panneau d'affichage, un luminaire intérieur ou extérieur et/ou un dispositif lumineux de signalisation, un affichage tête haute, un écran entièrement ou partiellement transparent, un écran flexible, un écran enroulable, un écran pliable, un écran extensible, une imprimante laser, un téléphone, un téléphone portable, une tablette, une phablette, un assistant numérique personnel (PDA), un appareil portable, un ordinateur portable, un appareil photo numérique, un caméscope, un viseur, un micro-écran, un écran tridimensionnel (3D), un écran de réalité virtuelle ou de réalité augmentée, un véhicule, un mur d'images composé de plusieurs écrans assemblés, un écran de théâtre ou de stade, un appareil de photothérapie, un panneau d'affichage et leurs combinaisons.

11. Composé organométallique représenté par la Formule 1 : 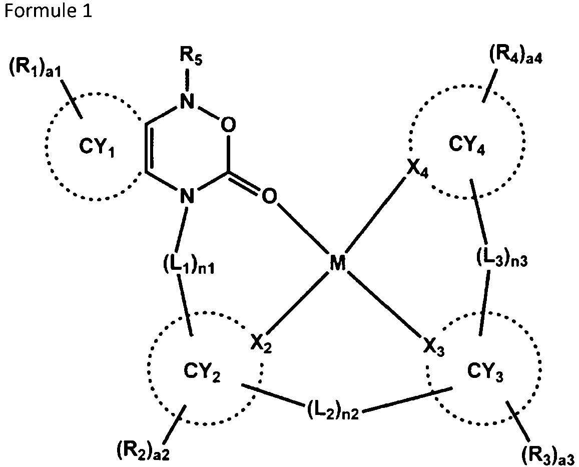 dans lequel dans la formule 1,
M est du platine (Pt), du palladium (Pd), du cuivre (Cu), de l'argent (Ag), de l'or (Au), du rhodium (Rh), du ruthénium (Ru), de l'osmium (Os), du titane (Ti), du zirconium (Zr), du hafnium (Hf), de l'europium (Eu), du terbium (Tb) ou du thulium (Tm),
X₂ à X₄ sont chacun indépendamment C ou N,
les cycles CY₁ à CY₄ sont chacun indépendamment un groupe carbocyclique en C₅-C₃₀ ou un groupe hétérocyclique en C₁-C₃₀,
L₁ à L₃ sont chacun indépendamment une liaison simple, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*, *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂- *', ou *-Ge(R₁ₐ)(R_{1b})-*', et * et *' indiquent chacun un site de liaison à un atome voisin,
n1 à n3 sont chacun indépendamment un entier de 1 à 5,
R₁ à R₅, R₁ₐ, et R_{1b} sont chacun indépendamment de l'hydrogène, du deutérium, du -F, du -CI, du -Br, du -I, un groupe hydroxyle, un groupe cyano, un groupe nitro, un groupe alkyle C₁-C₆₀ qui est non-substitué ou substitué par au moins R₁₀ₐ, un groupe alcényle en C₂-C₆₀qui est non-substitué ou substitué par au moins un R₁₀ₐ, un groupe alcynyle en C₂-C₆₀ qui est non-substitué ou substitué par au moins un R₁₀ₐ, un groupe alcoxy en C₁-C₆₀ qui est non-substitué ou substitué par au moins un R₁₀ₐ, un groupe alkylthio en C₁-C₆₀ qui est non-substitué ou substitué par au moins un R₁₀ₐ, un groupe carbocyclique en C₃-C₆₀ qui est non-substitué ou substitué par au moins un R₁₀ₐ, un groupe hétérocyclique en C₁-C₆₀ qui est non-substitué ou substitué par au moins un R₁₀ₐ, un groupe aryloxy en C₆-C₆₀ qui est non-substitué ou substitué par au moins un R₁₀ₐ, un groupe arylthio en C₆-C₆₀ qui est non-substitué ou substitué par au moins un R₁₀ₐ, un -C(Q₁)(Q₂)(Q₃), un -Si(Q₁)(Q₂)(Q₃), un -N(Q₁)(Q₂), un -B(Q₁)(Q₂), un -C(=O)(Q₁), un -S(=O)₂(Q₁), ou un -P(=O)( Q₁)(Q₂),
a1 à a4 sont chacun indépendamment un entier compris entre 1 et 20,
deux ou plusieurs groupes voisins de R₁ à R₅ sont éventuellement liés ensemble pour former un groupe carbocyclique en C₃-C₆₀ non substitué ou substitué par au moins un R₁₀ₐ ou un groupe hétérocyclique en C₁-C₆₀ non substitué ou substitué par au moins un R₁₀ₐ,
R₁₀ₐ est :
un deutérium, -F, -CI, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀ ou un groupe alcoxy en C₁-C₆₀, chacun non substitué ou substitué par un deutérium, -F, -CI, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, un -Si(Q₁₁)(Q₁₂)(Q₁₃), -N(Q₁₁)(Q₁₂), -B(Q₁₁)(Q₁₂), - C(=O)(Q₁₁), -S(=O)₂(O₁₁), -P(=O)(Q₁₁)(Q₁₂), ou une combinaison de ceux-ci ;
un groupe carbocyclique en C₃-C₆₀, un groupe hétérocyclique en C₁-C₆₀, un groupe aryloxy en C₆-C₆₀ ou un groupe arylthio en C₆-C₆₀, chacun non substitué ou substitué par un deutérium, -F, -Cl, - Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, un - Si(Q₂₁)(Q₂₂)(Q₂₃), -N(Q₂₁)(Q₂₂), -B(Q₂₁)(Q₂₂), -C(=O)(Q₂₁), -S(=O)₂(O₂₁), -P(=O)(Q₂₁)(Q₂₂), ou une combinaison de ceux-ci ; ou
un -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou - P(=O)(Q₃₁)(Q₃₂), et
Q₁ à Q₃, Q₁₁ à Q₁₃, Q₂₁ à Q₂₃ et Q₃₁ à Q₃₃ sont chacun indépendamment : un hydrogène ; un deutérium ; -F ; -Cl ; -Br ; -I ; un groupe hydroxyle ; un groupe cyano ; un groupe nitro ; un groupe alkyle en C₁-C₆₀; un groupe alcényle en C₂-C₆₀; un groupe alcynyle en C₂-C₆₀ ; un groupe alcoxy en C₁-C₆₀; ou un groupe carbocyclique en C₃-C₆₀ ou un groupe hétérocyclique en C₁-C₆₀, chacun non substitué ou substitué par un deutérium, -F, un groupe cyano, un groupe alkyle en C₁-C₆₀, un groupe alcoxy en C₁-C₆₀, un groupe phényle, un groupe biphényle ou une combinaison de ceux-ci.

12. Composé organométallique selon la revendication 11, dans lequel M est du platine (Pt),
X₂ et X₃ sont chacun C, et X₄ est N,
une liaison entre X₂ et M et une liaison entre X₃ et M sont chacune une liaison covalente, et une liaison entre X₄ et M est une liaison de coordination.

13. Composé organométallique selon la revendication 11 ou la revendication 12, dans lequel les cycles CY₁ à CY₄ sont chacun indépendamment un groupe benzène, un groupe naphtalène, un groupe anthracène, un groupe phénanthrène, un groupe triphénylène, un groupe pyrène, un groupe chrysène, un groupe cyclopentadiène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe dibenzooxasiline, un groupe dibenzothiasiline, un groupe dibenzodihydroazasiline, un groupe dibenzodihydrodihydrodisiline, un groupe dibenzodihydrosiline, un groupe dibenzodioxine, un groupe dibenzooxathiine, un groupe dibenzooxazine, un groupe dibenzopyrane, un groupe dibenzodithiine, un groupe dibenzothiazine, un groupe dibenzothiopyrane, un groupe dibenzocyclohexadiène, un groupe dibenzodihydropyridine ou un groupe dibenzodihydropyrazine.

14. Composé organométallique selon l'une quelconque des revendications 11 à 13, dans lequel R₁ à R₅ sont chacun indépendamment :
un hydrogène, un deutérium, un groupe cyano ou un groupe alkyle en C₁-C₂₀ ;
un groupe alkyle en C₁-C₂₀ substitué par du deutérium, -CD₃, -CD₂H, -CDH₂, un groupe cyano, un groupe alkyle en C₁-C₁₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe naphtyle, ou toute combinaison de ceux-ci ;
un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe alkylphényle en C₁-C₁₀ ou un groupe naphtyle, chacun non substitué ou substitué par du deutérium, -CD₃, -CD₋₂H, -CDH₂, un groupe cyano, un groupe alkyle en C₁-C₂₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe alkylphényle en C₁-C₁₀, un groupe naphtyle, -Si(Q₃₁)(Q₃₂)(Q₃₃), ou toute combinaison de ceux-ci ; ou
-C(O₁)(Q₂)(Q₃) ou -Si(Q₁)(Q₂)(Q₃), et
Q₁ à Q₃ et Q₃₁ à Q₃₃ sont chacun indépendamment : un hydrogène ; un deutérium ; un groupe cyano ; un groupe alkyle en C₁-C₆₀; un groupe alcényle en C₂-C₆₀ ; un groupe alcynyle en C₂-C₆₀ ; ou un groupe carbocyclique en C₃-C₆₀ non substitué ou substitué avec du deutérium, un groupe cyano, un groupe alkyle en C₁-C₆₀, un groupe phényle, un groupe biphényle ou toute combinaison de ceux-ci.

15. Composé organométallique selon l'une quelconque des revendications 11 à 14, dans lequel R₅ est un groupe représenté par la formule 1-1 : 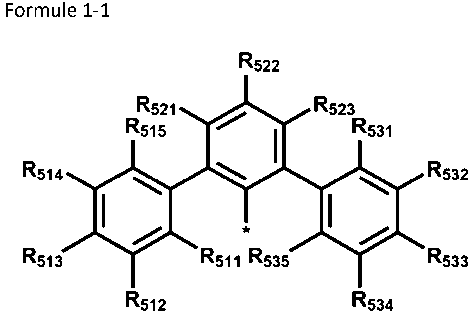 dans lequel, dans la Formule 1-1,
R₅₁₁ à R₅₁₅, R₅₂₁ à R₅₂₃ et R₅₃₁ à R₅₃₅ sont chacun tels que décrits en relation avec R₅ dans la Formule 1, et
* indique un site de liaison à N dans la Formule 1.

16. Composé organométallique selon l'une quelconque des revendications 11 à 15, dans lequel : dans la Formule 1, un groupe représenté par 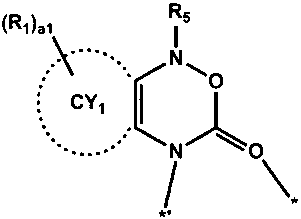 est sélectionné parmi les groupes représentés par les Formules CY1-1 à CY1-14 : 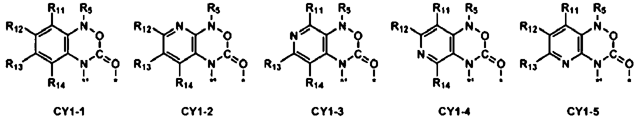 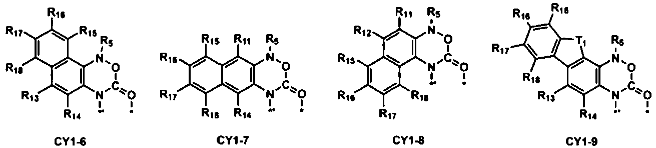 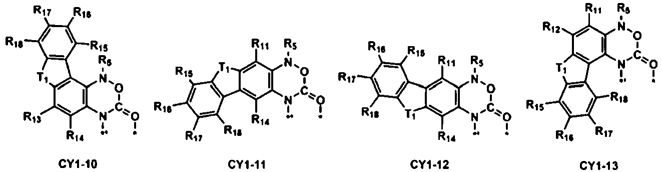 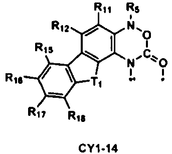 et, dans lequel, dans les formules CY1-1 à CY1-14,
T₁ est C(Y₁₁)(Y₁₂), N(Y₁₁), O, S ou Si(Y₁₁)(Y₁₂),
Y₁₁ et Y₁₂ représentent chacun indépendamment un hydrogène, un deutérium, un groupe -F, -Cl, -Br, -I, un groupe hydroxyle, un groupe cyano, un groupe nitro, un groupe alkyle enC₁-C₆₀ non substitué ou substitué par au moins un R₁₀ₐ, un groupe alcényle en C₂-C₆₀ non substitué ou substitué par au moins un R₁₀ₐ, un groupe alcynyle en C₂-C₆₀ non substitué ou substitué par au moins un R₁₀ₐ, un groupe alcoxy en C₁-C₆₀ non substitué ou substitué par au moins un R₁₀ₐ, un groupe alkylthio en C₁-C₆₀ non substitué ou substitué par au moins un R₁₀ₐ, un groupe carbocyclique en C₃-C₆₀ non substitué ou substitué par au moins un R₁₀ₐ, un groupe hétérocyclique en C₁-C₆₀ non substitué ou substitué par au moins un R₁₀ₐ, un groupe aryloxy en C₆-C₆₀ non substitué ou substitué par au moins un R₁₀ₐ, un groupe arylthio en C₆-C₆₀ non substitué ou substitué par au moins un R₁₀ₐ, -C(Q₁)(Q₂)(Q₃), -Si(Q₁)(Q₂)(Q₃), -N(Q₁)(Q₂), -B(Q₁)(Q₂). -C(=O)(Q₁), - S(=O)₂(Q₁), ou -P(=O)(Q₁)(Q₂),
R₁₀ₐ et Q₁ à Q₃ sont chacun tels que décrits dans la Formule 1,
R₁₁ à R₁₈ sont chacun tels que décrits en relation avec R₁ dans la Formule 1,
R₅ est tel que décrit dans la Formule 1,
* indique un site de liaison à M dans la Formule 1, et
*' indique un site de liaison à L₁ dans la Formule 1.

17. Composé organométallique selon l'une quelconque des revendications 11 à 16, dans lequel, dans la Formule 1, un groupe représenté par 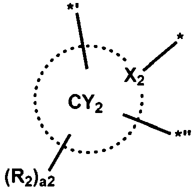 est choisi parmi les groupes représentés par les formules CY2-1 à CY2-16 : 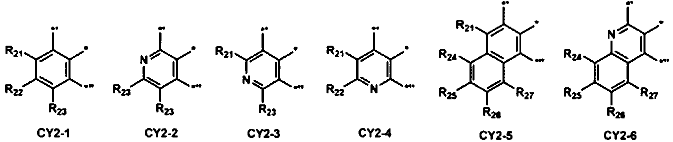 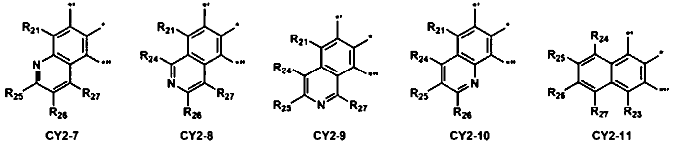 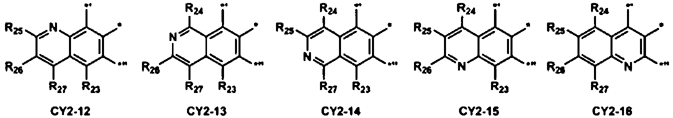 et, dans lequel, dans les formules CY2-1 à CY2-16,
R₂₁ à R₂₇ sont chacun tels que décrits en relation avec R₂ dans la Formule 1,
* indique un site de liaison à M dans la Formule 1,
*' indique un site de liaison à L₁ dans la Formule 1, et
*" indique un site de liaison à L₂ dans la Formule 1.

18. Composé organométallique selon l'une quelconque des revendications 11 à 17, dans lequel, dans la Formule 1, un groupe représenté par 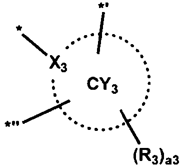 est choisi parmi les groupes représentés par les formules CY3-1 à CY3-16 : 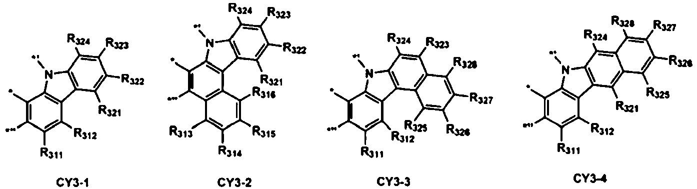 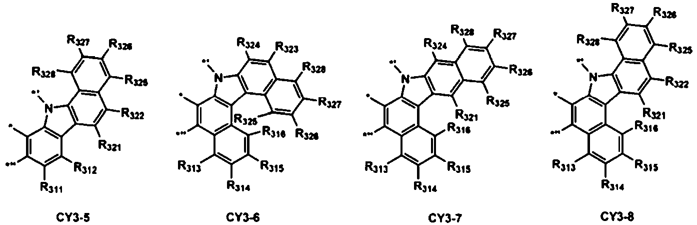 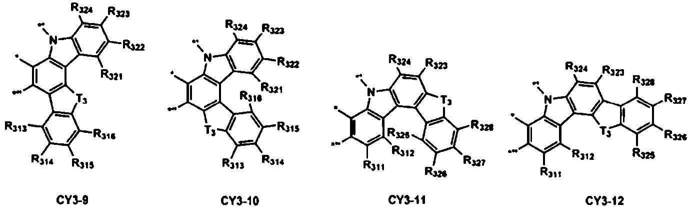 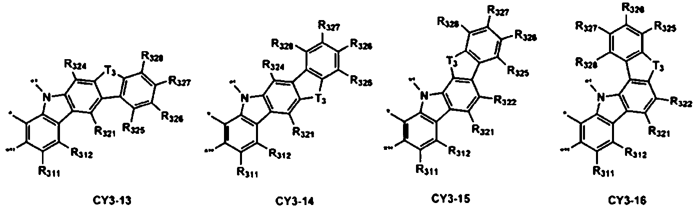 et, dans lequel, dans les Formules CY3-1 à CY3-16,
T₃ est C(Y₃₁)(Y₃₂), N(Y₃₁), O, S ou Si(Y₃₁)(Y₃₂),
Y₃₁ et Y₃₂ représentent chacun indépendamment un atome d'hydrogène, un deutérium, -F, -Cl, -Br, -I, un groupe hydroxyle, un groupe cyano, un groupe nitro, un groupe alkyle en C₁-C₆₀ non substitué ou substitué par au moins un R₁₀ₐ, un groupe alcényle en C₂-C₆₀ non substitué ou substitué par au moins un R₁₀ₐ, un groupe alcynyle en C₂-C₆₀ non substitué ou substitué par au moins un R₁₀ₐ, un groupe alcoxy en C₁-C₆₀ non substitué ou substitué par au moins un R₁₀ₐ, un groupe alkylthio en C₁-C₆₀ non substitué ou substitué par au moins un R₁₀ₐ, un groupe carbocyclique en C₃-C₆₀ non substitué ou substitué par au moins un R₁₀ₐ. un groupe hétérocyclique en C₁-C₆₀ non substitué ou substitué par au moins un R₁₀ₐ, un groupe aryloxy en C₆-C₆₀ non substitué ou substitué par au moins un R₁₀ₐ, un groupe arylthio en C₆-C₆₀ non substitué ou substitué par au moins un R₁₀ₐ, -C(Q₁)(Q₂)(Q₃), -Si(Q₁)(Q₂)(Q₃), -N(Q₁)(Q₂), -B(O₁)(Q₂). -C(=O)(Q₁), -S(=O)₂(Q₁), ou - P(=O)(Q₁)(Q₂),
R₁₀ₐ et Q₁ à Q₃ sont chacun tels que décrits dans la Formule 1,
R311 à R₃₁₆ et R₃₂₁ à R₃₂₈ sont chacun tels que décrits en relation avec R₃ dans la Formule 1,
* indique un site de liaison à M dans la formule 1,
*' indique un site de liaison à L₃ dans la Formule 1, et
*" indique un site de liaison à L₂ dans la Formule 1.

19. Composé organométallique selon l'une quelconque des revendications 11 à 18, dans lequel, dans la Formule 1, un groupe représenté par 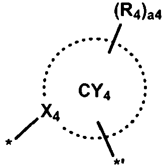 est choisi parmi les groupes représentés par les Formules CY4-1 à CY4-19 : 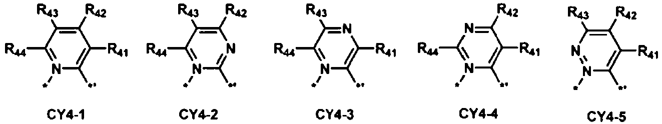 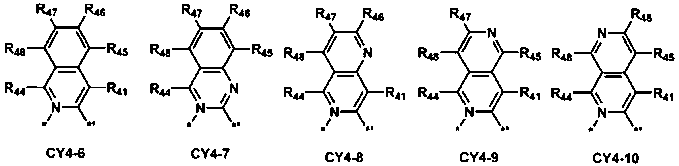 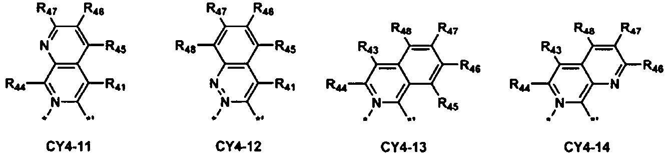 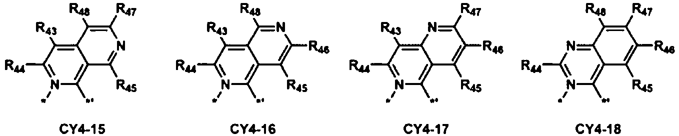 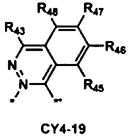 et, dans lequel, dans les Formules CY4-1 à CY4-19,
R₄₁ à R₄₈ sont chacun tels que décrits en relation avec R₄ dans la Formule 1,
* indique un site de liaison à M dans la Formule 1, et
*' indique un site de liaison à L₃ dans la Formule 1.

20. Composé organométallique selon la revendication 11, dans lequel le composé organométallique représenté par la Formule 1 est représenté par la Formule 1-2 : 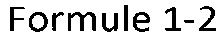 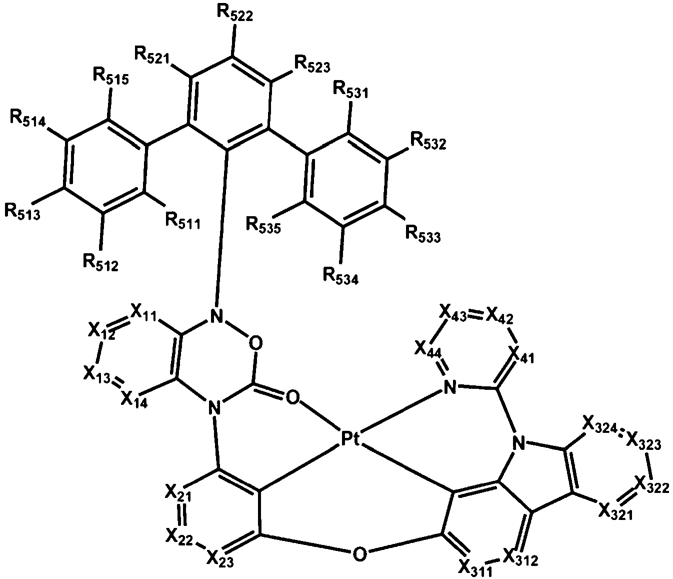 et, dans lequel, dans la Formule 1-2,
X₁₁ est C(R₁₁) ou N, X₁₂ est C(R₁₂) ou N, X₁₃ est C(R₁₃) ou N, et X₁₄ est C(R₁₄) ou N,
X₂₁ est C(R₂₁) ou N, X₂₂ est C(R₂₂) ou N, et X₂₃ est C(R₂₃) ou N,
X₃₁₁ est C(R₃₁₁) ou N, X₃₁₂ est C(R₃₁₂) ou N, X₃₂₁ est C(R₃₂₁) ou N, X₃₂₂ est C(R₃₂₂) ou N, X₃₂₃ est C(R₃₂₃) ou N, et X₃₂₄ est C(R₃₂₄) ou N,
X₄₁ est C(R₄₁) ou N, X₄₂ est C(R₄₂) ou N, X₄₃ est C(R₄₃) ou N, et X₄₄ est C(R₄₄) ou N,
R₁₁ à R₁₄ sont chacun tels que décrits en relation avec R₁ dans la Formule 1,
R₂₁ à R₂₃ sont chacun tels que décrits en relation avec R₂ dans la Formule 1,
R₃₁₁, R₃₁₂ et R₃₂₁ à R₃₂₄ sont chacun tels que décrits en relation avec R₃ dans la Formule,
R₄₁ à R₄₄ sont chacun tels que décrits en relation avec R₄ dans la Formule 1,
R₅₁₁ à R₅₁₅, R₅₂₁ à R₅₂₃ et R₅₃₁ à R₅₃₅ sont chacun décrits en relation avec Rs dans la Formule 1, et
deux ou plusieurs groupes voisins de R₁₁ à R₁₄, R₂₁ à R₂₃, R₃₁₁, R₃₁₂, R₃₂₁ à R₃₂₄, R₄₁ à R₄₄, R₅₁₁ à R₅₁₅, R₅₂₁ à R₅₂₃ et R₅₃₁ à R₅₃₅ sont éventuellement liés ensemble pour former un groupe carbocyclique C₃-C₆₀ non substitué ou substitué par au moins un R₁₀ₐ ou un groupe hétérocyclique C₁-C₆₀ non substitué ou substitué par au moins un R₁₀ₐ.
